# EUROPEAN PATENT APPLICATION

(11) **EP 4 475 654 A1**
(43) Date of publication of application: **11.12.2024**
(21) Application number: 23749951.2
(22) Date of filing: 01.02.2023
(51) Int. Cl.: H10K 85/60, H10K 50/11, H10K 50/12, C09K 11/06

(54) **ORGANIC LIGHT-EMITTING ELEMENT INCLUDING HETEROCYCLIC COMPOUND, COMPOSITION FOR ORGANIC MATERIAL LAYER OF ORGANIC LIGHT-EMITTING ELEMENT, AND METHOD FOR MANUFACTURING ORGANIC LIGHT-EMITTING ELEMENT**

(30) Priority: 04.02.2022 KR 20220014728; 29.08.2022 KR 20220108543
(71) Applicant: LT Materials Co., Ltd., Yongin-si, Gyeonggi-do 17118 (KR)
(72) Inventor: HEO, Yu-Jin, Yongin-si, Gyeonggi-do 17118 (KR); MO, Jun-Tae, Yongin-si, Gyeonggi-do 17118 (KR); KIM, Dong-Jun, Yongin-si, Gyeonggi-do 17118 (KR)
(74) Representative: Goddar, Heinz J.
(86) International application number: PCT/KR2023/001477
(87) International publication number: WO 2023/149718

(57) **Abstract**

The present application provides an organic light emitting device which includes a heterocyclic compound capable of significantly improving the service life, efficiency, electrochemical stability, and thermal stability of the organic light emitting device in an organic material layer, a composition for an organic material layer of the organic light emitting device, and a method for manufacturing the organic light emitting device. [Representative Drawing]

## Description

### [Technical Field]

This application claims priority to and the benefit of Korean Patent Application Nos. 10-2022-0014728 and 10-2022-0108543 filed in the Korean Intellectual Property Office on February 4, 2022 and August 29, 2022, respectively, the entire contents of which are incorporated herein by reference.

The present application relates to an organic light emitting device including a heterocyclic compound, a composition for an organic material layer of the organic light emitting device, and a method for manufacturing the organic light emitting device.

### [Background Art]

An electroluminescence device is a kind of self-emitting type display device, and has an advantage in that the viewing angle is wide, the contrast is excellent, and the response speed is fast.

An organic light emitting device has a structure in which an organic thin film is disposed between two electrodes. When a voltage is applied to an organic light emitting device having the structure, electrons and holes injected from the two electrodes combine with each other in an organic thin film to make a pair, and then, emit light while being extinguished. The organic thin film may be composed of a single layer or multiple layers, if necessary.

A material for the organic thin film may have a light emitting function, if necessary. For example, as the material for the organic thin film, it is also possible to use a compound, which may itself constitute a light emitting layer alone, or it is also possible to use a compound, which may serve as a host or a dopant of a host-dopant-based light emitting layer. In addition, as a material for the organic thin film, it is also possible to use a compound, which may perform a function such as hole injection, hole transport, electron blocking, hole blocking, electron transport or electron injection.

In order to improve the performance, service life, or efficiency of the organic light emitting device, there is a continuous need for developing a material for an organic thin film.

### [Related Art Document]

### [Patent Document]

US Patent No. 4,356,429

### [Disclosure]

### [Technical Problem]

The present invention has been made in an effort to provide an organic light emitting device including a heterocyclic compound, a composition for an organic material layer of the organic light emitting device, and a method for manufacturing the organic light emitting device.

### [Technical Solution]

An exemplary embodiment of the present application provides an organic light emitting device including a first electrode, a second electrode and an organic material layer having one or more layers provided between the first electrode and the second electrode, in which one or more layers of the organic material layer include a heterocyclic compound represented by the following Chemical Formula 1 and a heterocyclic compound represented by the following Chemical Formula 2.

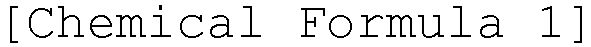

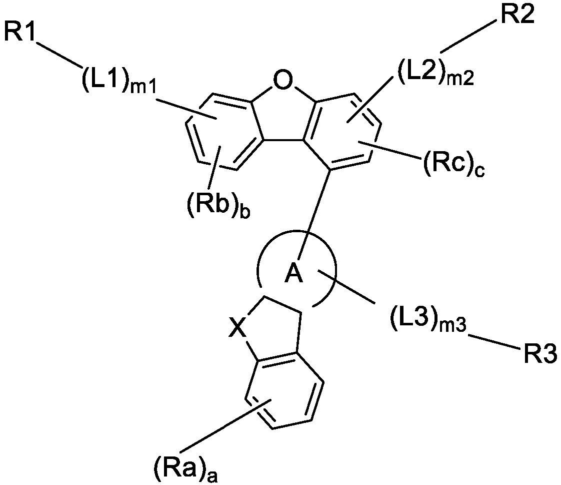

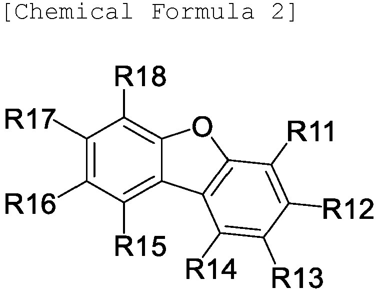

In Chemical Formula 1,
X is O; or S,
A is a pyrimidine ring group,
L1 to L3 are the same as or different from each other, and are each independently a direct bond; a substituted or unsubstituted C6 to C60 arylene group; or a substituted or unsubstituted C2 to C60 heteroarylene group, m1 to m3 are each independently an integer from 0 to 3, and when m1 to m3 are each 2 or higher, substituents in the parenthesis are the same as or different from each other,
R1 and R2 are the same as or different from each other, and are each independently hydrogen; deuterium; or a substituted or unsubstituted C6 to C60 aryl group,
R3 is a C6 to C60 aryl group; or a substituted or unsubstituted C2 to C60 heteroaryl group,
Ra to Rc are the same as or different from each other, and are each independently hydrogen; deuterium; a halogen group; a cyano group; or a substituted or unsubstituted alkyl group having 1 to 60 carbon atoms, a is an integer from 0 to 3, and when a is an integer of 2 or higher, Ra's in the parenthesis are the same as or different from each other, b is an integer from 0 to 2, and when b is 2, Rb's in the parenthesis are the same as or different from each other, and c is an integer from 0 to 4, and when c is an integer of 2 or higher, Rc's in the parenthesis are the same as or different from each other,
in Chemical Formula 2,
one of R11 to R18 is a group represented by the following Chemical Formula A, one of the others is a group represented by the following Chemical Formula B, and the rest are the same as or different from each other, and are each independently hydrogen; or deuterium, or bonded to an adjacent group to form a benzene ring, 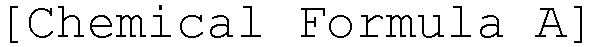 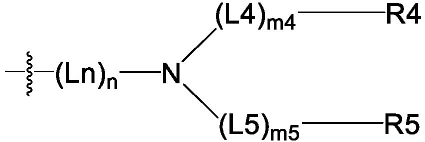 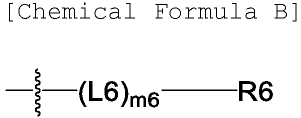
in Chemical Formulae A and B,
L4 to L6 and Ln are the same as or different from each other, and are each independently a direct bond; a substituted or unsubstituted C6 to C60 arylene group; or a substituted or unsubstituted C2 to C60 heteroarylene group, m4 to m6 and n are each independently an integer from 0 to 3, and when m4 to m6 and n are each 2 or higher, substituents in the parenthesis are the same as or different from each other,
R4 and R5 are the same as or different from each other, and are each independently a substituted or unsubstituted C6 to C60 aryl group; or a substituted or unsubstituted C2 to C60 heteroaryl group, or R4 and R5 are bonded to each other to form a ring,
R6 is a substituted or unsubstituted C6 to C60 aryl group; or a monocyclic or polycyclic heterocyclic group which is substituted or unsubstituted and includes one or more N's, and 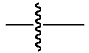
means a position bonded to Chemical Formula 2.

An exemplary embodiment of the present application provides a composition for an organic material layer of an organic light emitting device, which includes the heterocyclic compound represented by Chemical Formula 1 and the compound represented by Chemical Formula 2.

Further, an exemplary embodiment of the present application provides a method for manufacturing an organic light emitting device, the method including: preparing a substrate; forming a first electrode on the substrate; forming an organic material layer having one or more layers on the first electrode; and forming a second electrode on the organic material layer, in which the forming of the organic material layer includes forming the organic material layer having one or more layers by using the composition for an organic material layer according to an exemplary embodiment of the present application.

### [Advantageous Effects]

A heterocyclic compound according to an exemplary embodiment of the present application can be used as a material for an organic material layer of an organic light emitting device. The heterocyclic compound can be used as a material for a hole injection layer, a hole transport layer, a light emitting layer, an electron transport layer, an electron injection layer, a charge generation layer, and the like in an organic light emitting device. In particular, the heterocyclic compound represented by Chemical Formula 1 and the heterocyclic compound represented by Chemical Formula 2 can be used as a material for a light emitting layer of an organic light emitting device. In addition, when the heterocyclic compound represented by Chemical Formula 1 and the heterocyclic compound represented by Chemical Formula 2 are used for an organic light emitting device, the driving voltage of the device can be lowered, the light efficiency of the device can be improved, and the service life characteristics of the device can be improved by the thermal stability of the compound.

### [Description of Drawings]

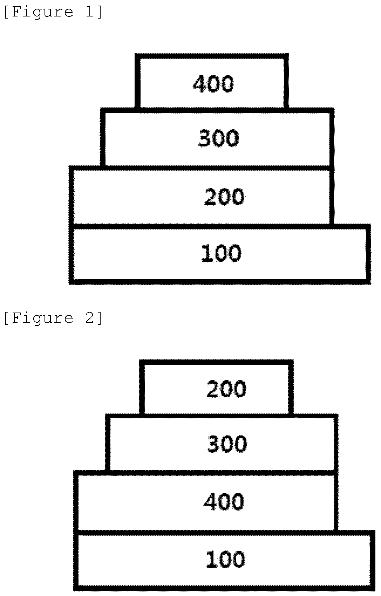

FIGS. 1 to 4 each are views schematically illustrating a stacking structure of an organic light emitting device according to an exemplary embodiment of the present application.

### [Mode for Invention]

Hereinafter, the present application will be described in detail.

An exemplary embodiment of the present application provides an organic light emitting device including a first electrode, a second electrode and an organic material layer having one or more layers provided between the first electrode and the second electrode, in which one or more layers of the organic material layer include a heterocyclic compound represented by the following Chemical Formula 1 and a heterocyclic compound represented by the following Chemical Formula 2. 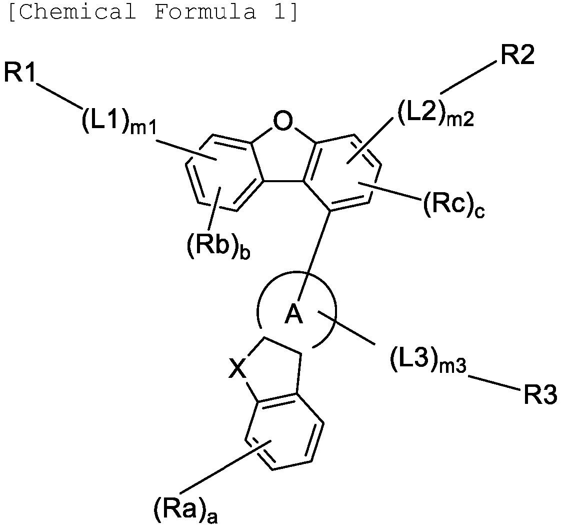 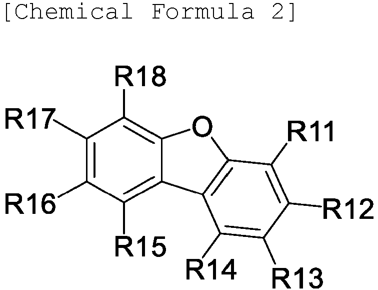 in Chemical Formula 1,
X is O; or S,
A is a pyrimidine ring group,
L1 to L3 are the same as or different from each other, and are each independently a direct bond; a substituted or unsubstituted C6 to C60 arylene group; or a substituted or unsubstituted C2 to C60 heteroarylene group, m1 to m3 are each independently an integer from 0 to 3, and when m1 to m3 are each 2 or higher, substituents in the parenthesis are the same as or different from each other,
R1 and R2 are the same as or different from each other, and are each independently hydrogen; deuterium; or a substituted or unsubstituted C6 to C60 aryl group,
R3 is a C6 to C60 aryl group; or a substituted or unsubstituted C2 to C60 heteroaryl group,
Ra to Rc are the same as or different from each other, and are each independently hydrogen; deuterium; a halogen group; a cyano group; or a substituted or unsubstituted alkyl group having 1 to 60 carbon atoms, a is an integer from 0 to 3, and when a is an integer of 2 or higher, Ra's in the parenthesis are the same as or different from each other, b is an integer from 0 to 2, and when b is 2, Rb's in the parenthesis are the same as or different from each other, and c is an integer from 0 to 4, and when c is an integer of 2 or higher, Rc's in the parenthesis are the same as or different from each other,
in Chemical Formula 2,
one of R11 to R18 is a group represented by the following Chemical Formula A, one of the others is a group represented by the following Chemical Formula B, and the rest are the same as or different from each other, and are each independently hydrogen; or deuterium, or bonded to an adjacent group to form a benzene ring, 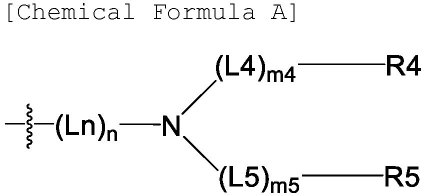 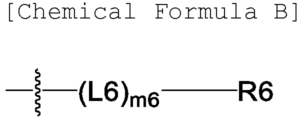
in Chemical Formulae A and B,
L4 to L6 and Ln are the same as or different from each other, and are each independently a direct bond; a substituted or unsubstituted C6 to C60 arylene group; or a substituted or unsubstituted C2 to C60 heteroarylene group, m4 to m6 and n are each independently an integer from 0 to 3, and when m4 to m6 and n are each 2 or higher, substituents in the parenthesis are the same as or different from each other,
R4 and R5 are the same as or different from each other, and are each independently a substituted or unsubstituted C6 to C60 aryl group; or a substituted or unsubstituted C2 to C60 heteroaryl group, or R4 and R5 are bonded to each other to form a ring,
R6 is a substituted or unsubstituted C6 to C60 aryl group; or a monocyclic or polycyclic heterocyclic group which is substituted or unsubstituted and includes one or more N's, and 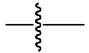
means a position bonded to Chemical Formula 2.

The heterocyclic compound represented by Chemical Formula 1 of the present invention has high thermal stability and appropriate molecular weight and band-gap. The heterocyclic compound represented by Chemical Formula 1 of the present invention prevents the loss of electrons and holes to enable the effective formation of a recombination zone.

Further, the heterocyclic compound represented by Chemical Formula 2 has excellent service life characteristics due to high thermal stability. Since the heterocyclic compound represented by Chemical Formula 1 prevents the loss of electrons and holes to enable the effective formation of a recombination zone, when the heterocyclic compound represented by Chemical Formula 1 is used together with the compound represented by Chemical Formula 2, the driving voltage at which electrons and holes are injected may be lowered when a donor with a good hole transport ability (p-host) and an acceptor with a good electron transport ability (n-host) are used as hosts of a light emitting layer.

That is, when both the compound represented by Chemical Formula 1 and the compound represented by Chemical Formula 2 are included in an organic material layer of an organic light emitting device, an exciplex phenomenon may occur.

The exciplex phenomenon is a phenomenon in which energy with a magnitude of the HOMO level of the donor (p-host) and the LUMO level of the acceptor (n-host) is released as an electron exchange between two molecules. When the exciplex phenomenon between two molecules occurs, a reverse intersystem crossing (RISC) occurs, and the internal quantum efficiency of fluorescence can be increased to 100% due to the RISC.

That is, when the compound represented by Chemical Formula 1, which is an acceptor with a good electron transport ability (n-host) and the compound represented by Chemical Formula 2, which is a donor with a good hole transport ability (p-host) , are used for an organic material layer, the service life and efficiency of the device can be improved.

In particular, when the compound represented by Chemical Formula 1 and the compound represented by Chemical Formula 2 are used as hosts for the light emitting layer, holes are injected into the p-host and electrons are injected into the n-host, so that the driving voltage can be lowered, which can help to improve the service life. When one part "includes" one constituent element in the present specification, unless otherwise specifically described, this does not mean that another constituent element is excluded, but means that another constituent element may be further included.

In the present specification, 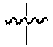 of a chemical formula means a position to which a constituent element is bonded.

The term "substitution" means that a hydrogen atom bonded to a carbon atom of a compound is changed into another substituent, and a position to be substituted is not limited as long as the position is a position at which the hydrogen atom is substituted, that is, a position at which the substituent may be substituted, and when two or more are substituted, the two or more substituents may be the same as or different from each other.

In the present specification, "substituted or unsubstituted" means being unsubstituted or substituted with one or more substituents selected from the group consisting of deuterium; a halogen group; -CN; a C1 to C60 alkyl group; a C2 to C60 alkenyl group; a C2 to C60 alkynyl group; a C1 to C60 haloalkyl group; a C1 to C60 alkoxy group; a C6 to C60 aryloxy group; a C1 to C60 alkylthioxy group; a C6 to C60 arylthioxy group; a C1 to C60 alkylsulfoxy group; a C6 to C60 arylsulfoxy group; a C3 to C60 cycloalkyl group; a C2 to C60 heterocycloalkyl group; a C6 to C60 aryl group; a C2 to C60 heteroaryl group; - SiRR'R"; -P(=O)RR'; and -NRR', or a substituent to which two or more substituents selected among the exemplified substituents are linked, and R, R' and R" are each independently a substituent composed of at least one of hydrogen; deuterium; a halogen group; an alkyl group; an alkenyl group; an alkoxy group; a cycloalkyl group; a heterocycloalkyl group; an aryl group; and a heteroaryl group.

In the present specification, "Cn" means that the number of carbon atoms is n. For example, C6 means 6 carbon atoms and C60 means 60 carbon atoms.

In the present specification, "when a substituent is not indicated in the structure of a chemical formula or compound" means that a hydrogen atom is bonded to a carbon atom. However, since deuterium (²H) is an isotope of hydrogen, some hydrogen atoms may be deuterium.

In an exemplary embodiment of the present application, "when a substituent is not indicated in the structure of a chemical formula or compound" may mean that all the positions that may be reached by the substituent are hydrogen or deuterium. That is, deuterium is an isotope of hydrogen, and some hydrogen atoms may be deuterium which is an isotope, and in this case, the content of deuterium may be 0% to 100%.

In an exemplary embodiment of the present application, in "the case where a substituent is not indicated in the structure of a chemical formula or compound", when the content of deuterium is 0%, the content of hydrogen is 100%, and all the substituents do not explicitly exclude deuterium such as hydrogen, hydrogen and deuterium may be mixed and used in the compound.

In an exemplary embodiment of the present application, deuterium is one of the isotopes of hydrogen, is an element that has a deuteron composed of one proton and one neutron as a nucleus, and may be represented by hydrogen-2, and the element symbol may also be expressed as D or ²H.

In an exemplary embodiment of the present application, the isotope means an atom with the same atomic number (Z), but different mass numbers (A), and the isotope may also be interpreted as an element which has the same number of protons, but different number of neutrons.

In an exemplary embodiment of the present application, when the total number of substituents of a basic compound is defined as T1 and the number of specific substituents among the substituents is defined as T2, the content T% of the specific substituent may be defined as T2/T1×100 = T%.

That is, in an example, the deuterium content of 20% in a phenyl group represented by 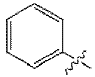 may be represented by 20% when the total number of substituents that the phenyl group can have is 5 (T1 in the formula) and the number of deuteriums among the substituents is 1 (T2 in the formula). That is, a deuterium content of 20% in the phenyl group may be represented by the following structural formula.

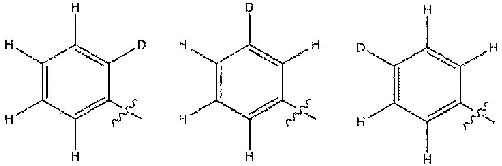

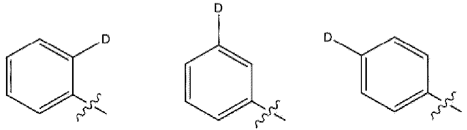

Further, in an exemplary embodiment of the present application, "a phenyl group having a deuterium content of 0%" may mean a phenyl group that does not include a deuterium atom, that is, has five hydrogen atoms.

In the present specification, the halogen may be fluorine, chlorine, bromine or iodine.

In the present specification, an alkyl group includes a straight-chain or branched-chain having 1 to 60 carbon atoms, and may be additionally substituted with another substituent. The number of carbon atoms of the alkyl group may be 1 to 60, specifically 1 to 40, and more specifically 1 to 20. Specific examples thereof include a methyl group, an ethyl group, a propyl group, an n-propyl group, an isopropyl group, a butyl group, an n-butyl group, an isobutyl group, a tert-butyl group, a sec-butyl group, a 1-methyl-butyl group, a 1-ethyl-butyl group, a pentyl group, an n-pentyl group, an isopentyl group, a neopentyl group, a tert-pentyl group, a hexyl group, an n-hexyl group, a 1-methylpentyl group, a 2-methylpentyl group, a 4-methyl-2-pentyl group, a 3,3-dimethylbutyl group, a 2-ethylbutyl group, a heptyl group, an n-heptyl group, a 1-methylhexyl group, an octyl group, an n-octyl group, a tert-octyl group, a 1-methylheptyl group, a 2-ethylhexyl group, a 2-propylpentyl group, an n-nonyl group, a 2,2-dimethylheptyl group, a 1-ethyl-propyl group, a 1,1-dimethyl-propyl group, an isohexyl group, a 2-methylpentyl group, a 4-methylhexyl group, a 5-methylhexyl group, and the like, but are not limited thereto.

In the present specification, an alkenyl group includes a straight-chain or branched-chain having 2 to 60 carbon atoms, and may be additionally substituted with another substituent. The number of carbon atoms of the alkenyl group may be 2 to 60, specifically 2 to 40, and more specifically 2 to 20. Specific examples thereof include a vinyl group, a 1-propenyl group, an isopropenyl group, a 1-butenyl group, a 2-butenyl group, a 3-butenyl group, a 1-pentenyl group, a 2-pentenyl group, a 3-pentenyl group, a 3-methyl-1-butenyl group, a 1,3-butadienyl group, an allyl group, a 1-phenylvinyl-1-yl group, a 2-phenylvinyl-1-yl group, a 2,2-diphenylvinyl-1-yl group, a 2-phenyl-2-(naphthyl-1-yl)vinyl-1-yl group, a 2,2-bis(diphenyl-1-yl)vinyl-1-yl group, a stilbenyl group, a styrenyl group, and the like, but are not limited thereto.

In the present specification, an alkynyl group includes a straight-chain or branched-chain having 2 to 60 carbon atoms, and may be additionally substituted with another substituent. The number of carbon atoms of the alkynyl group may be 2 to 60, specifically 2 to 40, and more specifically 2 to 20.

In the present specification, a haloalkyl group means an alkyl group substituted with a halogen group, and specific examples thereof include -CF₃, -CF₂CF₃, and the like, but are not limited thereto.

In the present specification, an alkoxy group is represented by -O(R101), and the above-described examples of the alkyl group may be applied to R101.

In the present specification, an aryloxy group is represented by -O(R102), and the above-described examples of the aryl group may be applied to R102.

In the present specification, an alkylthioxy group is represented by -S(R103), and the above-described examples of the alkyl group may be applied to R103.

In the present specification, an arylthioxy group is represented by -S(R104), and the above-described examples of the aryl group may be applied to R104.

In the present specification, an alkylsulfoxy group is represented by -S(=0)₂(R105), and the above-described examples of the alkyl group may be applied to R105.

In the present specification, an arylsulfoxy group is represented by -S(=0)₂(R106), and the above-described examples of the aryl group may be applied to R106.

In the present specification, a cycloalkyl group includes a monocycle or polycycle having 3 to 60 carbon atoms, and may be additionally substituted with another substituent. Here, the polycycle means a group in which a cycloalkyl group is directly linked to or fused with another cyclic group. Here, another cyclic group may also be a cycloalkyl group, but may also be another kind of cyclic group, for example, a heterocycloalkyl group, an aryl group, a heteroaryl group, and the like. The number of carbon atoms of the cycloalkyl group may be 3 to 60, specifically 3 to 40, and more specifically 5 to 20. Specific examples thereof include a cyclopropyl group, a cyclobutyl group, a cyclopentyl group, a 3-methylcyclopentyl group, a 2,3-dimethylcyclopentyl group, a cyclohexyl group, a 3-methylcyclohexyl group, a 4-methylcyclohexyl group, a 2,3-dimethylcyclohexyl group, a 3,4,5-trimethylcyclohexyl group, a 4-tert-butylcyclohexyl group, a cycloheptyl group, a cyclooctyl group, and the like, but are not limited thereto.

In the present specification, a heterocycloalkyl group includes O, S, Se, N, or Si as a heteroatom, includes a monocycle or polycycle having 2 to 60 carbon atoms, and may be additionally substituted with another substituent. Here, the polycycle means a group in which a heterocycloalkyl group is directly linked to or fused with another cyclic group. Here, another cyclic group may also be a heterocycloalkyl group, but may also be another kind of cyclic group, for example, a cycloalkyl group, an aryl group, a heteroaryl group, and the like. The number of carbon atoms of the heterocycloalkyl group may be 2 to 60, specifically 2 to 40, and more specifically 3 to 20.

In the present specification, an aryl group includes a monocycle or polycycle having 6 to 60 carbon atoms, and may be additionally substituted with another substituent. Here, the polycycle means a group in which an aryl group is directly linked to or fused with another cyclic group. Here, another cyclic group may also be an aryl group, but may also be another kind of cyclic group, for example, a cycloalkyl group, a heterocycloalkyl group, a heteroaryl group, and the like. The aryl group includes a spiro group. The number of carbon atoms of the aryl group may be 6 to 60, specifically 6 to 40, and more specifically 6 to 25. Specific examples of the aryl group include a phenyl group, a biphenyl group, a terphenyl group, a naphthyl group, an anthryl group, a chrysenyl group, a phenanthrenyl group, a perylenyl group, a fluoranthenyl group, a triphenylenyl group, a phenalenyl group, a pyrenyl group, a tetracenyl group, a pentacenyl group, a fluorenyl group, an indenyl group, an acenaphthylenyl group, a benzofluorenyl group, a spirobifluorenyl group, a 2,3-dihydro-1H-indenyl group, a fused cyclic group thereof, and the like, but are not limited thereto.

In the present specification, the terphenyl group may be selected from the following structures.

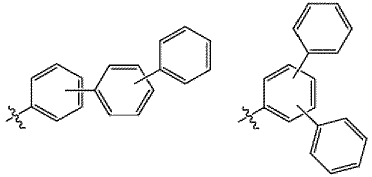

In the present specification, the fluorenyl group may be substituted, and adjacent substituents may be bonded to each other to form a ring.

When the fluorenyl group is substituted, the substituent may be 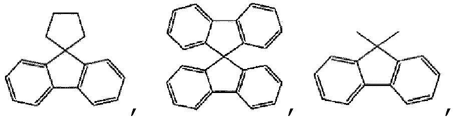 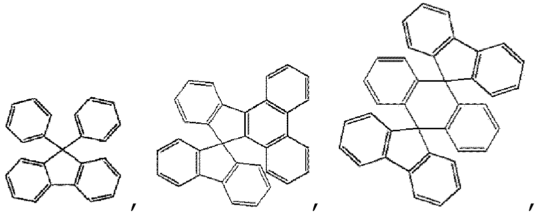 and the like, but is not limited thereto.

In the present specification, a heteroaryl group includes S, O, Se, N, or Si as a heteroatom, includes a monocycle or polycycle having 2 to 60 carbon atoms, and may be additionally substituted with another substituent. Here, the polycycle means a group in which a heteroaryl group is directly linked to or fused with another cyclic group. Here, another cyclic group may also be a heteroaryl group, but may also be another kind of cyclic group, for example, a cycloalkyl group, a heterocycloalkyl group, an aryl group, and the like. The number of carbon atoms of the heteroaryl group may be 2 to 60, specifically 2 to 40, and more specifically 3 to 25. Specific examples of the heteroaryl group include a pyridine group, a pyrrole group, a pyrimidine group, a pyridazine group, a furan group, a thiophene group, an imidazole group, a pyrazole group, an oxazole group, an isoxazole group, a thiazole group, an isothiazole group, a triazole group, a furazan group, an oxadiazole group, a thiadiazole group, a dithiazole group, a tetrazolyl group, a pyran group, a thiopyran group, a diazine group, an oxazine group, a thiazine group, a dioxin group, a triazine group, a tetrazine group, a quinoline group, an isoquinoline group, a quinazoline group, an isoquinazoline group, a quinozoline group, a naphthyridine group, an acridine group, a phenanthridine group, an imidazopyridine group, a diazanaphthalene group, a triazaindene group, an indole group, an indolizine group, a benzothiazole group, a benzoxazole group, a benzimidazole group, a benzothiophene group, a benzofuran group, a dibenzothiophene group, a dibenzofuran group, a carbazole group, a benzocarbazole group, a dibenzocarbazole group, a phenazine group, a dibenzosilole group, spirobi(dibenzosilole), a dihydrophenazine group, a phenoxazine group, a phenanthridine group, a thienyl group, an indolo[2,3-a]carbazole group, an indolo[2,3-b]carbazole group, an indoline group, a 10,11-dihydro-dibenzo[b,f]azepine group, a 9,10-dihydroacridine group, a phenanthrazine group, a phenothiathiazine group, a phthalazine group, a phenanthroline group, a naphthobenzofuran group, a naphthobenzothiophene group, a benzo[c][1,2,5]thiadiazole group, a 2,3-dihydrobenzo[b]thiophene group, a 2,3-dihydrobenzofuran group, a 5,10-dihydrodibenzo[b,e][1,4]azasiline group, a pyrazolo[1,5-c]quinazoline group, a pyrido[1,2-b]indazole group, a pyrido[1,2-a]imidazo[1,2-e]indoline group, a 5,11-dihydroindeno[1,2-b]carbazole group, and the like, but are not limited thereto.

In the present specification, when the substituent is a carbazole group, it means being bonded to nitrogen or carbon of carbazole.

In the present specification, when a carbazole group is substituted, an additional substituent may be substituted with the nitrogen or carbon of the carbazole. In the present specification, a benzocarbazole group may be any one of the following structures.

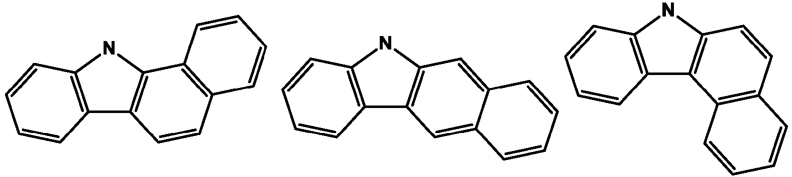

In the present specification, a dibenzocarbazole group may be any one of the following structures.

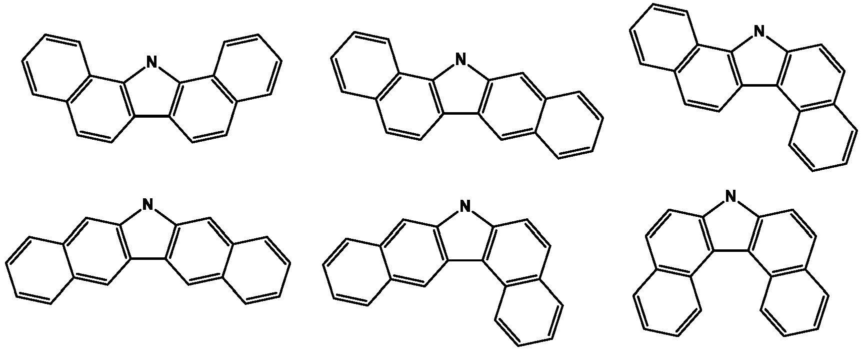

In the present specification, a naphthobenzofuran group may be any one of the following structures.

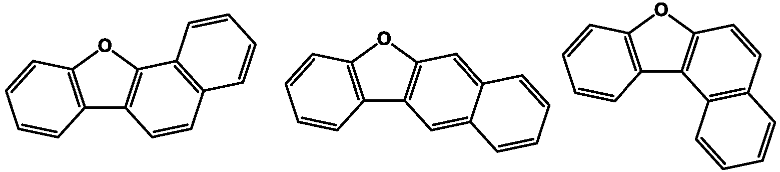

In the present specification, a naphthobenzothiophene group may be any one of the following structures.

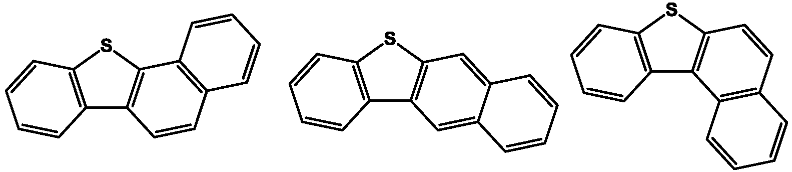

In the present specification, a silyl group includes Si and is a substituent to which the Si atom is directly linked as a radical, and is represented by - Si(R107)(R108)(R109), and R107 to R109 are the same as or different from each other, and may be each independently a substituent composed of at least one of hydrogen; deuterium; a halogen group; an alkyl group; an alkenyl group; an alkoxy group; a cycloalkyl group; a heterocycloalkyl group; an aryl group; and a heteroaryl group. Specific examples of the silyl group include 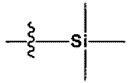 (a trimethyl silyl group), 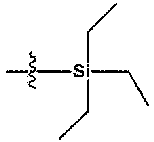 (a triethylsilyl group), 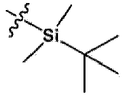 (a t-butyldimethylsilyl group), 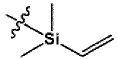 (a vinyldimethylsilyl group), 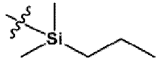 (a propyldimethylsilyl group), 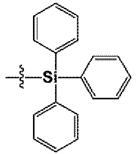 (a triphenylsilyl group), 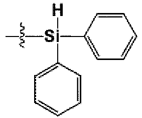 (a diphenylsilyl group), 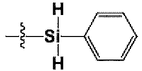 (a phenylsilyl group) and the like, but are not limited thereto.

In the present specification, a phosphine oxide group is represented by -P(=O)(R110)(R111), and R110 and R111 are the same as or different from each other, and may be each independently a substituent composed of at least one of hydrogen; deuterium; a halogen group; an alkyl group; an alkenyl group; an alkoxy group; a cycloalkyl group; a heterocycloalkyl group; an aryl group; and a heteroaryl group. Specifically, the phosphine oxide group may be substituted with an alkyl group or an aryl group, and the above-described example may be applied to the alkyl group and the aryl group. Examples of the phosphine oxide group include a dimethylphosphine oxide group, a diphenylphosphine oxide group, dinaphthylphosphine oxide, and the like, but are not limited thereto.

In the present specification, an amine group is represented by -N(R112)(R113), and R112 and R113 are the same as or different from each other, and may be each independently a substituent composed of at least one of hydrogen; deuterium; a halogen group; an alkyl group; an alkenyl group; an alkoxy group; a cycloalkyl group; a heterocycloalkyl group; an aryl group; and a heteroaryl group. The amine group may be selected from the group consisting of -NH₂; a monoalkylamine group; a monoarylamine group; a monoheteroarylamine group; a dialkylamine group; a diarylamine group; a diheteroarylamine group; an alkylarylamine group; an alkylheteroarylamine group; and an arylheteroarylamine group, and the number of carbon atoms thereof is not particularly limited, but is preferably 1 to 30. Specific examples of the amine group include a methylamine group, a dimethylamine group, an ethylamine group, a diethylamine group, a phenylamine group, a naphthylamine group, a biphenylamine group, a dibiphenylamine group, an anthracenylamine group, a 9-methyl-anthracenylamine group, a diphenylamine group, a phenylnaphthylamine group, a ditolylamine group, a phenyltolylamine group, a triphenylamine group, a biphenylnaphthylamine group, a phenylbiphenylamine group, a biphenylfluorenylamine group, a phenyltriphenylenylamine group, a biphenyltriphenylenylamine group, and the like, but are not limited thereto.

In the present specification, the above-described examples of the aryl group may be applied to an arylene group except for a divalent arylene group.

In the present specification, the above-described examples of the heteroaryl group may be applied to a heteroarylene group except for a divalent heteroarylene group.

In the present specification, the "adjacent" group may mean a substituent substituted with an atom directly linked to an atom in which the corresponding substituent is substituted, a substituent disposed to be sterically closest to the corresponding substituent, or another substituent substituted with an atom in which the corresponding substituent is substituted. For example, two substituents substituted at the ortho position in a benzene ring and two substituents substituted at the same carbon in an aliphatic ring may be interpreted as groups which are "adjacent" to each other.

Hydrocarbon rings and hetero rings that adjacent groups may form include an aliphatic hydrocarbon ring, an aromatic hydrocarbon ring, an aliphatic hetero ring and an aromatic hetero ring, and structures exemplified by the above-described cycloalkyl group, aryl group, heterocycloalkyl group and heteroaryl group may be applied to the rings, except for those that are not monovalent groups.

In an exemplary embodiment of the present application, the deuterium content of the heterocyclic compound represented by Chemical Formula 1 may be 0% to 100%.

In an exemplary embodiment of the present application, the deuterium content of the heterocyclic compound represented by Chemical Formula 1 may be 10% to 100%.

In an exemplary embodiment of the present application, the deuterium content of the heterocyclic compound represented by Chemical Formula 2 may be 0% to 100%.

In an exemplary embodiment of the present application, the deuterium content of the heterocyclic compound represented by Chemical Formula 2 may be 10% to 100%.

In an exemplary embodiment of the present application, L1 to L3 of Chemical Formula 1 are the same as or different from each other, and are each independently a direct bond; a substituted or unsubstituted C6 to C60 arylene group; or a substituted or unsubstituted C2 to C60 heteroarylene group, m1 to m3 are each independently an integer from 0 to 3, and when m1 to m3 are each 2 or higher, substituents in the parenthesis are the same as or different from each other.

In an exemplary embodiment of the present application, L1 to L3 are the same as or different from each other, and are each independently a direct bond; a substituted or unsubstituted C6 to C40 arylene group; or a substituted or unsubstituted C2 to C40 heteroarylene group.

In an exemplary embodiment of the present application, L1 to L3 are the same as or different from each other, and are each independently a direct bond; a substituted or unsubstituted C6 to C20 arylene group; or a substituted or unsubstituted C2 to C20 heteroarylene group.

In an exemplary embodiment of the present application, L1 to L3 are the same as or different from each other, and are each independently a direct bond; a substituted or unsubstituted phenylene group; a substituted or unsubstituted biphenylene group; a substituted or unsubstituted naphthylene group; a substituted or unsubstituted dimethylfluorenyl group; or a substituted or unsubstituted carbazolenylene group.

In an exemplary embodiment of the present application, L1 to L3 are the same as or different from each other, and are each independently a direct bond; a phenylene group which is unsubstituted or substituted with one or more deuteriums; a biphenylene group which is unsubstituted or substituted with one or more deuteriums; a naphthylene group which is unsubstituted or substituted with one or more deuteriums; a dimethylfluorenyl group which is unsubstituted or substituted with one or more deuteriums; or a carbazolenylene group which is unsubstituted or substituted with one or more deuteriums.

The dimethylfluorenyl group; and the carbazolenylene group mean a divalent group of a dimethylfluorene group; and a divalent group of a carbazole group, respectively. In an exemplary embodiment of the present application, m1 is an integer from 0 to 3, and when m1 is 2 or higher, L1's in the parenthesis are the same as or different from each other. In an exemplary embodiment of the present application, m1 is 0. In an exemplary embodiment of the present application, m1 is 1. In an exemplary embodiment of the present application, m1 is 2. In an exemplary embodiment of the present application, m1 is 3.

In an exemplary embodiment of the present application, m2 is an integer from 0 to 3, and when m2 is 2 or higher, L2's in the parenthesis are the same as or different from each other. In an exemplary embodiment of the present application, m2 is 0. In an exemplary embodiment of the present application, m2 is 1. In an exemplary embodiment of the present application, m2 is 2. In an exemplary embodiment of the present application, m2 is 3.

In an exemplary embodiment of the present application, m3 is an integer from 0 to 3, and when m3 is 2 or higher, L3's in the parenthesis are the same as or different from each other. In an exemplary embodiment of the present application, m3 is 0. In an exemplary embodiment of the present application, m3 is 1. In an exemplary embodiment of the present application, m3 is 2. In an exemplary embodiment of the present application, m3 is 3.

In an exemplary embodiment of the present application, R1 and R2 of Chemical Formula 1 are the same as or different from each other, and are each independently hydrogen; deuterium; or a substituted or unsubstituted C6 to C60 aryl group.

In an exemplary embodiment of the present application, R1 and R2 are the same as or different from each other, and are each independently hydrogen; deuterium; or a substituted or unsubstituted C6 to C40 aryl group. In an exemplary embodiment of the present application, R1 and R2 are the same as or different from each other, and may be each independently hydrogen; deuterium; a substituted or unsubstituted phenyl group; a substituted or unsubstituted biphenyl group; a substituted or unsubstituted terphenyl group; a substituted or unsubstituted naphthyl group; a substituted or unsubstituted phenanthrenyl group; a substituted or unsubstituted triphenylenyl group; or a substituted or unsubstituted chrysenyl group.

In an exemplary embodiment of the present application, R1 and R2 are the same as or different from each other, and may be each independently hydrogen; deuterium; a phenyl group which is unsubstituted or substituted with one or more deuteriums; a biphenyl group which is unsubstituted or substituted with one or more deuteriums; a terphenyl group which is unsubstituted or substituted with one or more deuteriums; a naphthyl group which is unsubstituted or substituted with one or more deuteriums; a phenanthrenyl group which is unsubstituted or substituted with one or more deuteriums; a triphenylenyl group which is unsubstituted or substituted with one or more deuteriums; or a chrysenyl group which is unsubstituted or substituted with one or more deuteriums.

In an exemplary embodiment of the present application, R1 and R2 are the same as or different from each other, and are each independently hydrogen; deuterium; or a substituted or unsubstituted C6 to C60 aryl group, and at least one of R1 and R2 is a substituted or unsubstituted C6 to C60 aryl group.

In an exemplary embodiment of the present application, R1 and R2 are the same as or different from each other, and are each independently hydrogen; deuterium; or a substituted or unsubstituted C6 to C60 aryl group, and at least one of R1 and R2 is a substituted or unsubstituted C6 to C40 aryl group.

In an exemplary embodiment of the present application, R1 and R2 are the same as or different from each other, and are each independently hydrogen; deuterium; or a substituted or unsubstituted C6 to C60 aryl group, and at least one of R1 and R2 is a substituted or unsubstituted C6 to C20 aryl group.

In an exemplary embodiment of the present application, R1 is hydrogen; or deuterium, and R2 is a substituted or unsubstituted C6 to C60 aryl group. When R2 is a substituted or unsubstituted C6 to C60 aryl group, the description on the aryl group of the above-described R1 and R2 may be applied.

In an exemplary embodiment of the present application, R2 is hydrogen; or deuterium, and R1 is a substituted or unsubstituted C6 to C60 aryl group. When R1 is a substituted or unsubstituted C6 to C60 aryl group, the description on the aryl group of the above-described R1 and R2 may be applied.

In an exemplary embodiment of the present application, R1 and R2 are the same as or different from each other, and may be each independently a substituted or unsubstituted C6 to C60 aryl group. In this case, the description on the aryl group of the above-described R1 and R2 may be applied.

In an exemplary embodiment of the present application, R3 of Chemical Formula 1 is a C6 to C60 aryl group; or a substituted or unsubstituted C2 to C60 heteroaryl group.

In an exemplary embodiment of the present application, R3 is a C6 to C40 aryl group; or a substituted or unsubstituted C2 to C40 heteroaryl group.

In an exemplary embodiment of the present application, R3 may be a substituted or unsubstituted phenyl group; a substituted or unsubstituted biphenyl group; a substituted or unsubstituted terphenyl group; a substituted or unsubstituted naphthyl group; a substituted or unsubstituted dimethylfluorene group; a substituted or unsubstituted spirobifluorenyl group; a substituted or unsubstituted phenanthrenyl group; a substituted or unsubstituted triphenylenyl group; a substituted or unsubstituted chrysenyl group; a substituted or unsubstituted carbazole group; a substituted or unsubstituted dibenzofuran group; or a substituted or unsubstituted dibenzothiophene group.

In an exemplary embodiment of the present application, R3 may be a phenyl group which is unsubstituted or substituted with one or more deuteriums; a biphenyl group which is unsubstituted or substituted with one or more deuteriums; a terphenyl group which is unsubstituted or substituted with one or more deuteriums; a naphthyl group which is unsubstituted or substituted with one or more deuteriums; a dimethylfluorene group which is unsubstituted or substituted with one or more deuteriums; a spirobifluorenyl group which is unsubstituted or substituted with one or more deuteriums; a phenanthrenyl group which is unsubstituted or substituted with one or more deuteriums; a triphenylenyl group which is unsubstituted or substituted with one or more deuteriums; a chrysenyl group which is unsubstituted or substituted with one or more deuteriums; a carbazole group which is unsubstituted or substituted with one or more deuteriums; a dibenzofuran group which is unsubstituted or substituted with one or more deuteriums; or a dibenzothiophene group which is unsubstituted or substituted with one or more deuteriums.

In an exemplary embodiment of the present application, Ra to Rc of Chemical Formula 1 are hydrogen; deuterium; a halogen group; a cyano group; or a substituted or unsubstituted alkyl group having 1 to 60 carbon atoms, a is an integer from 0 to 3, and when a is an integer of 2 or higher, Ra's in the parenthesis are the same as or different from each other, b is an integer from 0 to 2, and when b is 2, Rb's in the parenthesis are the same as or different from each other, and c is an integer from 0 to 4, and when c is an integer of 2 or higher, Rc's in the parenthesis are the same as or different from each other.

In an exemplary embodiment of the present application, Ra to Rc are hydrogen; or deuterium.

In an exemplary embodiment of the present application, a is an integer from 0 to 3, and when a is an integer of 2 or higher, Ra's in the parenthesis are the same as or different from each other. In an exemplary embodiment of the present application, a is 0. In an exemplary embodiment of the present application, a is 1. In an exemplary embodiment of the present application, a is 2. In an exemplary embodiment of the present application, a is 3.

In an exemplary embodiment of the present application, b is an integer from 0 to 2, and when b is 2, Rb's in the parenthesis are the same as or different from each other. In an exemplary embodiment of the present application, b is 0. In an exemplary embodiment of the present application, b is 1. In an exemplary embodiment of the present application, b is 2.

In an exemplary embodiment of the present application, c is an integer from 0 to 4, and when c is an integer of 2 or higher, Rc's in the parenthesis are the same as or different from each other. In an exemplary embodiment of the present application, c is 0. In an exemplary embodiment of the present application, c is 1. In an exemplary embodiment of the present application, c is 2. In an exemplary embodiment of the present application, c is 3. In an exemplary embodiment of the present application, b is 1. In an exemplary embodiment of the present application, c is 4.

In an exemplary embodiment of the present application, Chemical Formula 1 may be represented by the following Chemical Formula 1-1 or Chemical Formula 1-2.

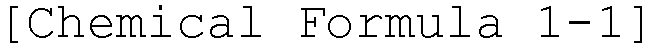

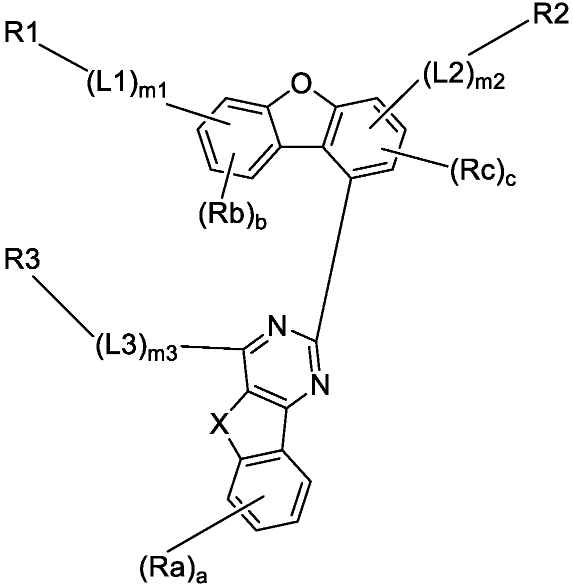

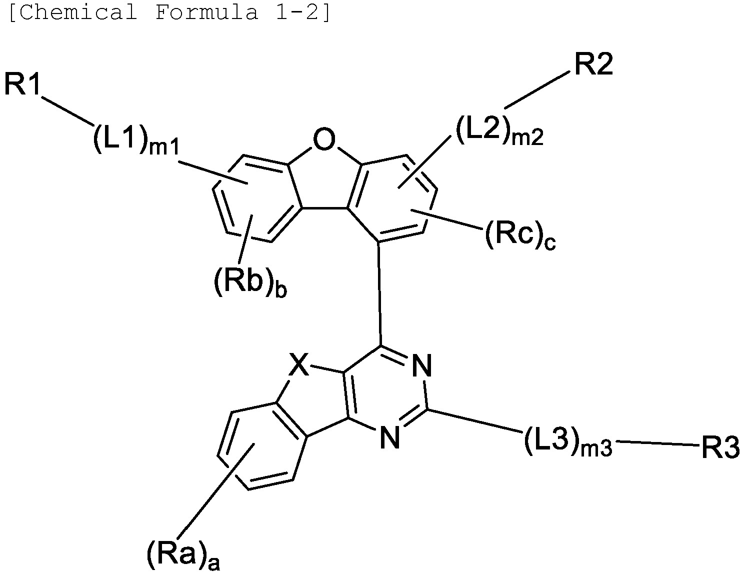

In Chemical Formulae 1-1 and 1-2, the definitions of X, L1 to L3, R1 to R3, Ra to Rc, m1 to m3, a, b and c are the same as those in Chemical Formula 1.

In an exemplary embodiment of the present application, in Chemical Formula 2, one of R11 to R18 is a group represented by the following Chemical Formula A, one of the others is a group represented by the following Chemical Formula B, and the rest are the same as or different from each other, and are each independently hydrogen; or deuterium, or bonded to an adjacent group to form a benzene ring.

In an exemplary embodiment of the present application, Chemical Formula 2 may be represented by any one of the following Chemical Formulae 2-1 to 2-4.

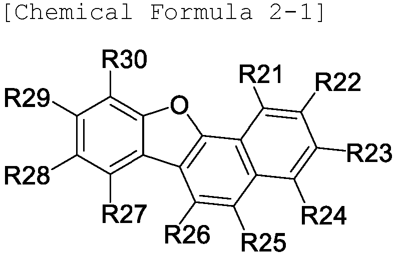

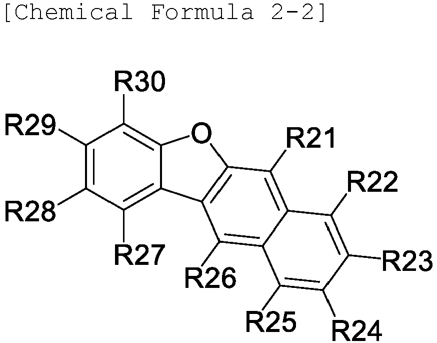

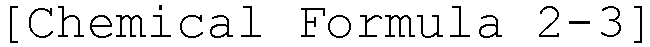

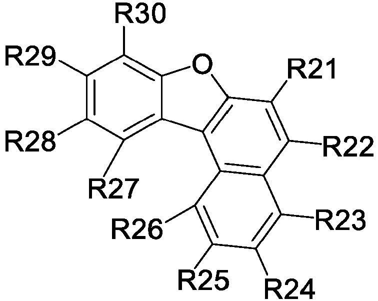

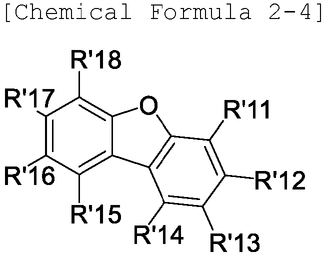

In Chemical Formulae 2-1 to 2-3, one of R21 to R30 is the group represented by Chemical Formula A, one of the others is the group represented by Chemical Formula B, and the rest are the same as or different from each other, and are each independently hydrogen; or deuterium, and
in Chemical Formula 2-4, one of R'11 to R'18 is the group represented by Chemical Formula A, one of the others is the group represented by Chemical Formula B, and the rest are the same as or different from each other, and are each independently hydrogen; or deuterium.

In an exemplary embodiment of the present application, Ln, L4 and L5 of Chemical Formula A are the same as or different from each other, and are each independently a direct bond; a substituted or unsubstituted C6 to C60 arylene group; or a substituted or unsubstituted C2 to C60 heteroarylene group, n, m4 and m5 are each independently an integer from 0 to 3, and when n, m4 and m5 are each 2 or higher, substituents in the parenthesis are the same as or different from each other.

In an exemplary embodiment of the present application, Ln, L4 and L5 are the same as or different from each other, and are each independently a direct bond; a substituted or unsubstituted C6 to C40 arylene group; or a substituted or unsubstituted C2 to C40 heteroarylene group.

In an exemplary embodiment of the present application, Ln, L4 and L5 are the same as or different from each other, and are each independently a direct bond; a substituted or unsubstituted C6 to C20 arylene group; or a substituted or unsubstituted C2 to C20 heteroarylene group.

In an exemplary embodiment of the present application, Ln, L4 and L5 are the same as or different from each other, and are each independently a direct bond; or a substituted or unsubstituted phenylene group.

In an exemplary embodiment of the present application, Ln, L4 and L5 are the same as or different from each other, and are each independently a direct bond; or a phenylene group which is unsubstituted or substituted with one or more deuteriums.

In an exemplary embodiment of the present application, R4 and R5 of Chemical Formula A are the same as or different from each other, and are each independently a substituted or unsubstituted C6 to C60 aryl group; or a substituted or unsubstituted C2 to C60 heteroaryl group, or R4 and R5 are bonded to each other to form a ring.

In an exemplary embodiment of the present application, R4 and R5 are the same as or different from each other, and are each independently a substituted or unsubstituted C6 to C40 aryl group; or a substituted or unsubstituted C2 to C40 heteroaryl group.

In an exemplary embodiment of the present application, R4 and R5 are the same as or different from each other, and are each independently a substituted or unsubstituted C6 to C20 aryl group; or a substituted or unsubstituted C2 to C20 heteroaryl group.

In an exemplary embodiment of the present application, R4 and R5 are the same as or different from each other, and may be each independently a substituted or unsubstituted phenyl group; a substituted or unsubstituted biphenyl group; a substituted or unsubstituted naphthyl group; a substituted or unsubstituted dimethylfluorene group; a substituted or unsubstituted phenanthrenyl group; a substituted or unsubstituted dibenzofuran group; or a substituted or unsubstituted dibenzothiophene group.

In an exemplary embodiment of the present application, R4 and R5 are the same as or different from each other, and may be each independently a phenyl group which is unsubstituted or substituted with one or more deuteriums; a biphenyl group which is unsubstituted or substituted with one or more deuteriums; a naphthyl group which is unsubstituted or substituted with one or more deuteriums; a dimethylfluorene group which is unsubstituted or substituted with one or more deuteriums; a phenanthrenyl group which is unsubstituted or substituted with one or more deuteriums; a dibenzofuran group which is unsubstituted or substituted with one or more deuteriums; or a dibenzothiophene group which is unsubstituted or substituted with one or more deuteriums.

In an exemplary embodiment of the present application, R4 and R5 may be bonded to each other to form a ring.

In an exemplary embodiment of the present application, Chemical Formula A may be represented by any one of the following Chemical Formulae A-1 to A-3.

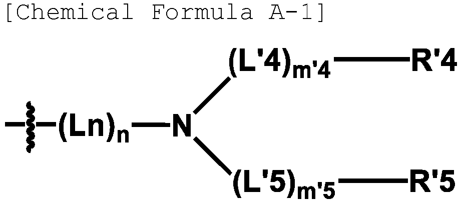

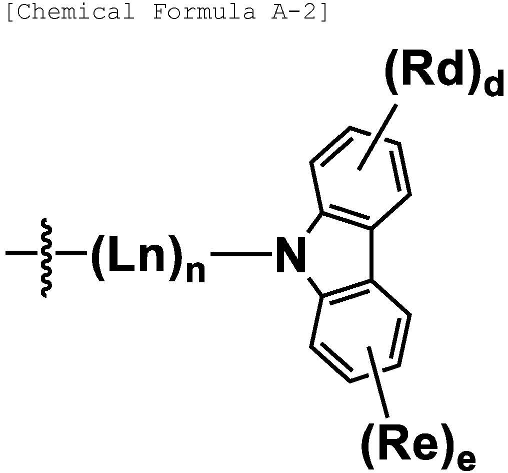

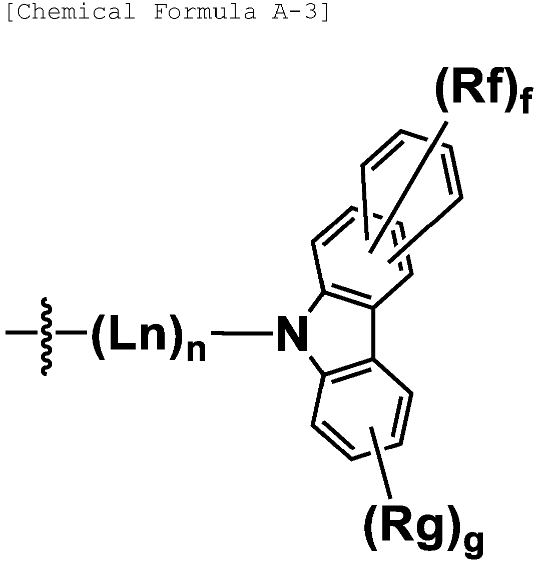

In Chemical Formulae A-1 to A-3,
L'4 and L'5 are the same as or different from each other, and are each independently a direct bond; a substituted or unsubstituted C6 to C60 arylene group; or a substituted or unsubstituted C2 to C60 heteroarylene group, m'4 and m'5 are each independently an integer from 0 to 3, and when m'4 and m'5 are each 2 or higher, substituents in the parenthesis are the same as or different from each other,
R'4 and R'5 are the same as or different from each other, and are each independently a substituted or unsubstituted C6 to C60 aryl group; or a substituted or unsubstituted C2 to C60 heteroaryl group,
Rd to Rg are the same as or different from each other, and are each independently hydrogen; deuterium; a halogen group; a cyano group; or a substituted or unsubstituted alkyl group having 1 to 60 carbon atoms, d, e and g are each independently an integer from 0 to 4, and when d, e and g are each 2 or higher, substituents in the parenthesis are the same as or different from each other, and f is an integer from 0 to 6, and when f is 2 or higher, substituents in the parenthesis are the same as or different from each other, and
the definitions of Ln and n are the same as those in Chemical Formula A.

That is, the group represented by Chemical Formula A may be an amine group, a carbazole group or a benzocarbazole group.

In an exemplary embodiment of the present application, L'4 and L'5 are the same as or different from each other, and are each independently a direct bond; a substituted or unsubstituted C6 to C40 arylene group; or a substituted or unsubstituted C2 to C40 heteroarylene group.

In an exemplary embodiment of the present application, L'4 and L'5 are the same as or different from each other, and are each independently a direct bond; a substituted or unsubstituted C6 to C20 arylene group; or a substituted or unsubstituted C2 to C20 heteroarylene group.

In an exemplary embodiment of the present application, L'4 and L'5 are the same as or different from each other, and are each independently a direct bond; or a substituted or unsubstituted phenylene group.

In an exemplary embodiment of the present application, L'4 and L'5 are the same as or different from each other, and are each independently a direct bond; or a phenylene group which is unsubstituted or substituted with one or more deuteriums.

In an exemplary embodiment of the present application, R'4 and R'5 are the same as or different from each other, and are each independently a substituted or unsubstituted C6 to C40 aryl group; or a substituted or unsubstituted C2 to C40 heteroaryl group.

In an exemplary embodiment of the present application, R'4 and R'5 are the same as or different from each other, and are each independently a substituted or unsubstituted C6 to C20 aryl group; or a substituted or unsubstituted C2 to C20 heteroaryl group.

In an exemplary embodiment of the present application, R'4 and R'5 are the same as or different from each other, and may be each independently a substituted or unsubstituted phenyl group; a substituted or unsubstituted biphenyl group; a substituted or unsubstituted naphthyl group; a substituted or unsubstituted dimethylfluorene group; a substituted or unsubstituted phenanthrenyl group; a substituted or unsubstituted dibenzofuran group; or a substituted or unsubstituted dibenzothiophene group.

In an exemplary embodiment of the present application, R'4 and R'5 are the same as or different from each other, and may be each independently a phenyl group which is unsubstituted or substituted with one or more deuteriums; a biphenyl group which is unsubstituted or substituted with one or more deuteriums; a naphthyl group which is unsubstituted or substituted with one or more deuteriums; a dimethylfluorene group which is unsubstituted or substituted with one or more deuteriums; a phenanthrenyl group which is unsubstituted or substituted with one or more deuteriums; a dibenzofuran group which is unsubstituted or substituted with one or more deuteriums; or a dibenzothiophene group which is unsubstituted or substituted with one or more deuteriums.

In an exemplary embodiment of the present application, L6 of Chemical Formula B is a direct bond; a substituted or unsubstituted C6 to C60 arylene group; or a substituted or unsubstituted C2 to C60 heteroarylene group, and m6 is an integer from 0 to 3, and when m6 is 2 or higher, substituents in the parenthesis are the same as or different from each other.

In an exemplary embodiment of the present application, L6 is a direct bond; a substituted or unsubstituted C6 to C40 arylene group; or a substituted or unsubstituted C2 to C40 heteroarylene group.

In an exemplary embodiment of the present application, L6 is a direct bond; a substituted or unsubstituted C6 to C20 arylene group; or a substituted or unsubstituted C2 to C20 heteroarylene group.

In an exemplary embodiment of the present application, L6 is a direct bond; a substituted or unsubstituted phenylene group; or a substituted or unsubstituted naphthylene group.

In an exemplary embodiment of the present application, L6 is a direct bond; a phenylene group which is unsubstituted or substituted with one or more deuteriums; or a naphthylene group which is unsubstituted or substituted with one or more deuteriums.

In an exemplary embodiment of the present application, Rd to Rg are the same as or different from each other, and are each independently hydrogen; deuterium; a halogen group; a cyano group; or a substituted or unsubstituted alkyl group having 1 to 40 carbon atoms, d, e and g are each independently an integer from 0 to 4, and when d, e and g are each 2 or higher, substituents in the parenthesis are the same as or different from each other, and f is an integer from 0 to 6, and when f is 2 or higher, substituents in the parenthesis are the same as or different from each other.

In an exemplary embodiment of the present application, Rd to Rg are the same as or different from each other, and are each independently hydrogen; or deuterium.

In an exemplary embodiment of the present application, all of Rd to Rg are hydrogen.

In an exemplary embodiment of the present application, all of Rd to Rg are deuterium.

In an exemplary embodiment of the present application, R6 is a substituted or unsubstituted C6 to C60 aryl group; or a monocyclic or polycyclic heterocyclic group which is substituted or unsubstituted and includes one or more N's.

In an exemplary embodiment of the present application, R6 is a substituted or unsubstituted C6 to C40 aryl group; or a monocyclic or polycyclic heterocyclic group which is substituted or unsubstituted and includes one or more N's.

In an exemplary embodiment of the present application, R6 is a substituted or unsubstituted C6 to C20 aryl group; or a monocyclic or polycyclic heterocyclic group which is substituted or unsubstituted and includes one or more N's.

In an exemplary embodiment of the present application, R6 is a substituted or unsubstituted phenyl group; a substituted or unsubstituted naphthyl group; a substituted or unsubstituted phenanthrenyl group; or a monocyclic or polycyclic heterocyclic group which is substituted or unsubstituted and includes one or more N's.

In an exemplary embodiment of the present application, R6 is a phenyl group which is unsubstituted or substituted with one or more deuteriums; a naphthyl group which is unsubstituted or substituted with one or more deuteriums; a phenanthrenyl group which is unsubstituted or substituted with one or more deuteriums; or a monocyclic or polycyclic heterocyclic group which is unsubstituted or substituted with one or more deuteriums and includes one or more N's.

In an exemplary embodiment of the present application, the monocyclic or polycyclic heterocyclic group which is substituted or unsubstituted and includes one or more N's may include one or more and three or less N's.

In an exemplary embodiment of the present application, the monocyclic or polycyclic heterocyclic group which is substituted or unsubstituted and includes one or more N's may be represented by the following Chemical Formula 3.

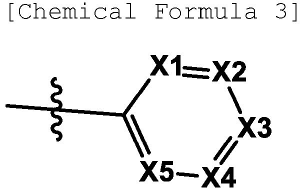

In Chemical Formula 3,
X1 is CR101 or N, X2 is CR102 or N, X3 is CR103 or N, X4 is CR104 or N, and X5 is CR105 or N, and
R101 to R105 are the same as or different from each other, and are each independently selected from the group consisting of hydrogen; deuterium; a halogen; a cyano group; a substituted or unsubstituted C1 to C60 alkyl group; a substituted or unsubstituted C2 to C60 alkenyl group; a substituted or unsubstituted C2 to C60 alkynyl group; a substituted or unsubstituted C1 to C20 alkoxy group; a substituted or unsubstituted C3 to C60 cycloalkyl group; a substituted or unsubstituted C2 to C60 heterocycloalkyl group; a substituted or unsubstituted C6 to C60 aryl group; a substituted or unsubstituted C2 to C60 heteroaryl group; a substituted or unsubstituted phosphine oxide group; and a substituted or unsubstituted amine group, or two or more adjacent groups are bonded to each other to form a substituted or unsubstituted aliphatic or aromatic hydrocarbon ring or hetero ring, and here, 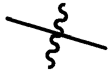 is a moiety linked to L6 of Chemical Formula B.

In an exemplary embodiment of the present application, Chemical Formula 3 may be represented by one of the following Chemical Formulae 4 to 7.

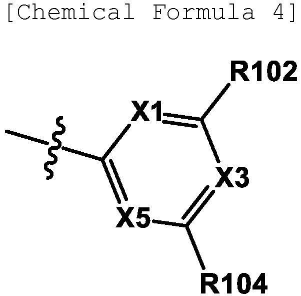

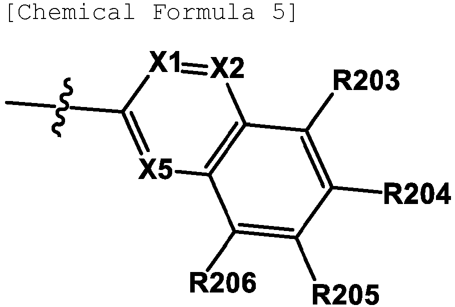

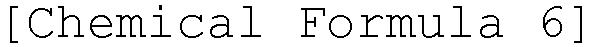

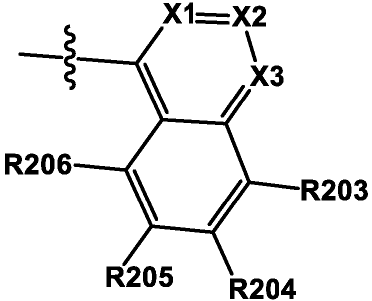

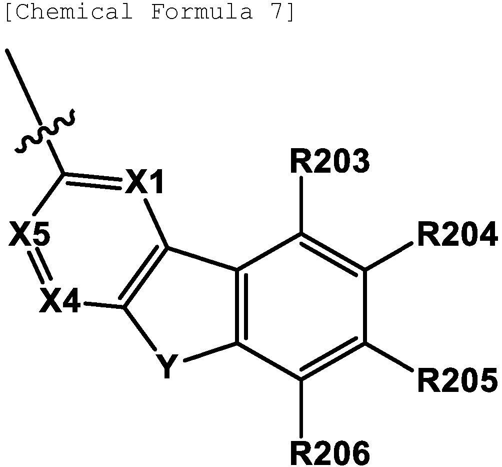

In Chemical Formula 4, one or more of X1, X3 and X5 are N, and the others are the same as those defined in Chemical Formula 3,
in Chemical Formula 5, one or more of X1, X2 and X5 are N, and the others are the same as those defined in Chemical Formula 3,
in Chemical Formula 6, one or more of X1 to X3 are N, and the others are the same as those defined in Chemical Formula 3,
in Chemical Formula 7, one or more of X1, X4 and X5 are N, and the others are the same as those defined in Chemical Formula 3,
Y is O; or S, and
R102, R104 and R203 to R206 are the same as or different from each other, and are each independently selected from the group consisting of hydrogen; deuterium; a halogen; a cyano group; a substituted or unsubstituted C1 to C60 alkyl group; a substituted or unsubstituted C2 to C60 alkenyl group; a substituted or unsubstituted C2 to C60 alkynyl group; a substituted or unsubstituted C1 to C20 alkoxy group; a substituted or unsubstituted C3 to C60 cycloalkyl group; a substituted or unsubstituted C2 to C60 heterocycloalkyl group; a substituted or unsubstituted C6 to C60 aryl group; a substituted or unsubstituted C2 to C60 heteroaryl group; a substituted or unsubstituted phosphine oxide group; and a substituted or unsubstituted amine group, or two or more adjacent groups are bonded to each other to form a substituted or unsubstituted aliphatic or aromatic hydrocarbon ring or hetero ring, and the definition of 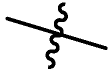 is the same as that in Chemical Formula 3.

In an exemplary embodiment of the present application, Chemical Formula 4 may be selected by any one of the structural formulae of the following Group A.

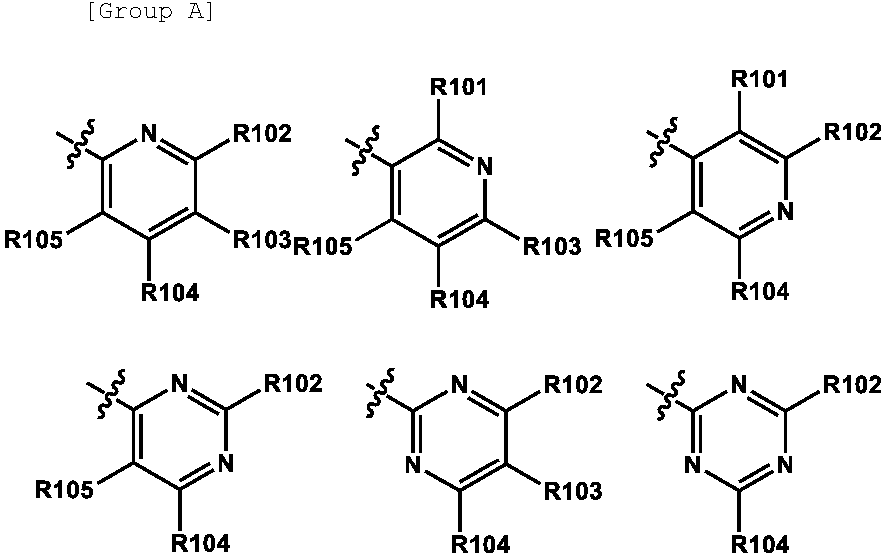

The definitions of the substituents of the structural formulae of Group A are the same as those in Chemical Formula 4.

In an exemplary embodiment of the present application, Chemical Formula 5 may be represented by the following Chemical Formula 5-1 or Chemical Formula 5-2.

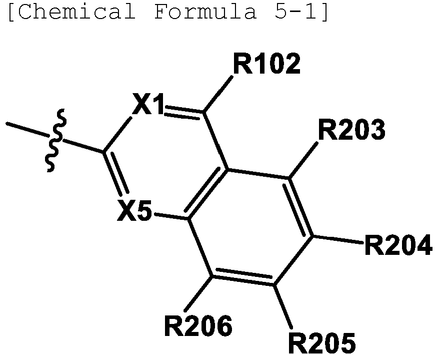

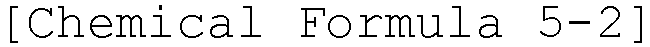

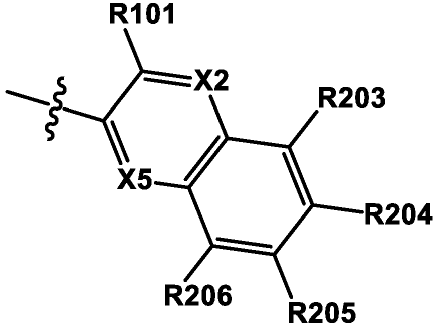

The substituents of Chemical Formulae 5-1 and 5-2 are the same as those defined in Chemical Formula 5.

In an exemplary embodiment of the present application, Chemical Formula 6 may be represented by the following Chemical Formula 6-1.

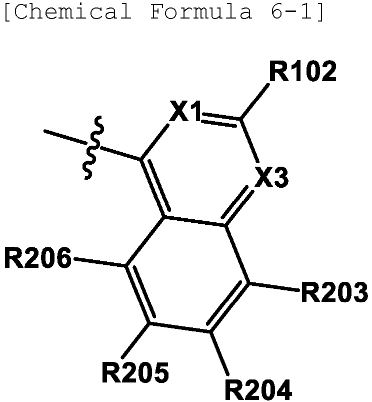

The substituents of Chemical Formula 6-1 are the same as those defined in Chemical Formula 6.

In an exemplary embodiment of the present application, Chemical Formula 7 may be represented by the following Chemical Formula 7-1.

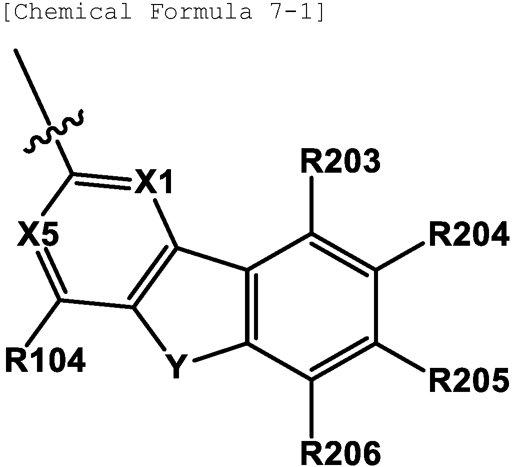

The substituents of Chemical Formula 7-1 are the same as those defined in Chemical Formula 7.

In an exemplary embodiment of the present application, R102, R104 and R203 to R206 are the same as or different from each other, and may be each independently hydrogen; deuterium; a halogen; a cyano group; a substituted or unsubstituted C1 to C60 alkyl group; a substituted or unsubstituted C6 to C60 aryl group; or a substituted or unsubstituted C2 to C60 heteroaryl group.

In an exemplary embodiment of the present application, R102, R104 and R203 to R206 are the same as or different from each other, and may be each independently hydrogen; deuterium; a substituted or unsubstituted C6 to C60 aryl group; or a substituted or unsubstituted C2 to C60 heteroaryl group.

In an exemplary embodiment of the present application, R102, R104 and R203 to R206 are the same as or different from each other, and may be each independently hydrogen; deuterium; a substituted or unsubstituted C6 to C40 aryl group; or a substituted or unsubstituted C2 to C40 heteroaryl group.

In an exemplary embodiment of the present application, the deuterium content of the heterocyclic compound represented by Chemical Formula 1 is 0% or more and 100% or less.

In an exemplary embodiment of the present application, the heterocyclic compound represented by Chemical Formula 1 does not include deuterium or includes deuterium.

In an exemplary embodiment of the present application, when the heterocyclic compound represented by Chemical Formula 1 includes deuterium, the deuterium content of the heterocyclic compound represented by Chemical Formula 1 is 10% or more and 100% or less.

In an exemplary embodiment of the present application, the deuterium content of the heterocyclic compound represented by Chemical Formula 1 is 20% or more and 100% or less.

In an exemplary embodiment of the present application, the deuterium content of the heterocyclic compound represented by Chemical Formula 1 is 40% or more and 100% or less.

In an exemplary embodiment of the present application, the deuterium content of the heterocyclic compound represented by Chemical Formula 2 is 0% or more and 100% or less.

In an exemplary embodiment of the present application, the heterocyclic compound represented by Chemical Formula 2 does not include deuterium or includes deuterium.

In an exemplary embodiment of the present application, when the heterocyclic compound represented by Chemical Formula 2 includes deuterium, the deuterium content of the heterocyclic compound represented by Chemical Formula 2 is 10% or more and 100% or less.

In an exemplary embodiment of the present application, the deuterium content of the heterocyclic compound represented by Chemical Formula 2 is 20% or more and 100% or less.

In an exemplary embodiment of the present application, the deuterium content of the heterocyclic compound represented by Chemical Formula 2 is 40% or more and 100% or less.

According to an exemplary embodiment of the present application, Chemical Formula 1 may be represented by any one of the following compounds, but is not limited thereto.

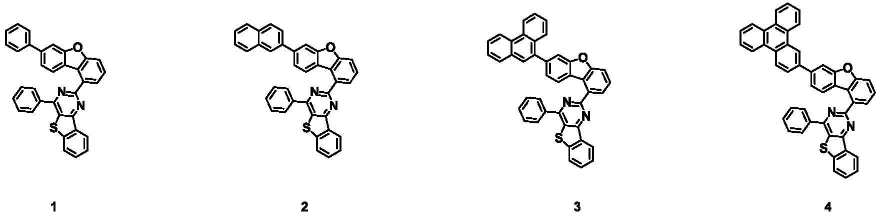

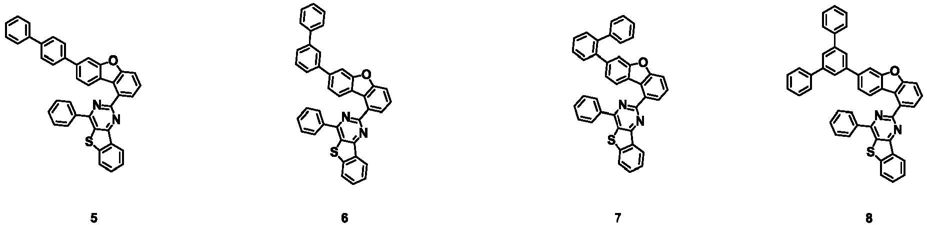

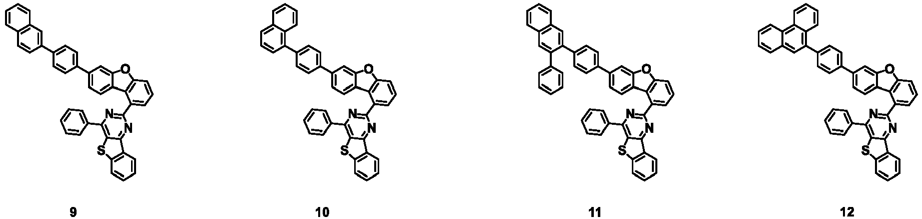

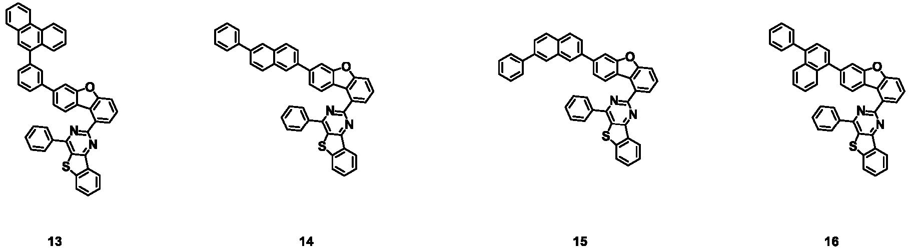

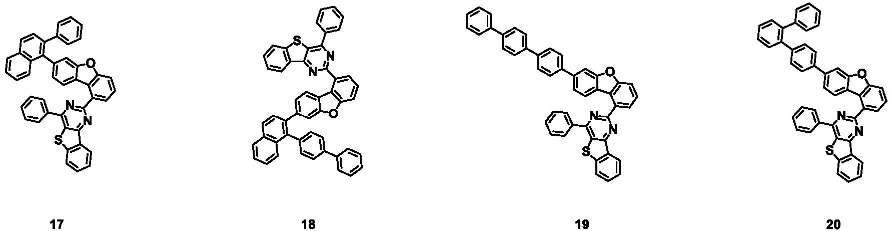

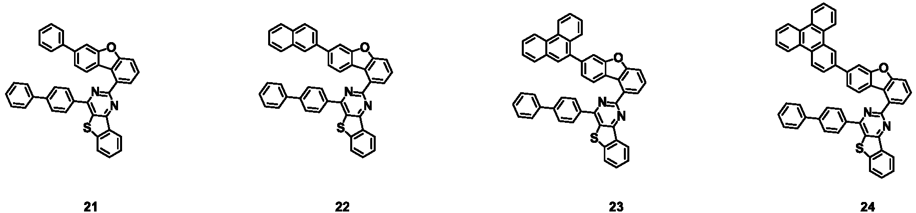

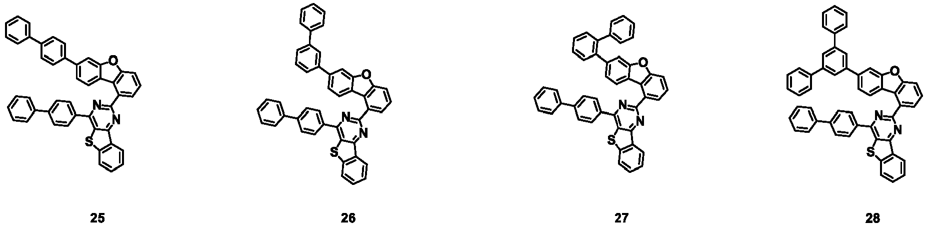

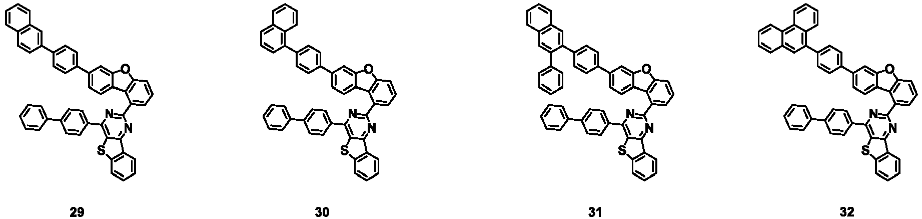

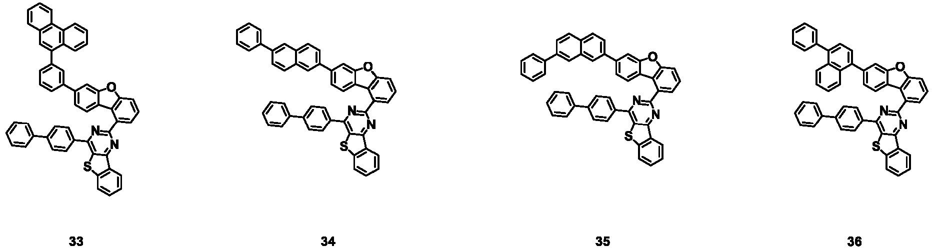

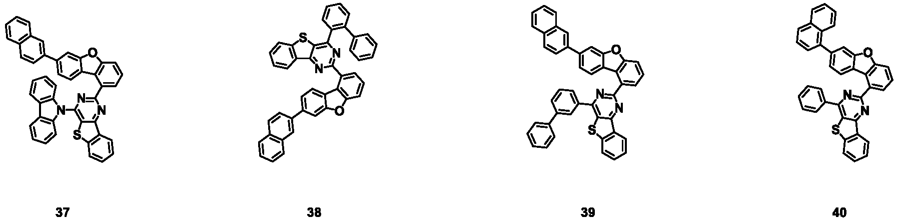

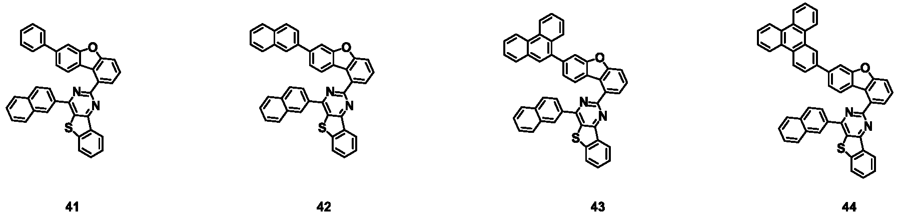

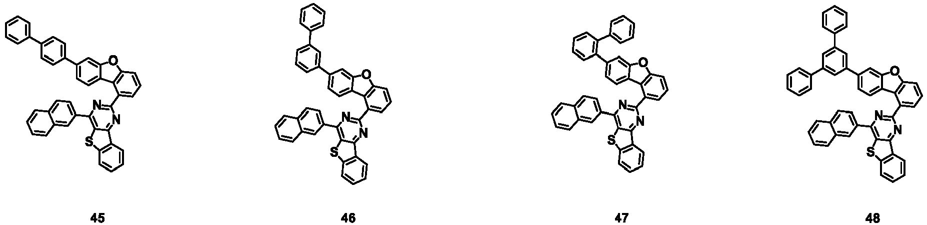

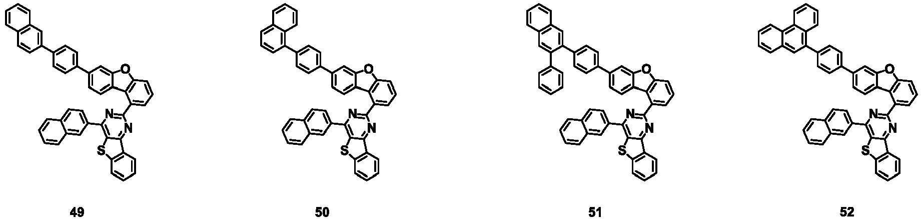

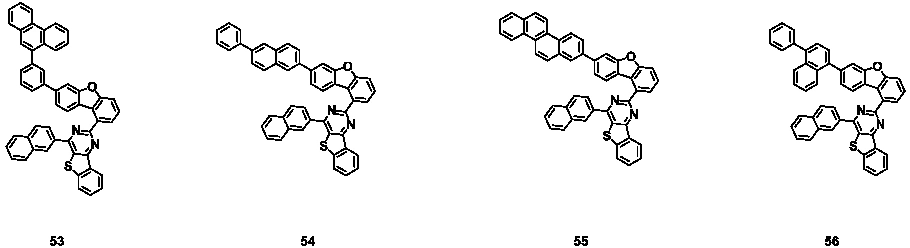

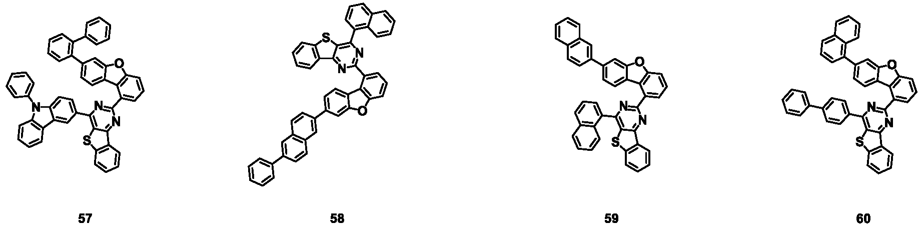

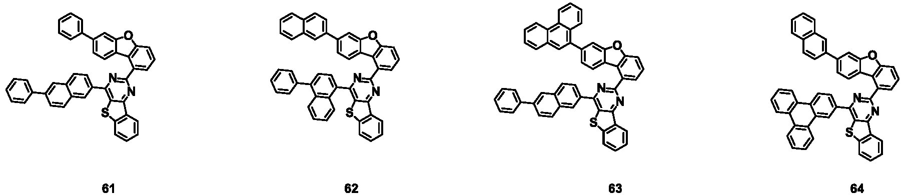

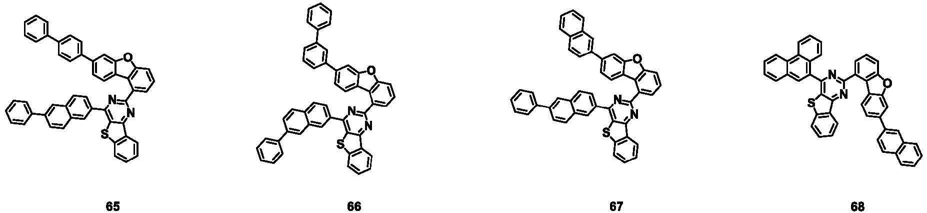

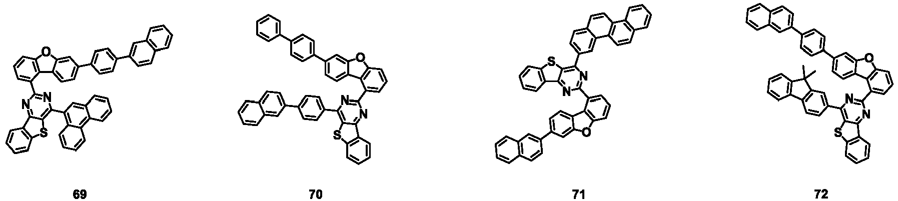

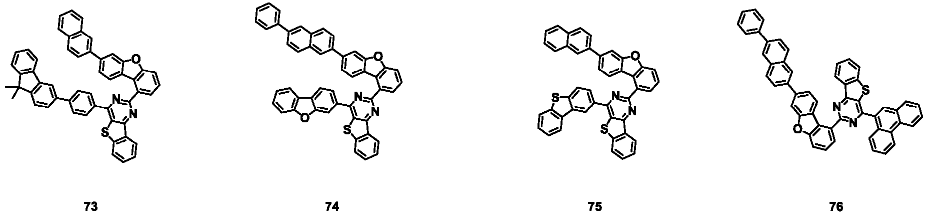

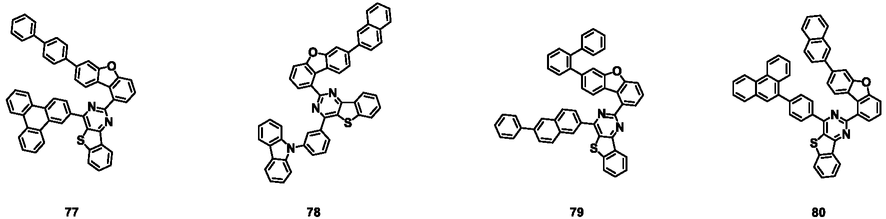

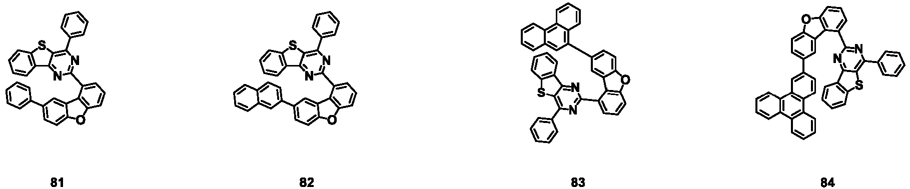

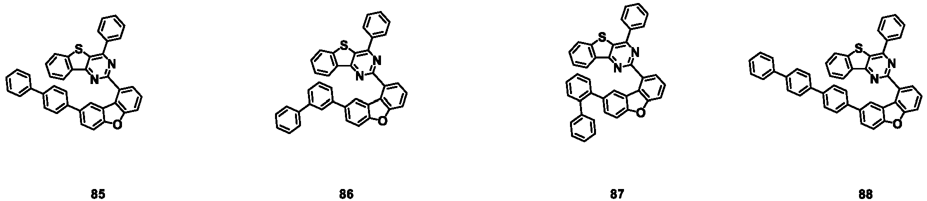

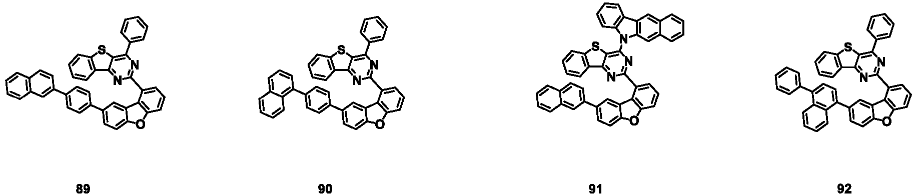

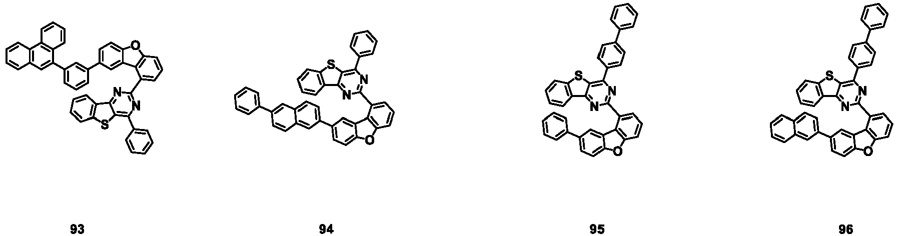

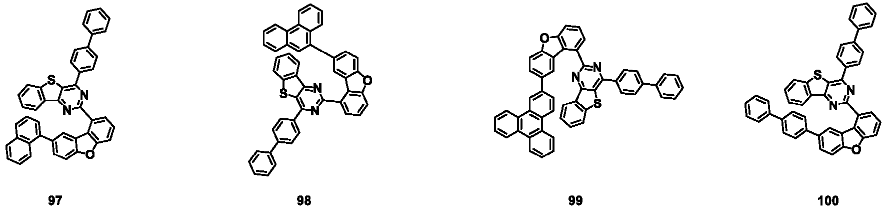

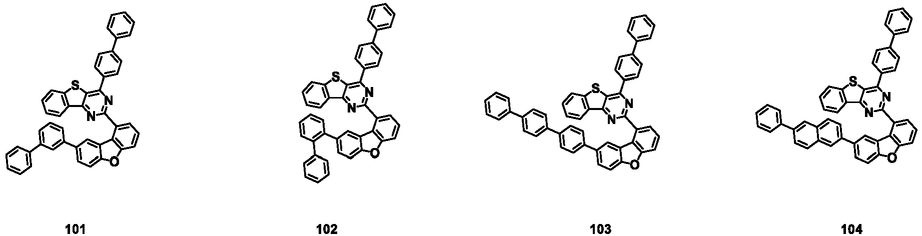

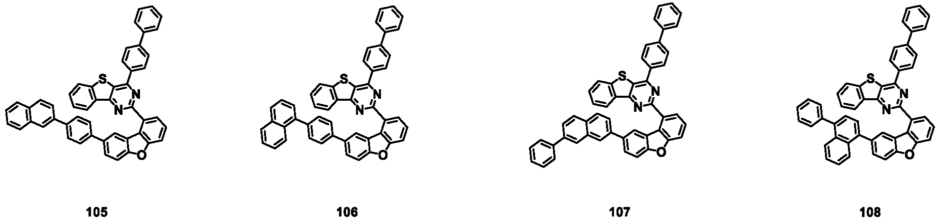

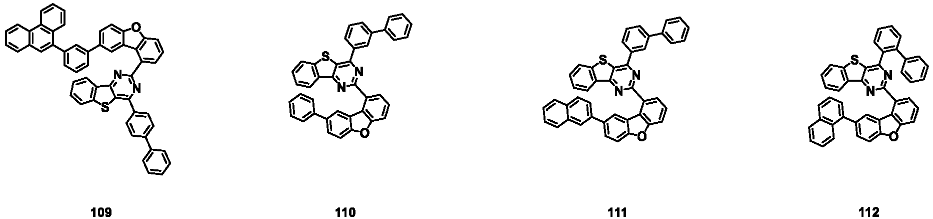

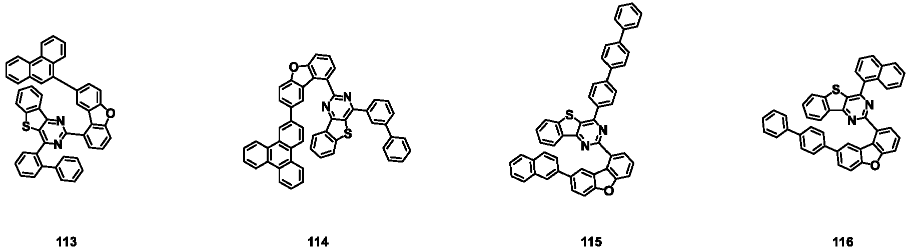

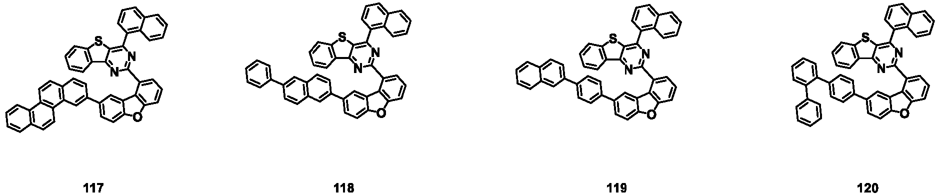

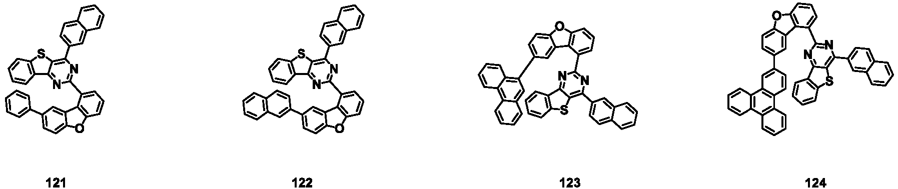

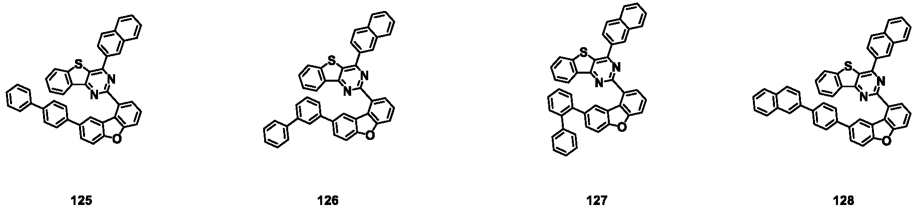

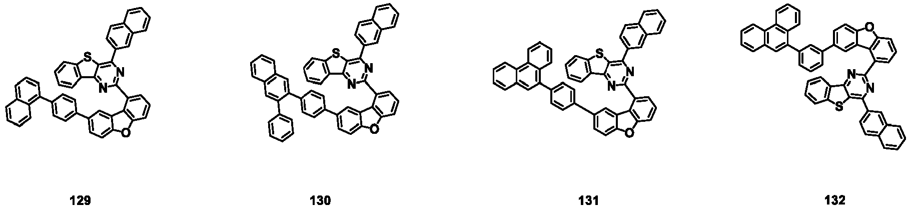

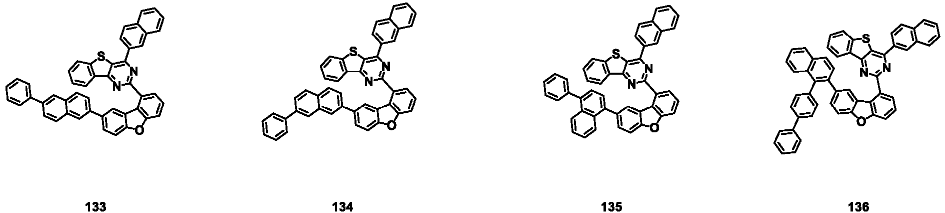

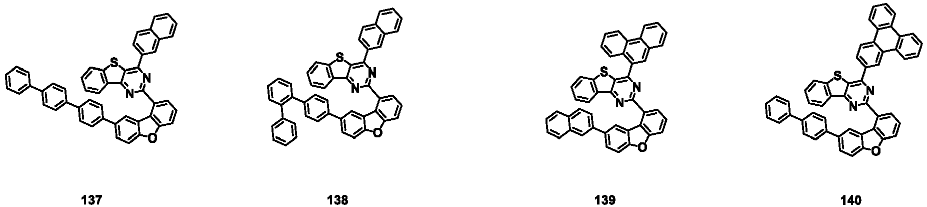

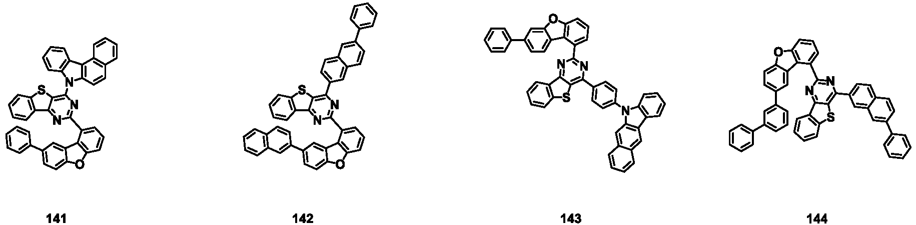

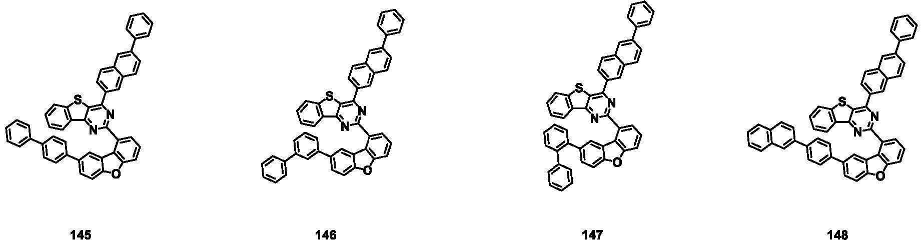

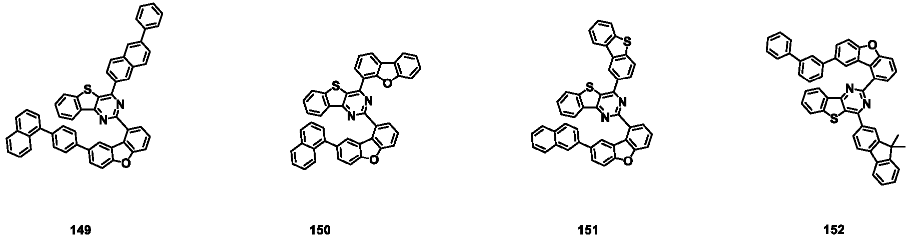

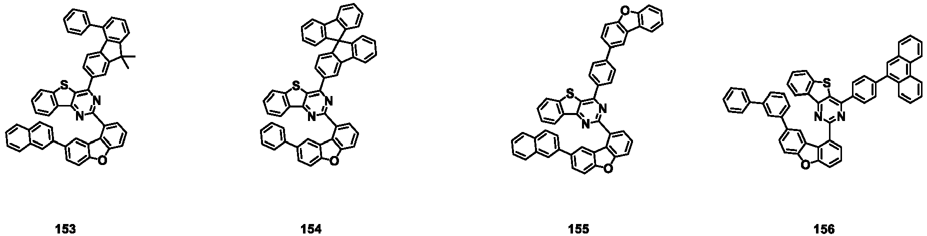

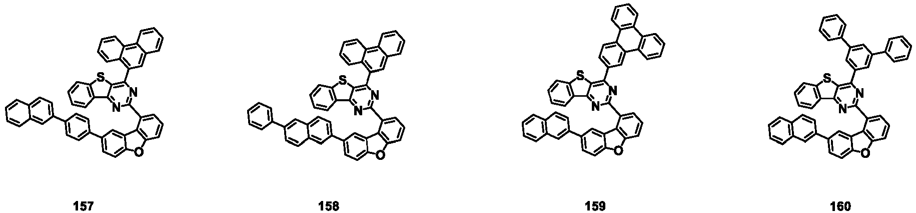

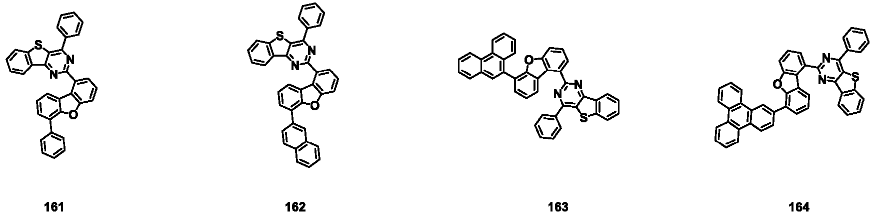

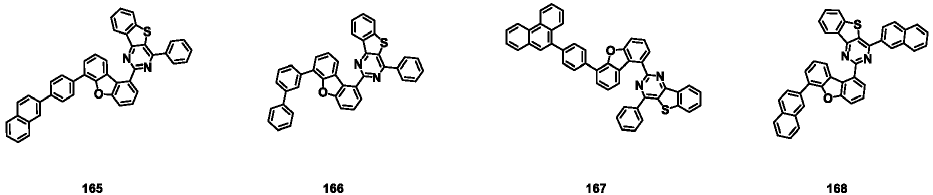

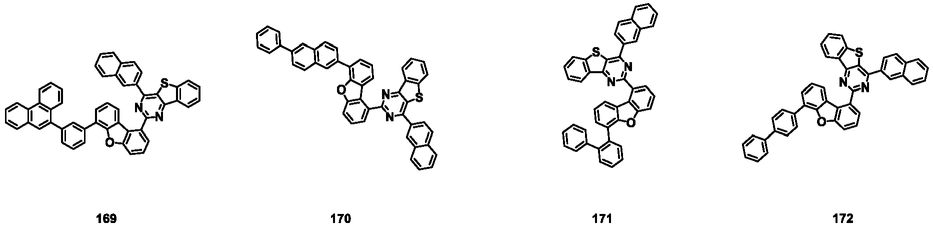

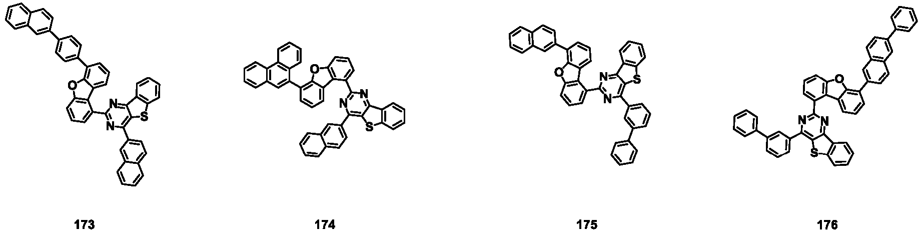

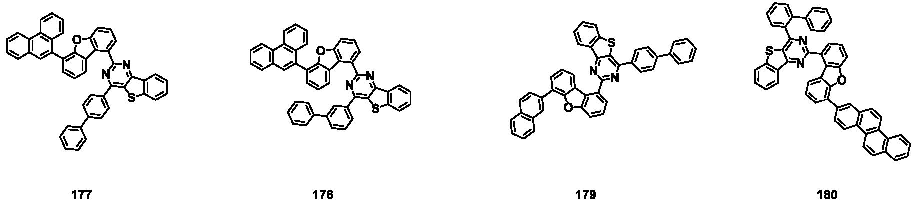

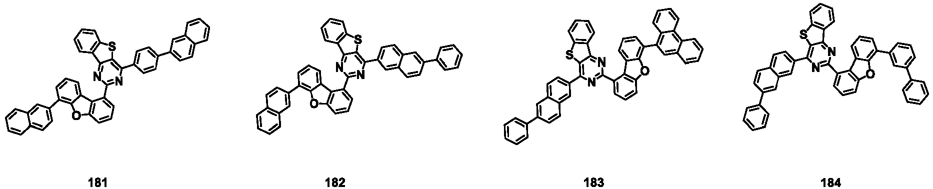

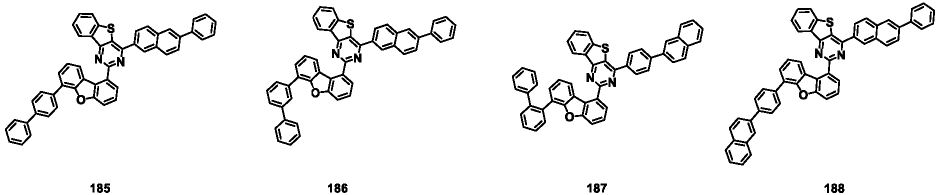

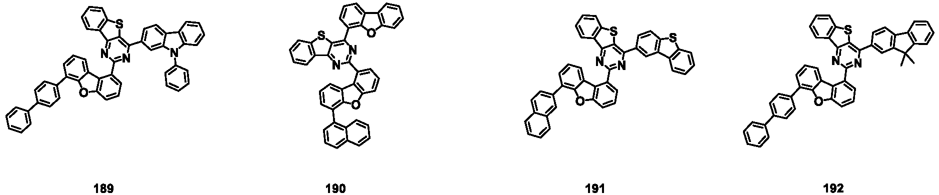

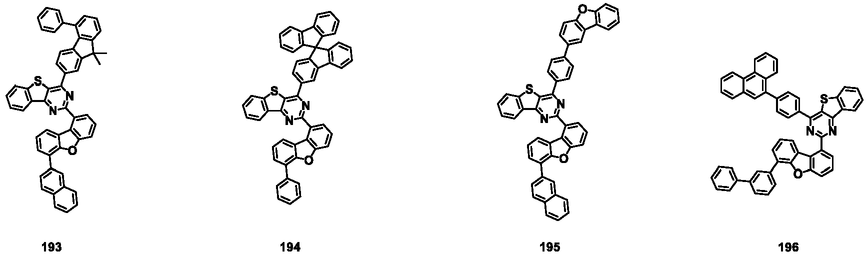

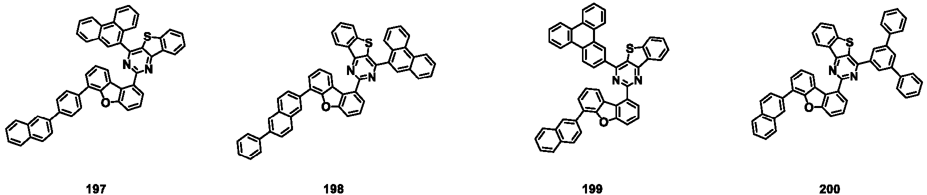

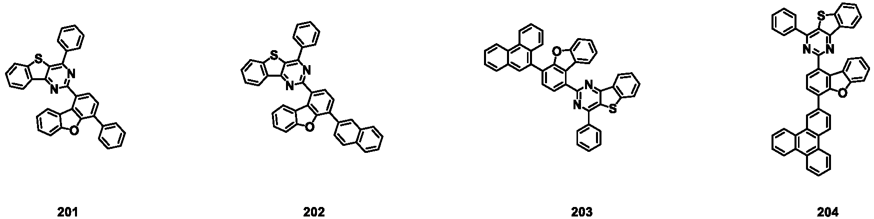

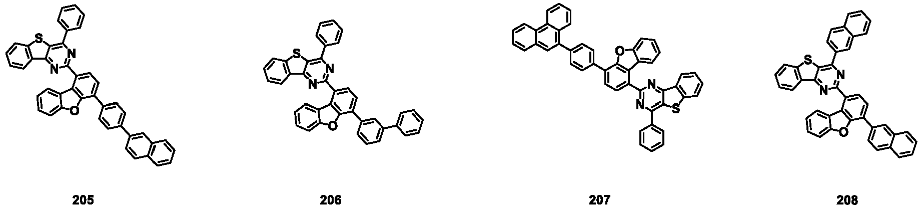

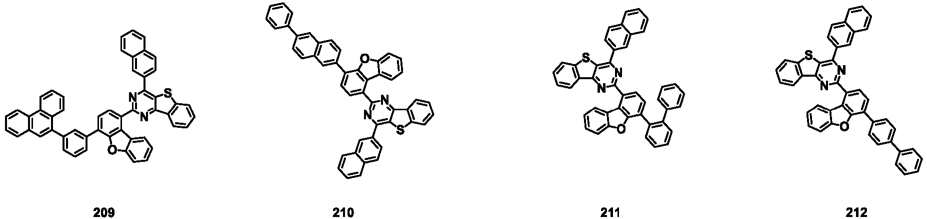

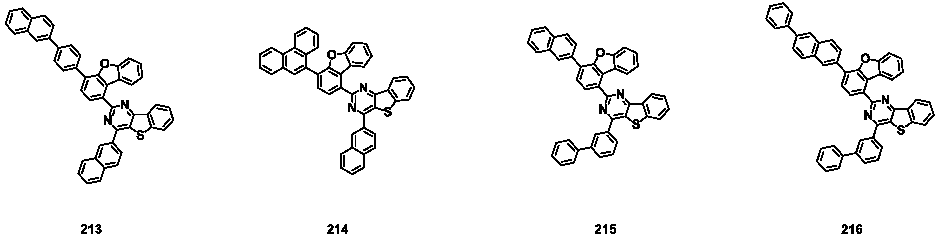

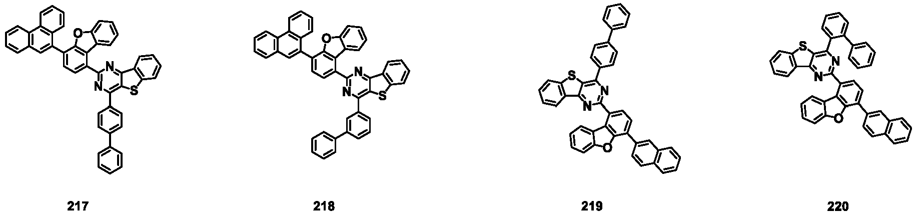

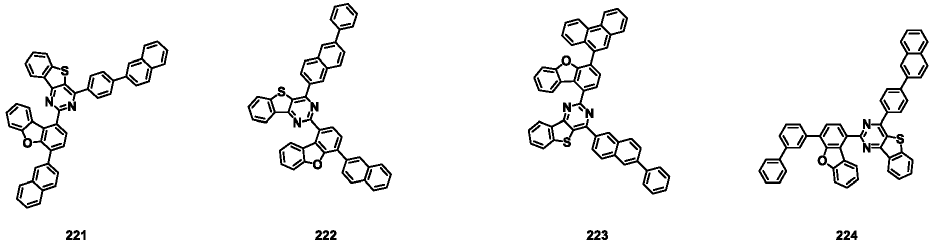

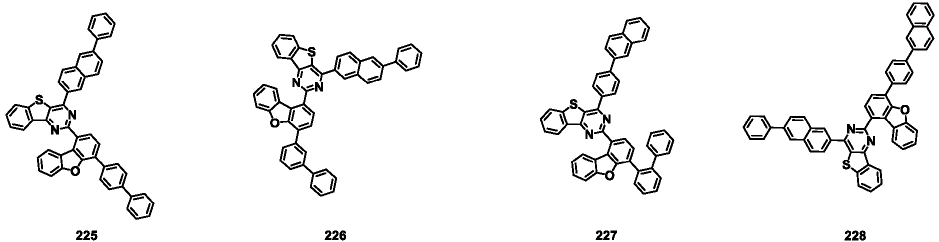

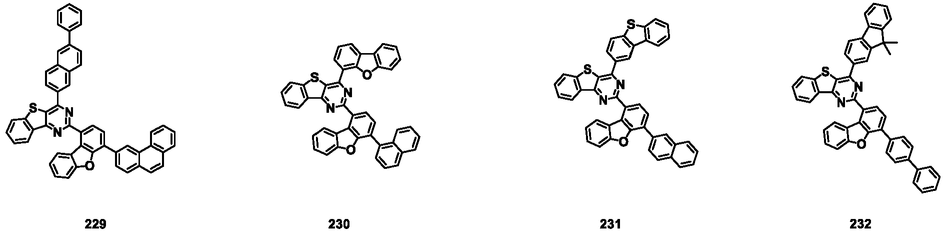

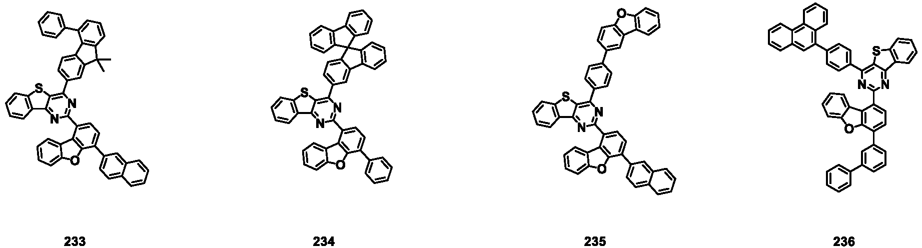

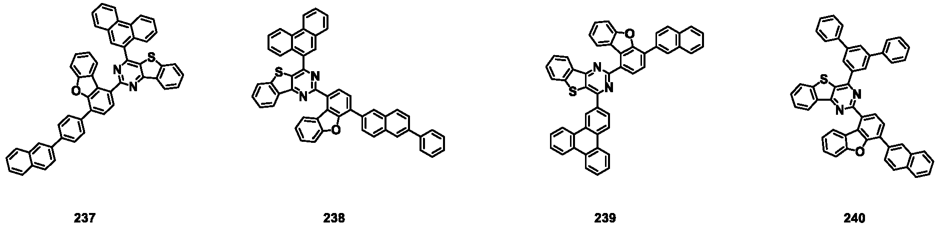

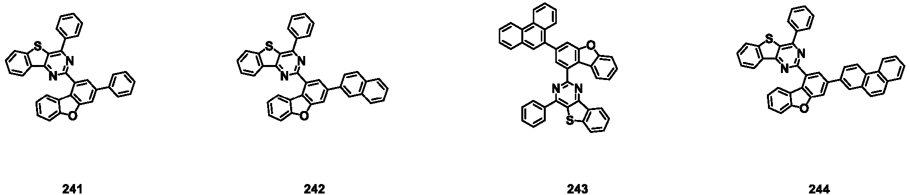

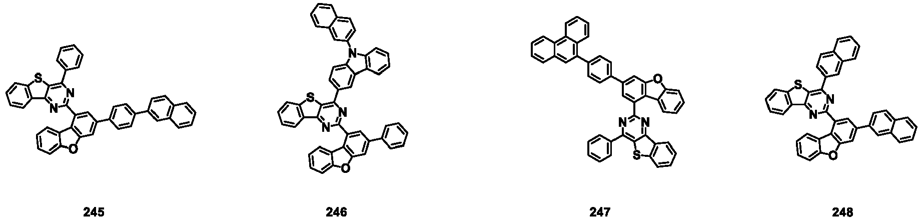

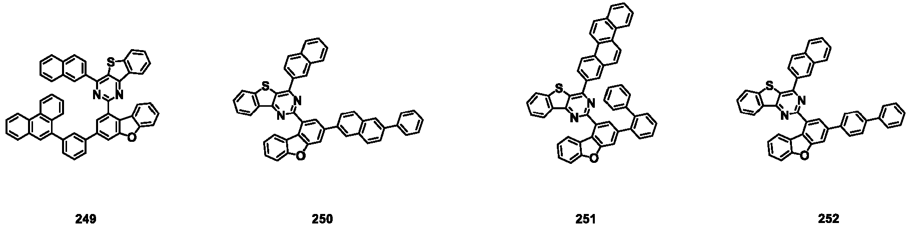

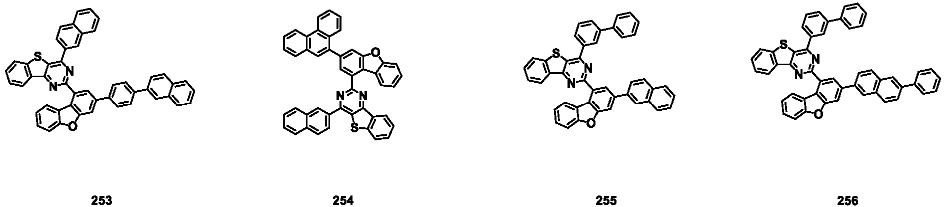

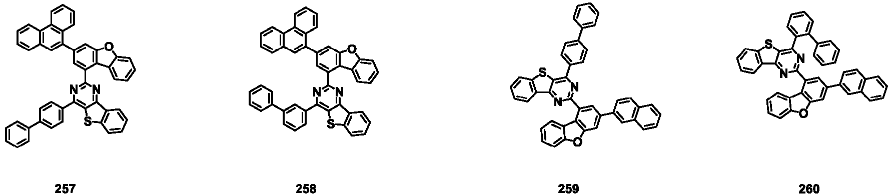

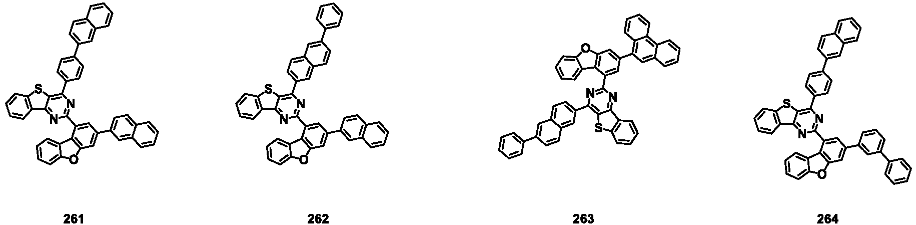

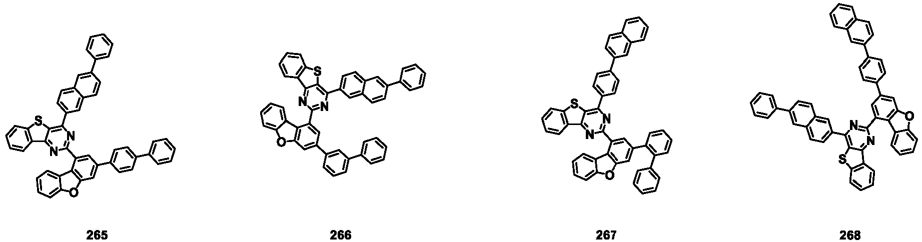

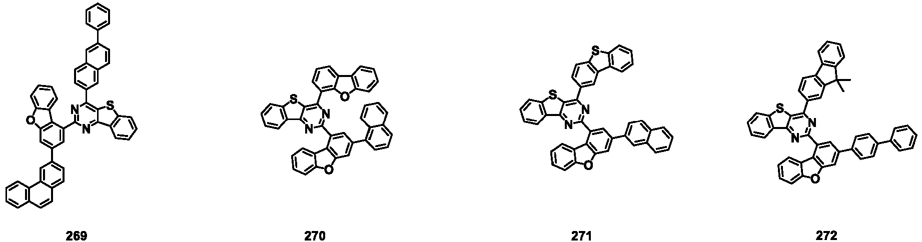

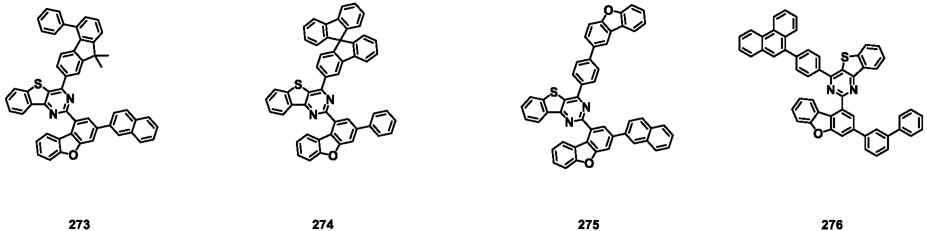

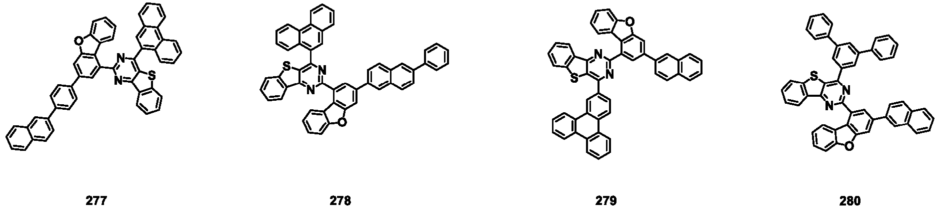

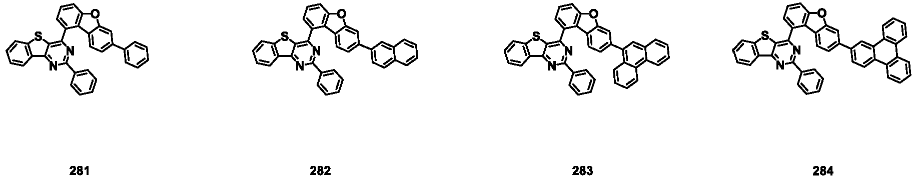

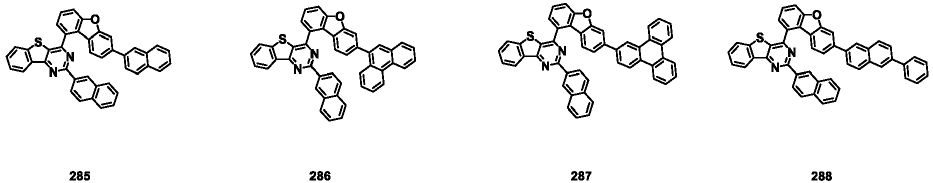

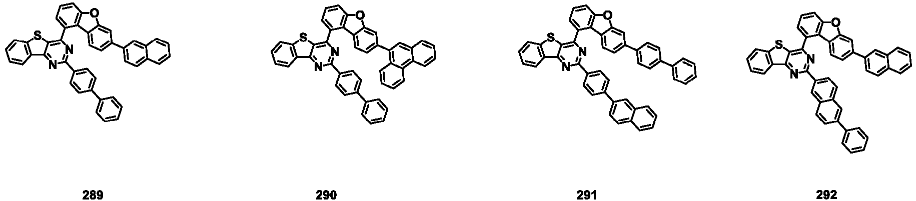

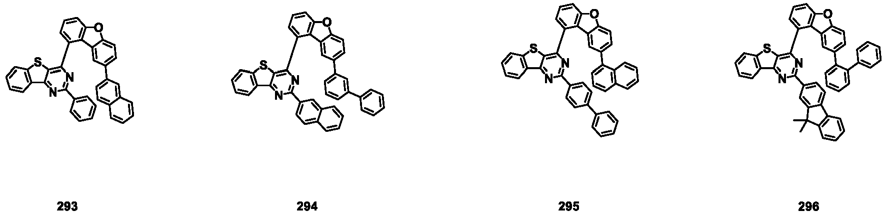

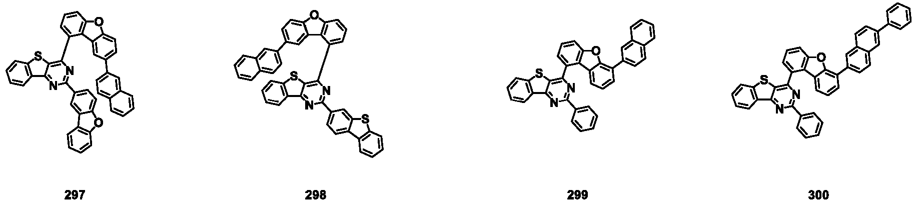

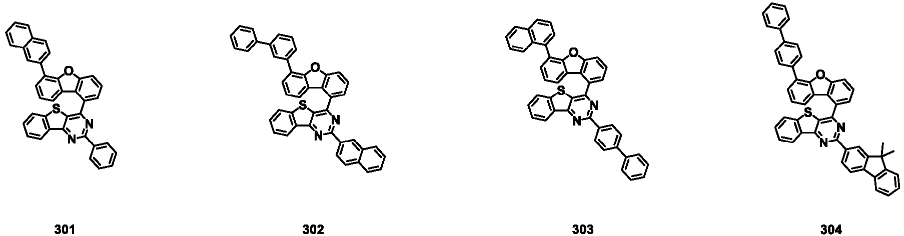

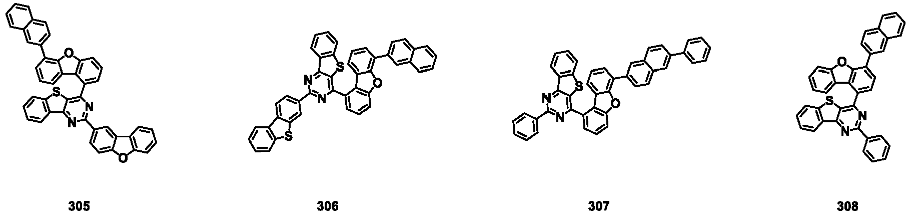

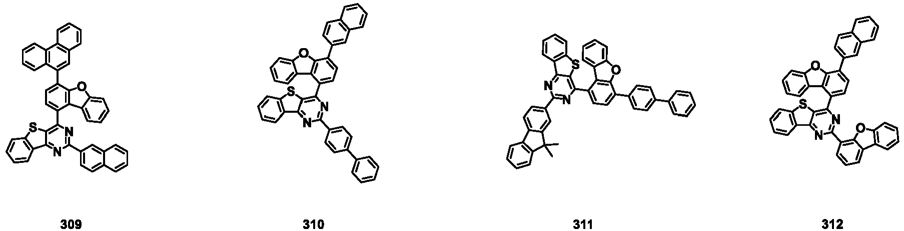

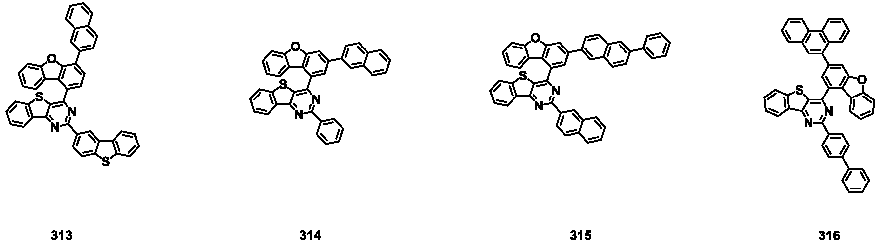

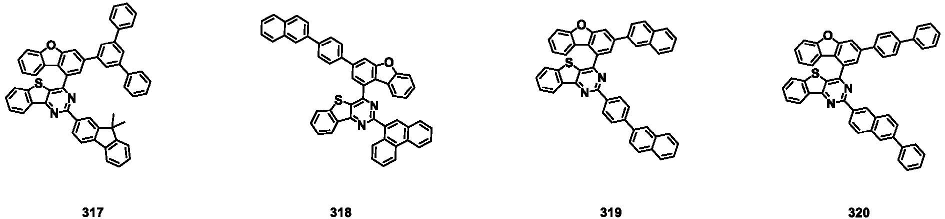

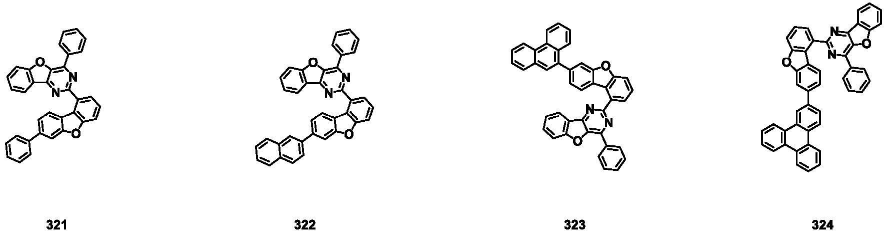

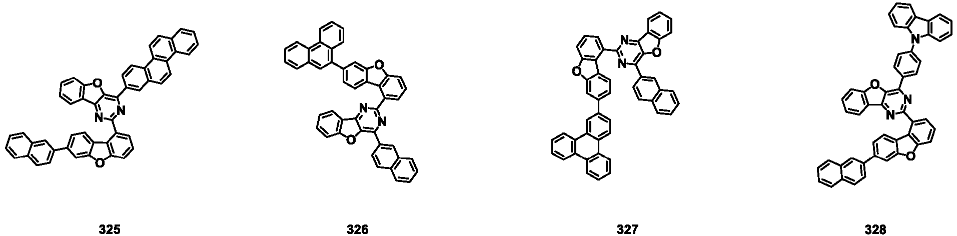

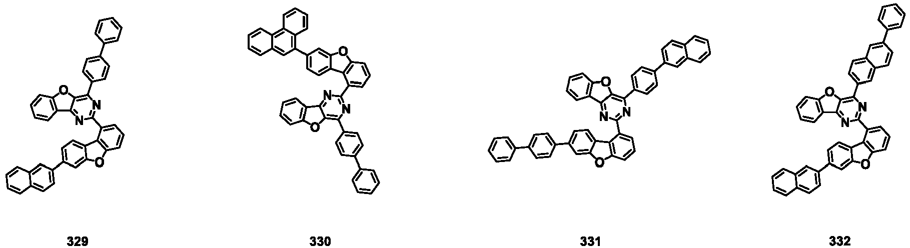

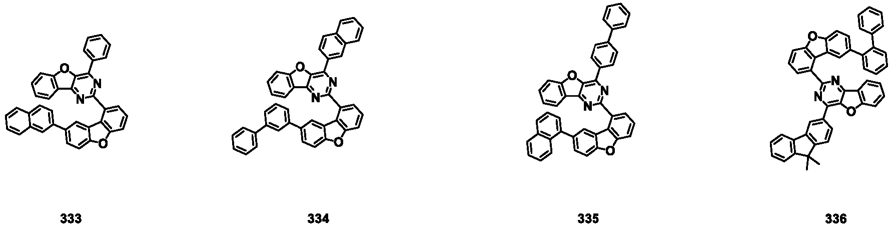

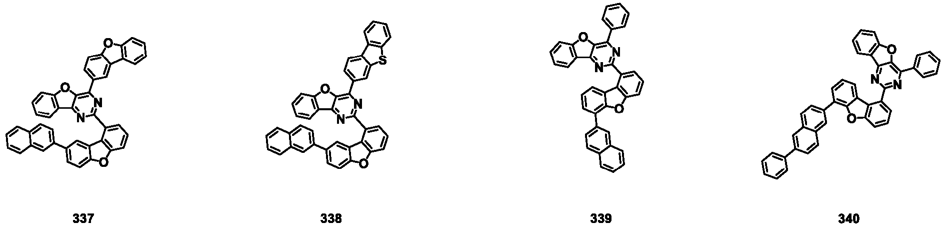

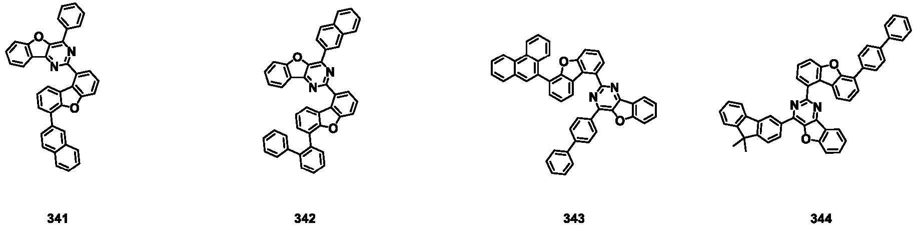

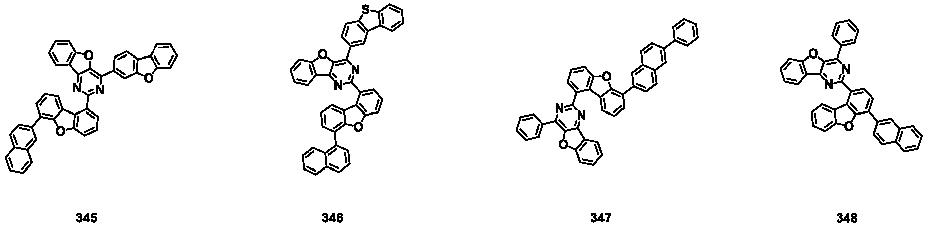

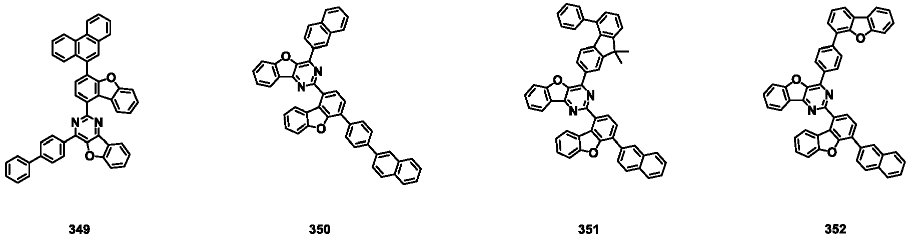

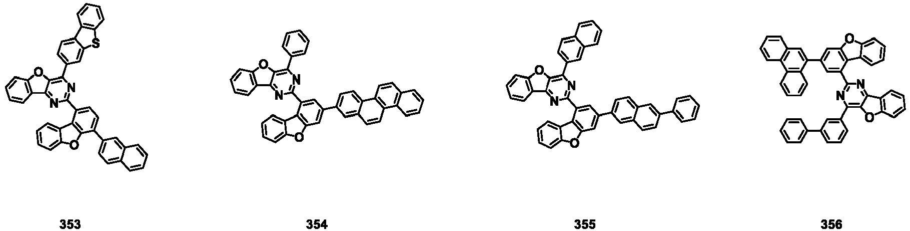

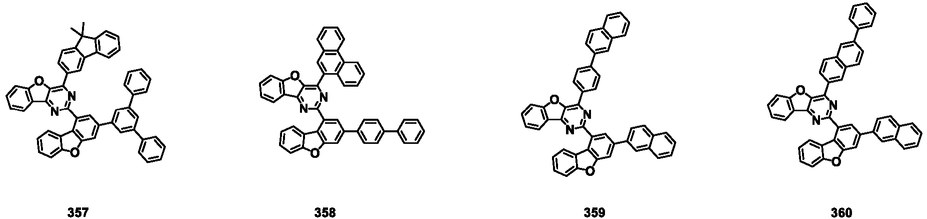

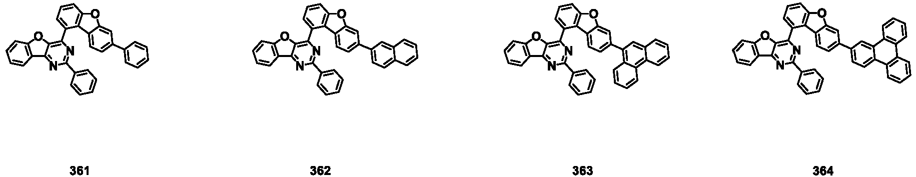

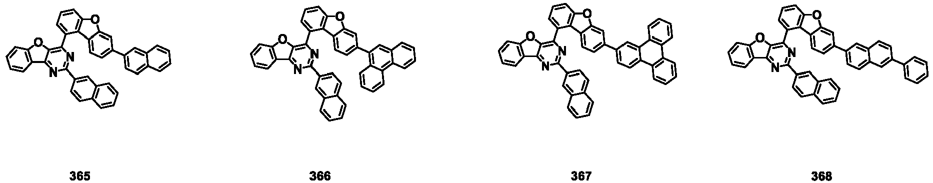

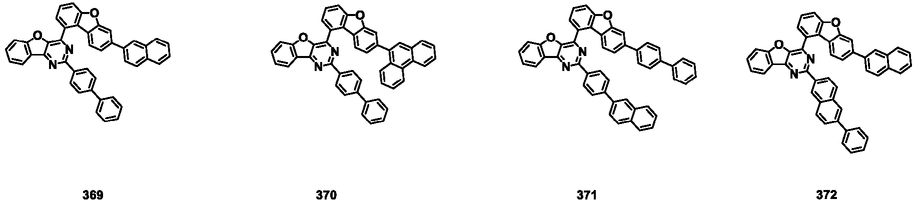

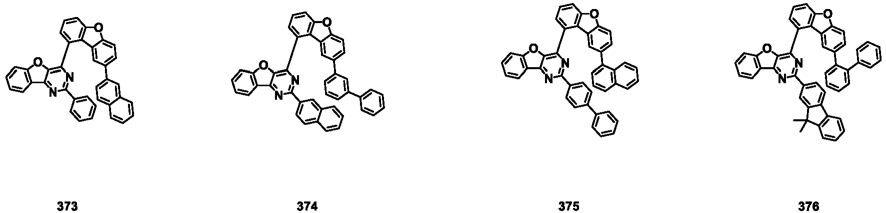

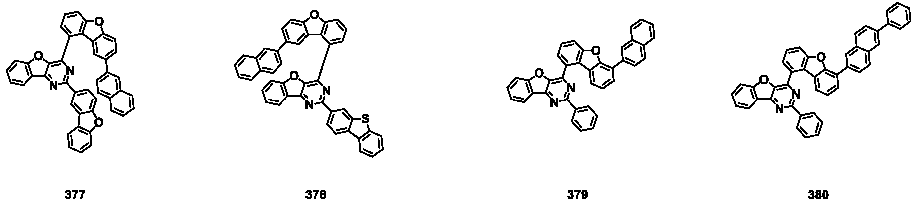

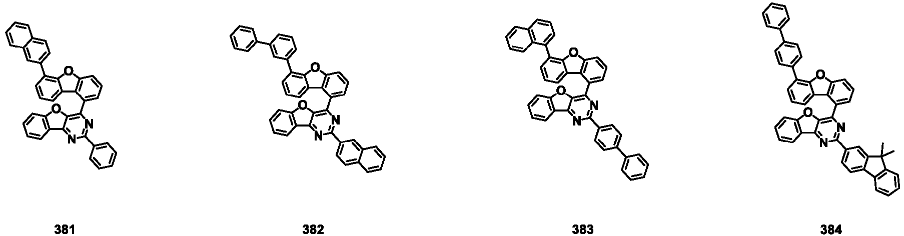

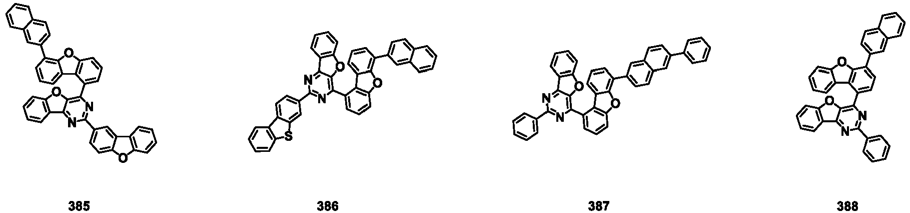

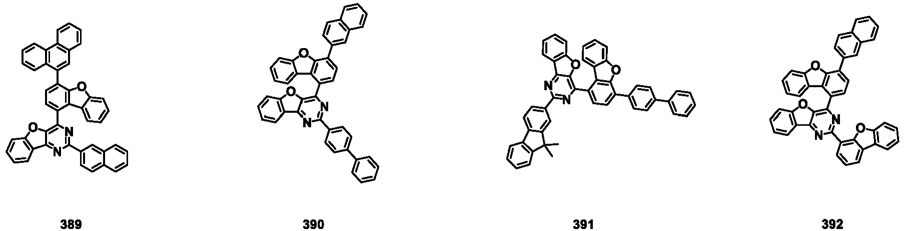

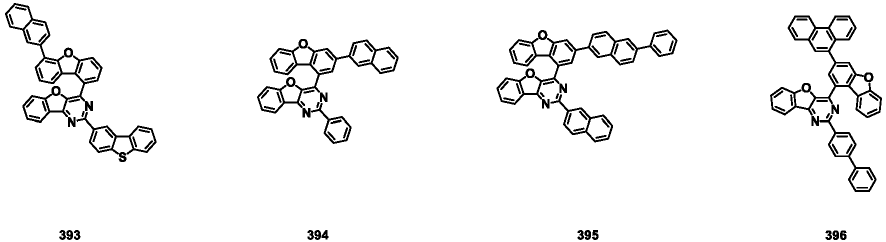

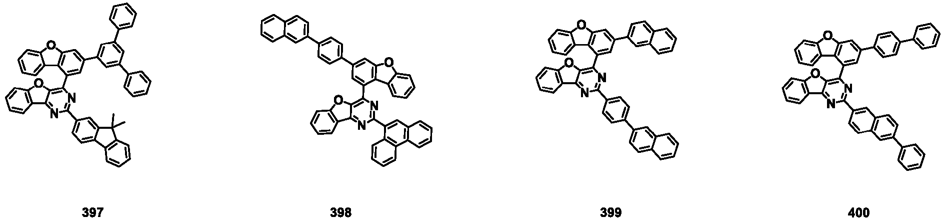

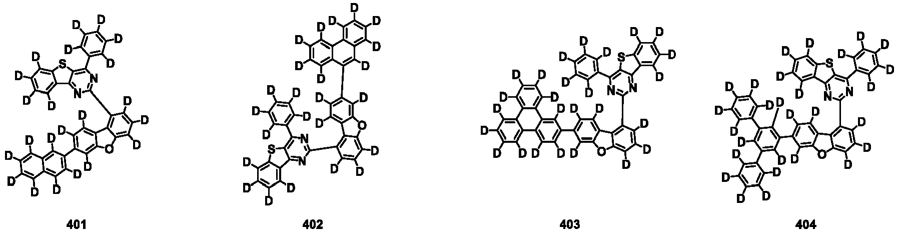

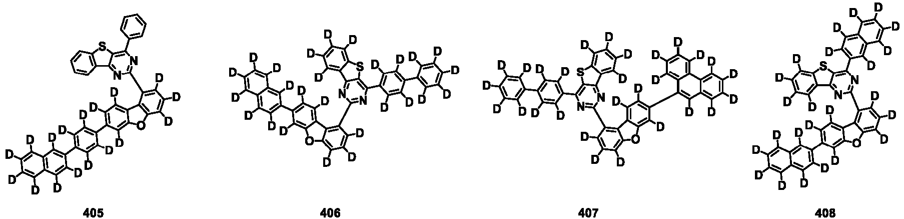

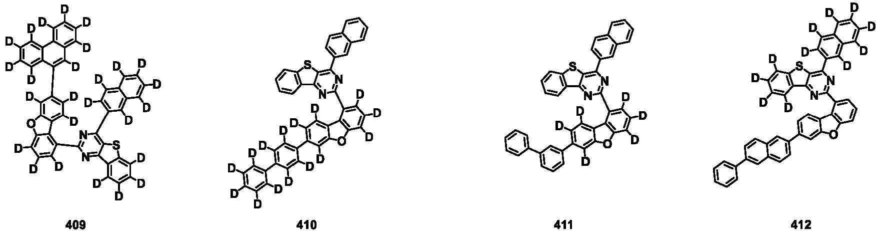

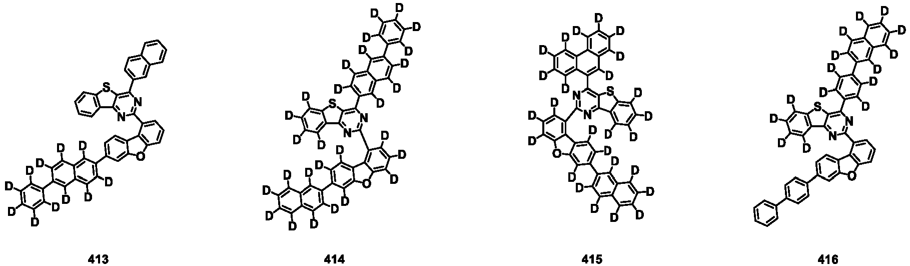

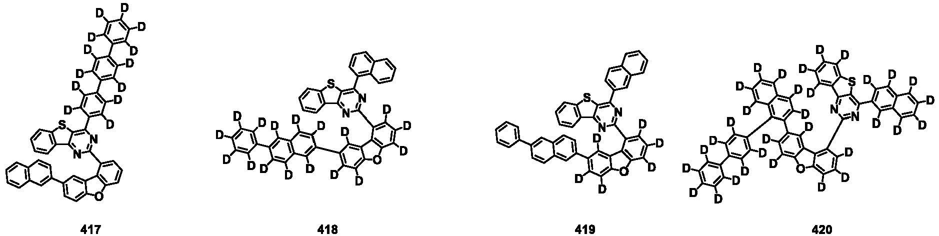

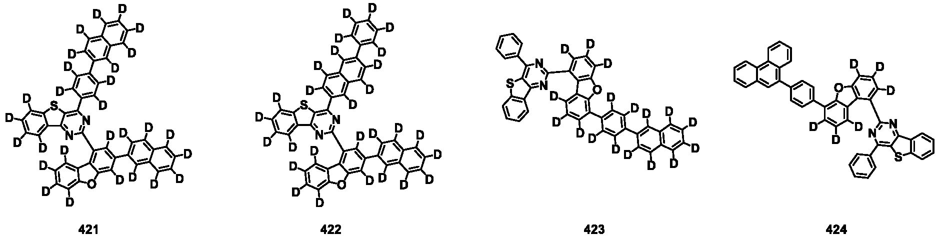

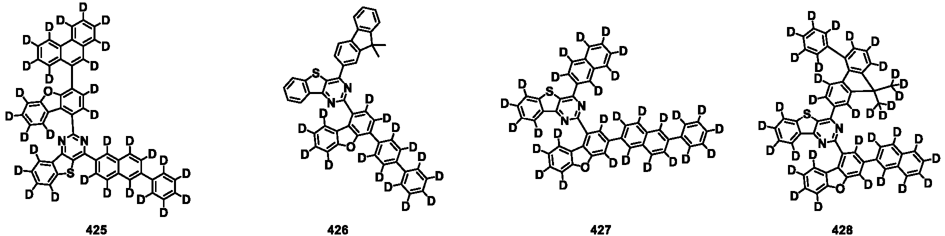

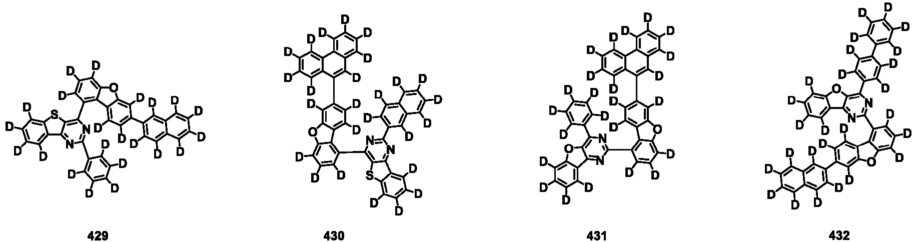

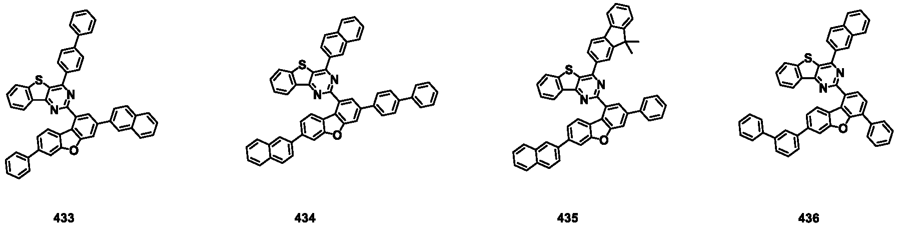

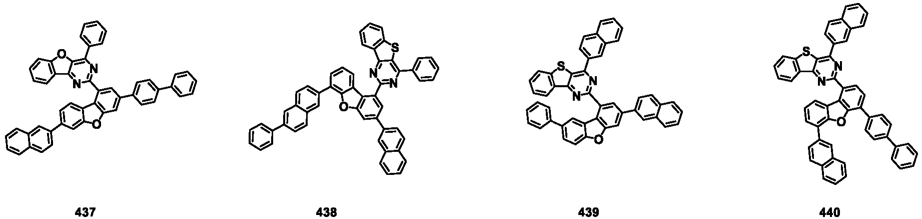

According to an exemplary embodiment of the present application, Chemical Formula 2 may be represented by any one of the following compounds, but is not limited thereto.

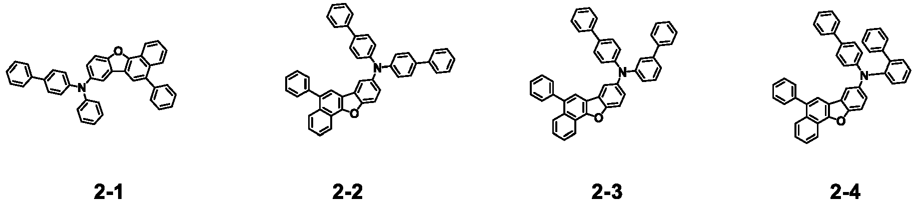

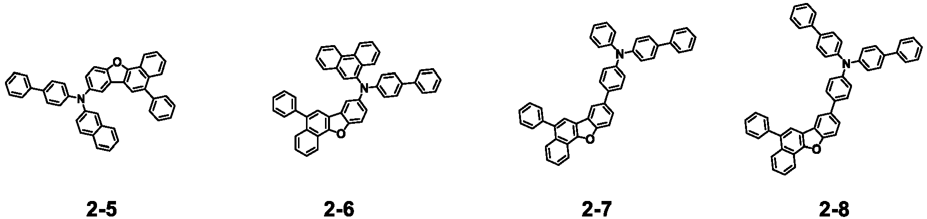

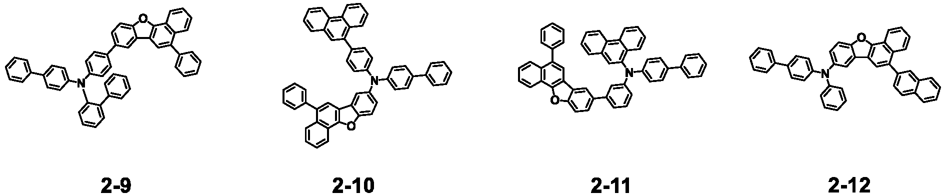

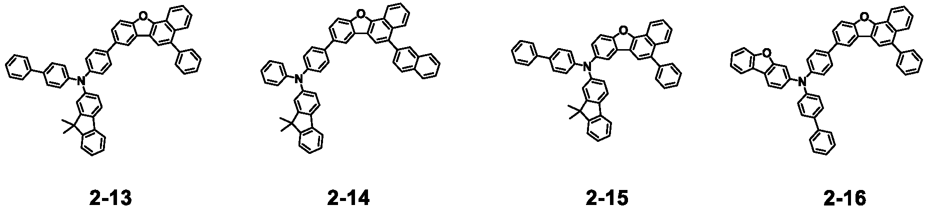

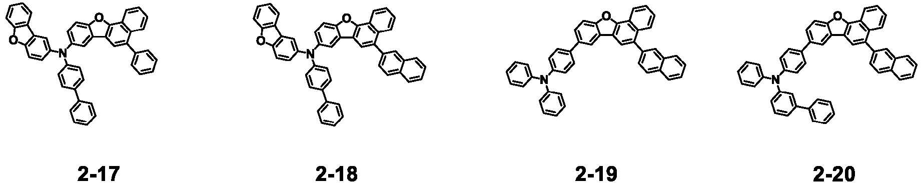

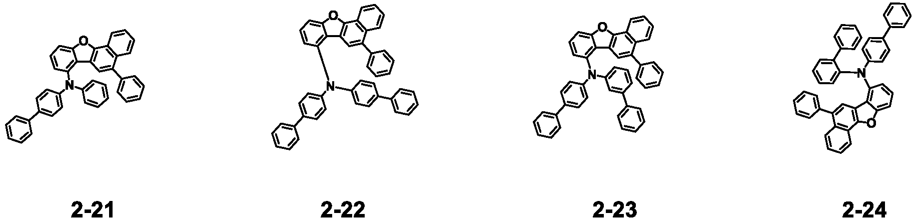

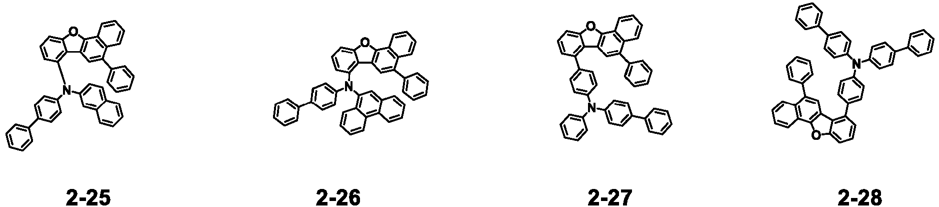

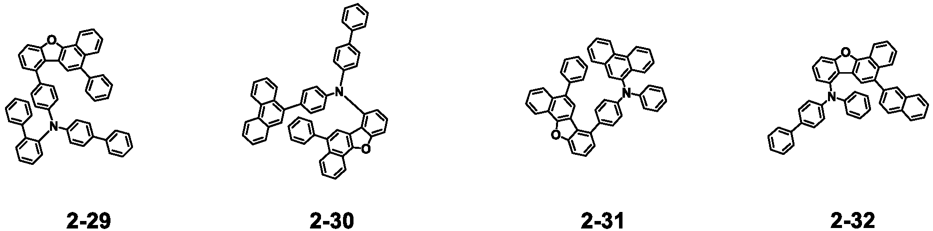

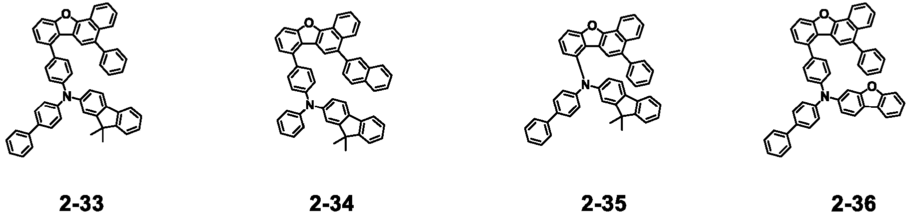

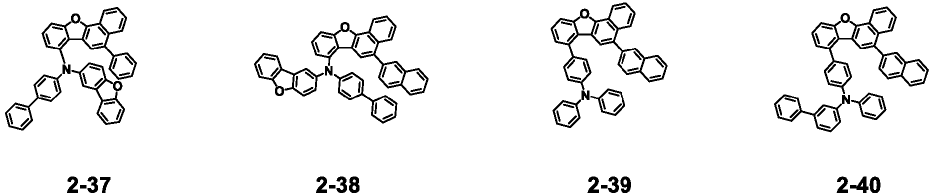

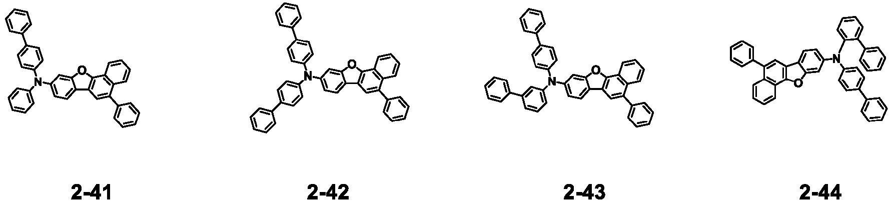

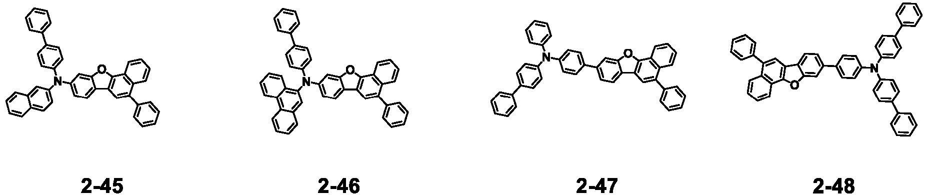

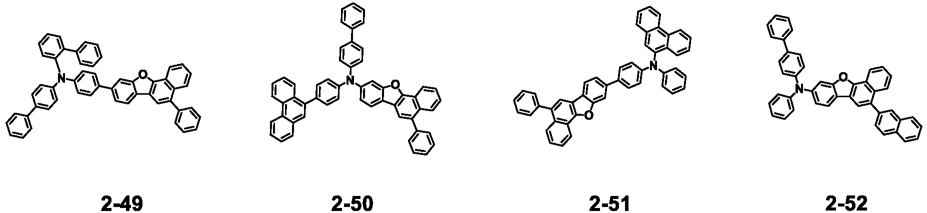

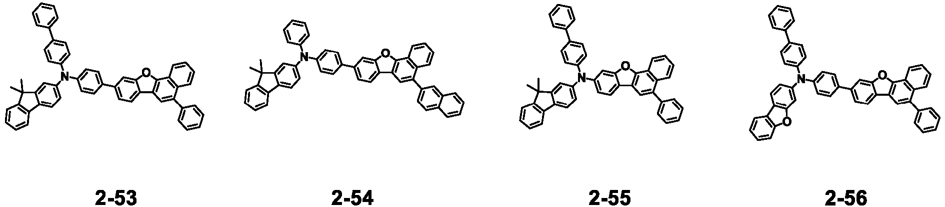

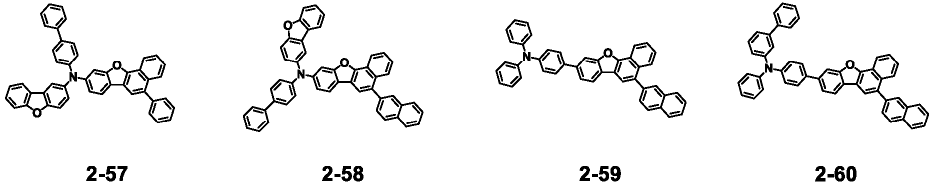

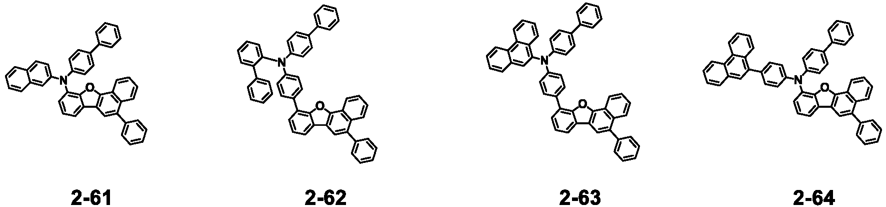

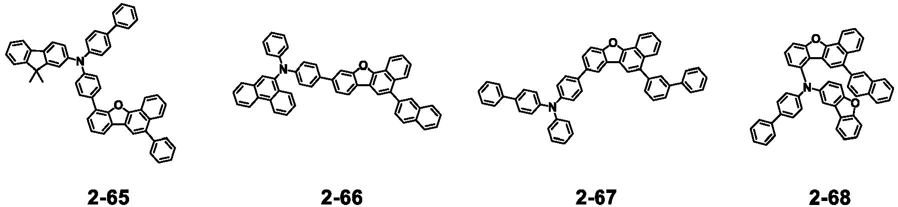

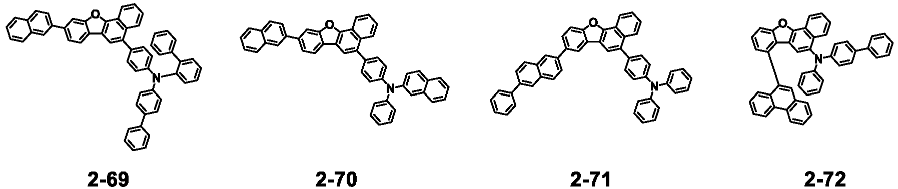

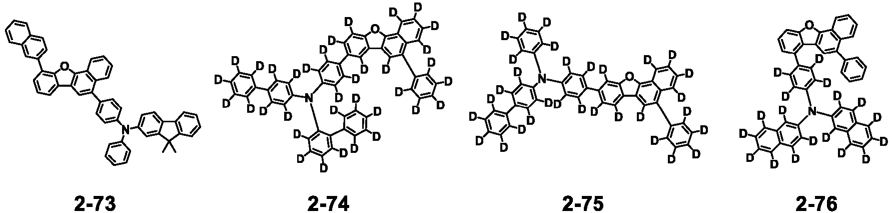

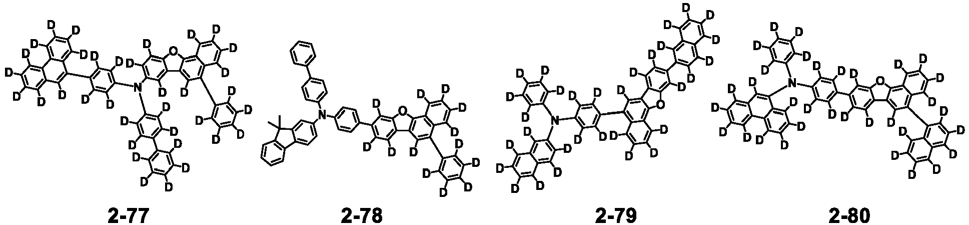

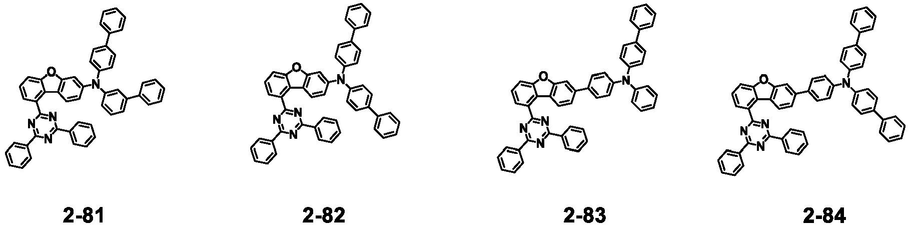

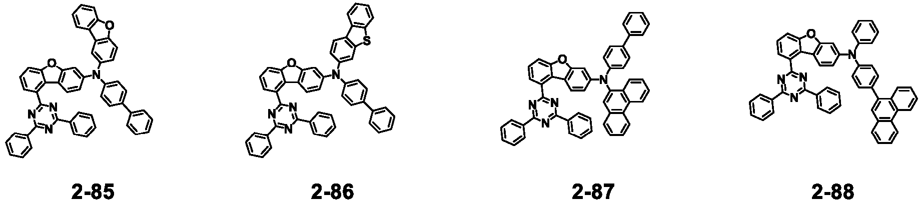

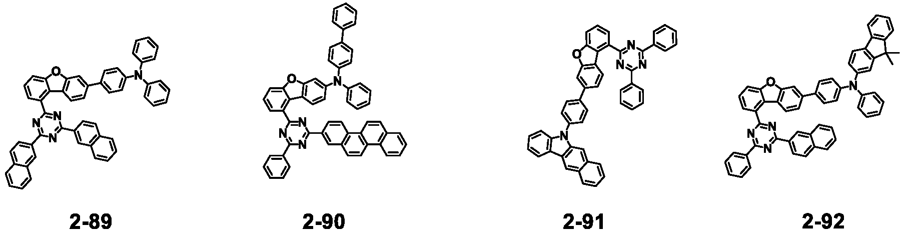

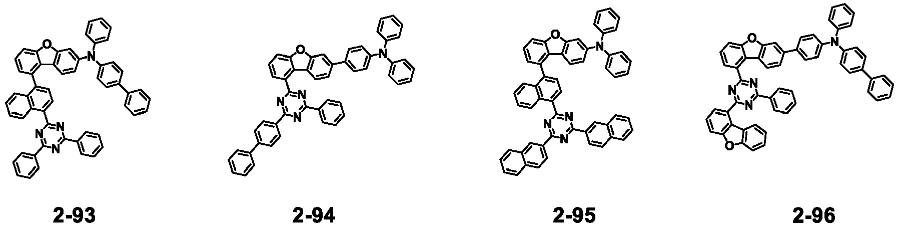

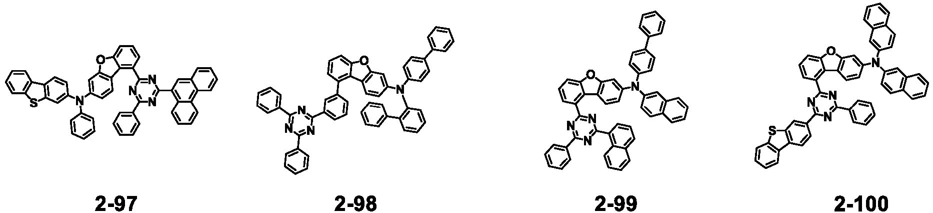

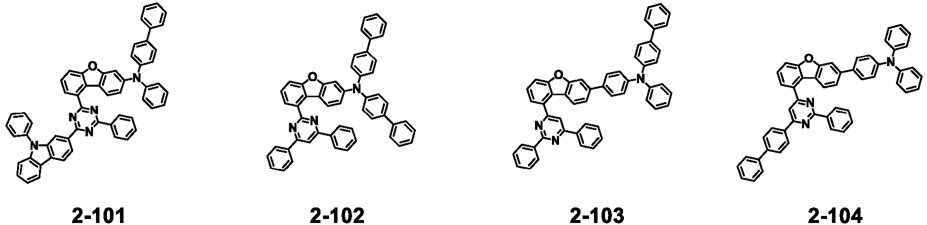

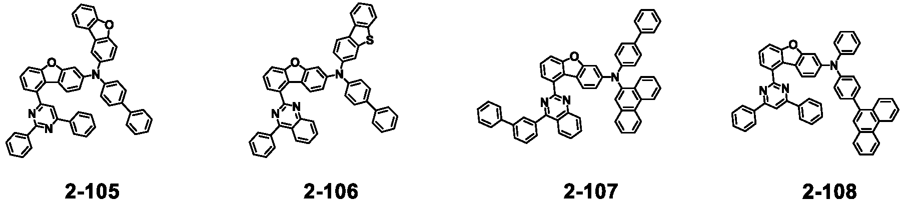

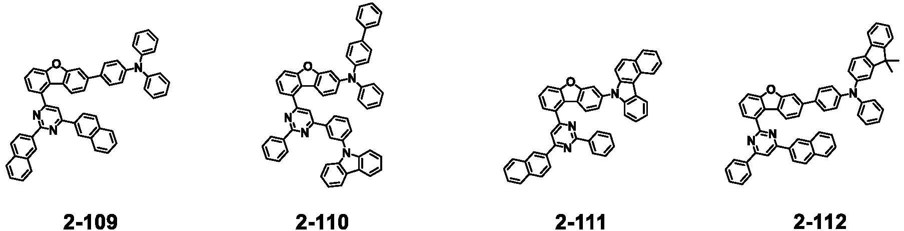

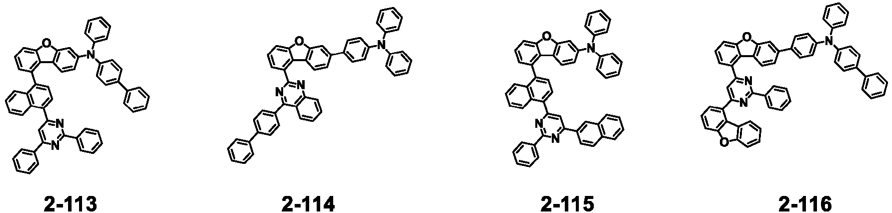

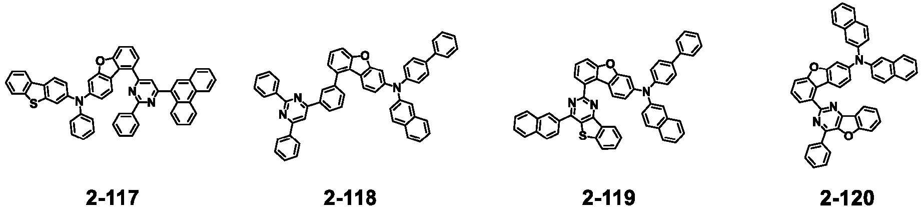

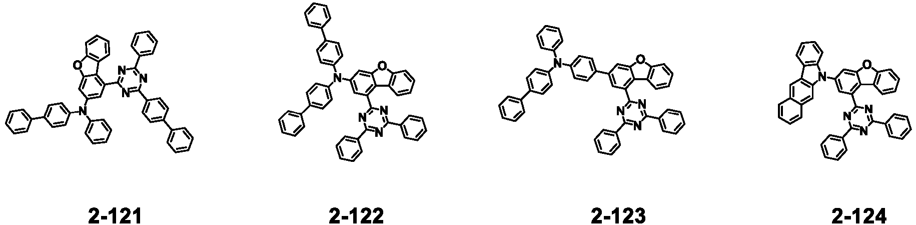

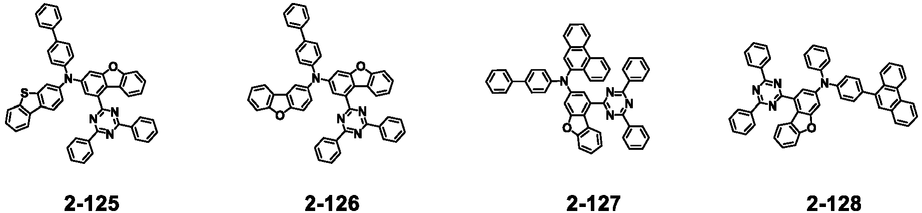

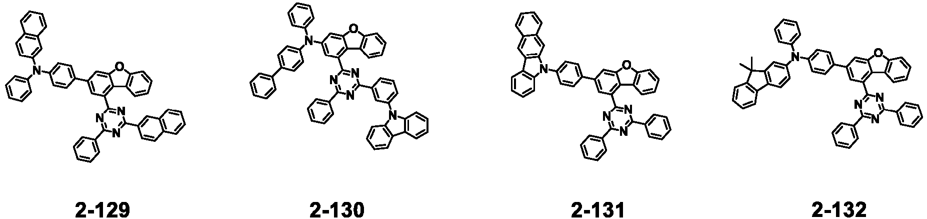

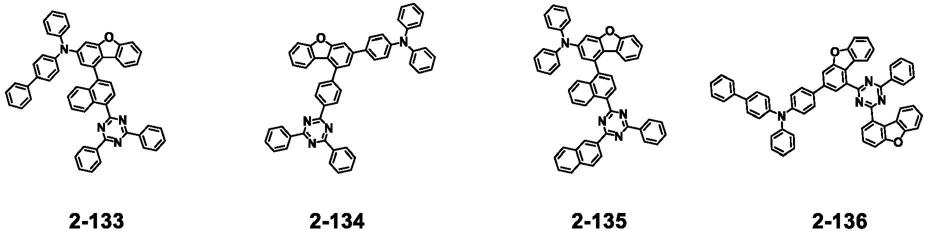

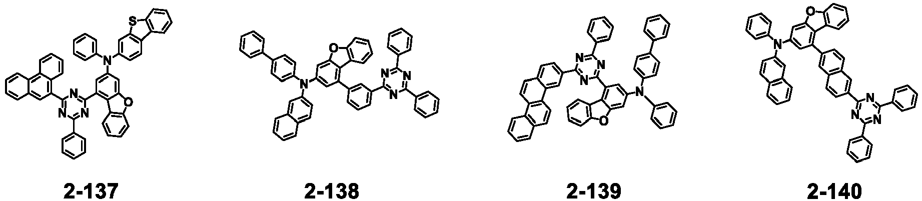

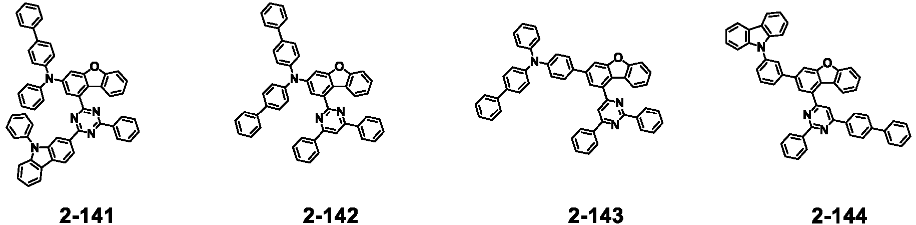

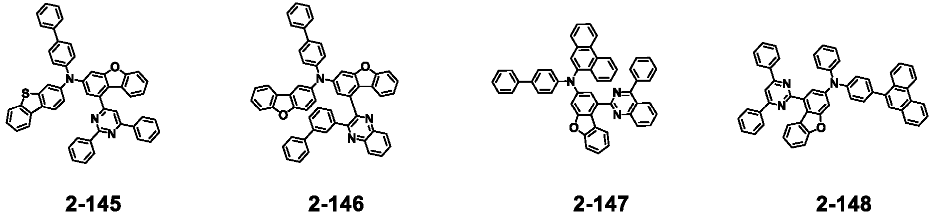

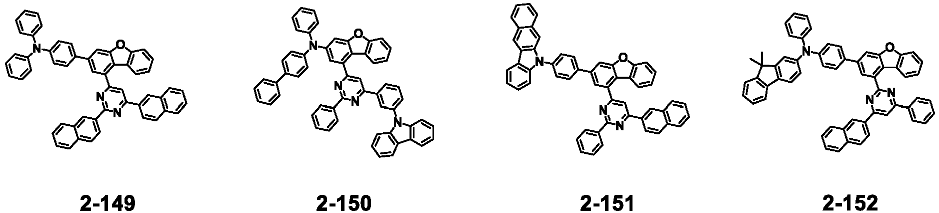

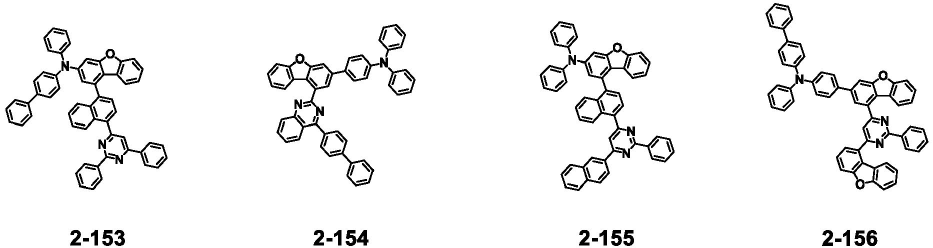

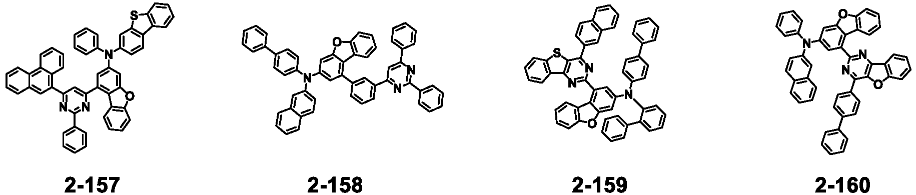

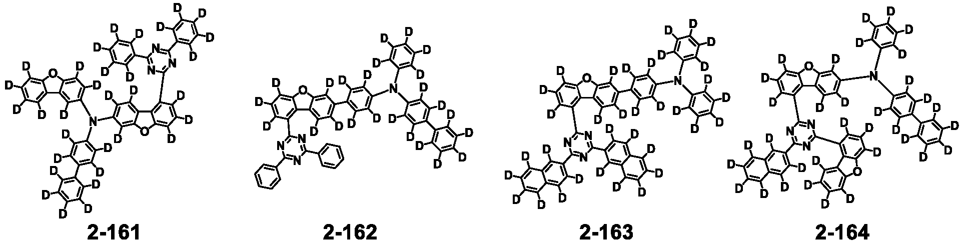

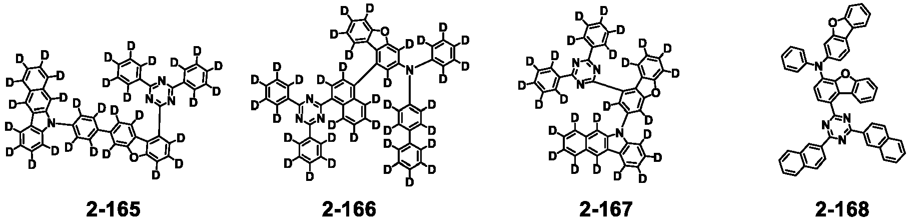

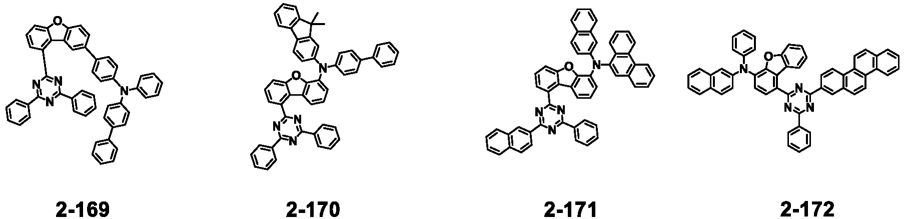

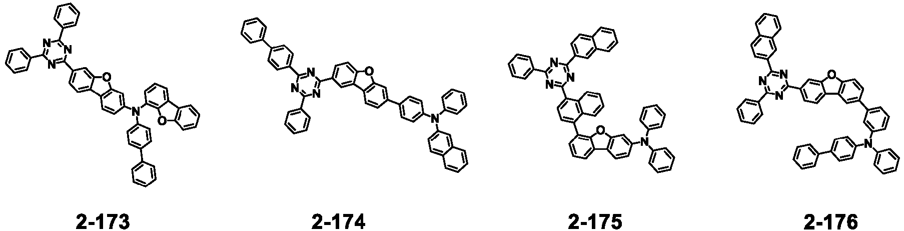

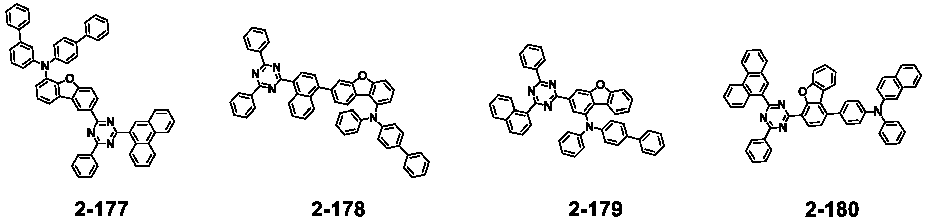

Further, it is possible to synthesize a compound having inherent characteristics of a substituent introduced by introducing various substituents into the structure of Chemical Formula 1 or Chemical Formula 2. For example, it is possible to synthesize a material which satisfies conditions required for each organic material layer by introducing a substituent usually used for a hole injection layer material, a material for transporting holes, a light emitting layer material, an electron transport layer material, and a charge generation layer material, which are used for preparing an organic light emitting device, into the core structure.

In addition, it is possible to finely adjust an energy band gap by introducing various substituents into the structure of Chemical Formula 1 or Chemical Formula 2, and meanwhile, it is possible to improve characteristics at the interface between organic materials and diversify the use of material.

Meanwhile, the heterocyclic compound has a high glass transition temperature (Tg) and thus has excellent thermal stability. The increase in thermal stability becomes an important factor for providing a device with driving stability.

The heterocyclic compound according to an exemplary embodiment of the present application may be prepared by a multi-step chemical reaction. Some intermediate compounds are first prepared, and the compound of Chemical Formula 1 or Chemical Formula 2 may be prepared from the intermediate compounds. More specifically, the heterocyclic compound according to an exemplary embodiment of the present application may be prepared based on Preparation Examples to be described below.

Another exemplary embodiment of the present application provides an organic light emitting device including the heterocyclic compounds represented by Chemical Formula 1 and Chemical Formula 2. The "organic light emitting device" may be expressed by terms such as "organic light emitting diode", "organic light emitting diodes (OLEDs)", "OLED device", and "organic electroluminescence device".

The heterocyclic compound may be formed as an organic material layer by not only a vacuum deposition method, but also a solution application method when an organic light emitting device is manufactured. Here, the solution application method means spin coating, dip coating, inkjet printing, screen printing, a spray method, roll coating, and the like, but is not limited thereto.

In the organic light emitting device of the present application, the organic material layer includes a light emitting layer, and the light emitting layer may include the heterocyclic compound represented by Chemical Formula 1 and the heterocyclic compound represented by Chemical Formula 2. In this case, the light emitting efficiency and service life of the organic light emitting device are further excellent.

In the organic light emitting device according to the present application, the organic material layer includes a light emitting layer, and the light emitting layer may include a host material.

In the organic light emitting device according to the present application, the host material may include two or more host materials, one of the two host material is an N-type host material, and the other may be a P-type host material.

In the organic light emitting device according to the present application, the host material may include two or more host materials, and each of the two or more host materials may include the heterocyclic compound represented by Chemical Formula 1 and the heterocyclic compound represented by Chemical Formula 2.

In the organic light emitting device of the present application, the heterocyclic compound represented by Chemical Formula 1 may be used as an N-type host.
In the organic light emitting device of the present application, the heterocyclic compound represented by Chemical Formula 2 may be used as a P-type host.

That is, in the organic light emitting device according to the present application, the host material may include two or more host materials, and among the two or more host materials, the heterocyclic compound represented by Chemical Formula 1 is an N-type host material, and the heterocyclic compound represented by Chemical Formula 2 may be a P-type host material.

In the organic light emitting device according to the present application, the host material may include two or more host materials, and the two or more host materials may be pre-mixed and used.

That is, the light emitting layer may be used by pre-mixing two or more host materials. The pre-mixing means that for the light emitting layer, before two or more host materials are deposited onto an organic material layer, the materials are first mixed and the mixture is contained in one common container and mixed.

Furthermore, another exemplary embodiment of the present application provides a composition for an organic material layer of an organic light emitting device, which includes both the heterocyclic compound represented by Chemical Formula 1 and the compound represented by Chemical Formula 2.

The specific contents on the hetero-cyclic compound represented by Chemical Formula 1 and the compound represented by Chemical Formula 2 are the same as those described above.

In another exemplary embodiment of the present application, the weight ratio of the heterocyclic compound represented by Chemical Formula 1 : the compound represented by Chemical Formula 2 in the composition may be 1 : 10 to 10 : 1, may be 1 : 8 to 8 : 1, may be 1 : 5 to 5 : 1, and may be 1 : 2 to 2 : 1, but is not limited thereto.

The composition may be used when an organic material for an organic light emitting device is formed, and particularly, may be more preferably used when a host of a light emitting layer is formed.

The composition is in a form in which two or more compounds are simply mixed, materials in a powder state may also be mixed before an organic material layer of an organic light emitting device is formed, and it is possible to mix compounds in a liquid state at a temperature which is equal to or more than a suitable temperature. The composition is in a solid state at a temperature which is equal to or less than the melting point of each material, and may be maintained as a liquid phase when the temperature is adjusted.

In an exemplary embodiment of the present application, provided is a method for manufacturing an organic light emitting device, the method including: preparing a substrate; forming a first electrode on the substrate; forming an organic material layer having one or more layers on the first electrode; and forming a second electrode on the organic material layer, in which the forming of the organic material layer includes forming the organic material layer having one or more layers by using the composition for an organic material layer according to an exemplary embodiment of the present application.

In an exemplary embodiment of the present application, provided is a method for manufacturing an organic light emitting device, in which the forming of the organic material layer forms the organic material layer by supplying the heterocyclic compound represented by Chemical Formula 1 and the compound represented by Chemical Formula 2 as each individual supply source, and then using a thermal vacuum deposition method.

In an exemplary embodiment of the present application, provided is a method for manufacturing an organic light emitting device, in which the forming of the organic material layer forms the organic material layer by pre-mixing the heterocyclic compound represented by Chemical Formula 1 and the compound represented by Chemical Formula 2, and using a thermal vacuum deposition method.

The organic light emitting device according to an exemplary embodiment of the present application may be manufactured by typical manufacturing methods and materials of the organic light emitting device, except that the above-described heterocyclic compound is used to form an organic material layer.

The organic light emitting device of the present invention may further include one or two or more layers selected from the group consisting of a light emitting layer, a hole injection layer, a hole transport layer, an electron blocking layer, an electron injection layer, an electron transport layer, a hole auxiliary layer, and a hole blocking layer.

FIGS. 1 to 3 exemplify the stacking sequence of the electrodes and the organic material layer of the organic light emitting device according to an exemplary embodiment of the present application. However, the scope of the present application is not intended to be limited by these drawings, and the structure of the organic light emitting device known in the art may also be applied to the present application.

According to FIG. 1, an organic light emitting device in which a positive electrode 200, an organic material layer 300, and a negative electrode 400 are sequentially stacked on a substrate 100 is illustrated. However, the organic light emitting device is not limited only to such a structure, and as in FIG. 2, an organic light emitting device in which a negative electrode, an organic material layer, and a positive electrode are sequentially stacked on a substrate may also be implemented.

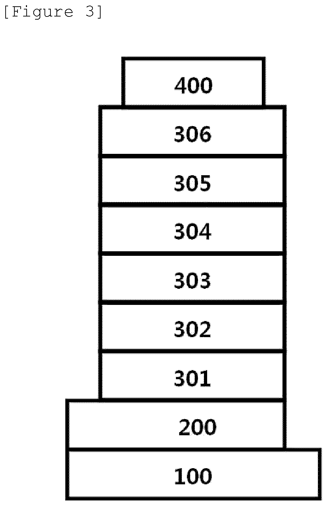

FIG. 3 exemplifies a case where an organic material layer is a multilayer. An organic light emitting device according to FIG. 3 includes a hole injection layer 301, a hole transport layer 302, a light emitting layer 303, a hole blocking layer 304, an electron transport layer 305, and an electron injection layer 306. However, the scope of the present application is not limited by the stacking structure as described above, and if necessary, the other layers except for the light emitting layer may be omitted, and another necessary functional layer may be further added.

In addition, the organic light emitting device according to an exemplary embodiment of the present application includes a first electrode, a first stack provided on the first electrode and including a first light emitting layer, a charge generation layer provided on the first stack, a second stack provided on the charge generation layer and including a second light emitting layer, and a second electrode provided on the second stack.

In an exemplary embodiment of the present application, the first light emitting layer and the second light emitting layer may include the heterocyclic compound represented by the chemical formula 1 and the heterocyclic compound represented by the chemical formula 2, respectively.

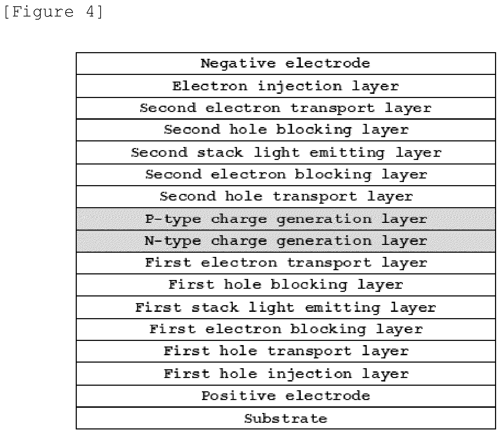

As the organic light emitting device according to an exemplary embodiment of the present application, an organic light emitting device having a 2-stack tandem structure is exemplarily illustrated in the following FIG. 4.

In this case, the first electron blocking layer, the first hole blocking layer, the second hole blocking layer, and the like described in the following FIG. 4 may be omitted depending on the case.

In an exemplary embodiment of the present application, the compound of Chemical Formula 1 may be doped with an alkali metal or an alkaline earth metal. In this case, due to the formation of the gap state, the driving voltage of the organic light emitting device may be lowered and the efficiency and service life may be further improved.

In an exemplary embodiment of the present application, provided is a composition including an alkali metal or an alkaline earth metal in the compound of Chemical Formula 1. The content of the alkali metal or alkaline earth metal of the composition may be 0.01 wt% to 30 wt%, preferably 0.01 wt% to 25 wt%, and more preferably 0.01 wt% to 20 wt%, based on the weight of the entire composition.

In an exemplary embodiment of the present application, the alkali metal or alkaline earth metal may be lithium (Li), rubidium (Rb), cesium (Cs) or magnesium (Mg). However, the alkali metal or alkaline earth metal is not limited thereto.

In the organic light emitting device according to an exemplary embodiment of the present application, materials other than the heterocyclic compound of Chemical Formula 1 and the heterocyclic compound of Chemical Formula 2 will be exemplified below, but these materials are provided only for exemplification and are not for limiting the scope of the present application, and may be replaced with materials publicly known in the art.

As a positive electrode material, materials having a relatively high work function may be used, and a transparent conductive oxide, a metal or a conductive polymer, and the like may be used. Specific examples of the positive electrode material include: a metal such as vanadium, chromium, copper, zinc, and gold, or an alloy thereof; a metal oxide such as zinc oxide, indium oxide, indium tin oxide (ITO), and indium zinc oxide (IZO); a combination of a metal and an oxide, such as ZnO : Al or SnO₂ : Sb; a conductive polymer such as poly(3-methylthiophene), poly[3,4-(ethylene-1,2-dioxy)thiophene] (PEDT), polypyrrole, and polyaniline; and the like, but are not limited thereto.

As a negative electrode material, materials having a relatively low work function may be used, and a metal, a metal oxide, or a conductive polymer, and the like may be used. Specific examples of the negative electrode material include: a metal such as magnesium, calcium, sodium, potassium, titanium, indium, yttrium, lithium, gadolinium, aluminum, silver, tin, and lead, or an alloy thereof; a multi-layer structured material, such as LiF/Al or LiO₂/Al; and the like, but are not limited thereto.

As a hole injection material, a publicly-known hole injection material may also be used, and it is possible to use, for example, a phthalocyanine compound such as copper phthalocyanine disclosed in US Patent No. 4,356,429 or starburst-type amine derivatives described in the document [Advanced Material, 6, p. 677 (1994)], for example, tris(4-carbazoyl-9-ylphenyl)amine (TCTA), 4,4',4"-tri[phenyl(m-tolyl)amino]triphenylamine (m-MTDATA), 1,3,5-tris[4-(3-methylphenylphenylamino)phenyl]benzene (m-MTDAPB), polyaniline/dodecylbenzenesulfonic acid or poly(3,4-ethylenedioxythiophene)/poly(4-styrenesulfonate), which is a soluble conductive polymer, polyaniline/camphor sulfonic acid or polyaniline/poly(4-styrene-sulfonate), and the like.

As a hole transport material, a pyrazoline derivative, an arylamine-based derivative, a stilbene derivative, a triphenyldiamine derivative, and the like may be used, and a low-molecular weight or polymer material may also be used.

As an electron transport material, it is possible to use an oxadiazole derivative, anthraquinodimethane and a derivative thereof, benzoquinone and a derivative thereof, naphthoquinone and a derivative thereof, anthraquinone and a derivative thereof, tetracyanoanthraquinodimethane and a derivative thereof, a fluorenone derivative, diphenyldicyanoethylene and a derivative thereof, a diphenoquinone derivative, a metal complex of 8-hydroxyquinoline and a derivative thereof, and the like, and a low-molecular weight material and a polymer material may also be used.

As an electron injection material, for example, LiF is representatively used in the art, but the present application is not limited thereto.

As a light emitting material, a red, green, or blue light emitting material may be used, and if necessary, two or more light emitting materials may be mixed and used. Further, a fluorescent material may also be used as the light emitting material, but may also be used as a phosphorescent material. As the light emitting material, it is also possible to use alone a material which emits light by combining holes and electrons each injected from a positive electrode and a negative electrode, but materials in which a host material and a dopant material are involved in light emission together may also be used.

The organic light emitting device according to an exemplary embodiment of the present application may be a top emission type, a bottom emission type, or a dual emission type according to the material to be used.

The heterocyclic compound according to an exemplary embodiment of the present application may act even in organic electronic devices including organic solar cells, organic photoconductors, organic transistors, and the like, based on the principle similar to those applied to organic light emitting devices.

Hereinafter, the present specification will be described in more detail through Examples, but these Examples are provided only for exemplifying the present application, and are not intended to limit the scope of the present application.

### <Preparation Examples>

### <Preparation Example 1> Preparation of Compound 1

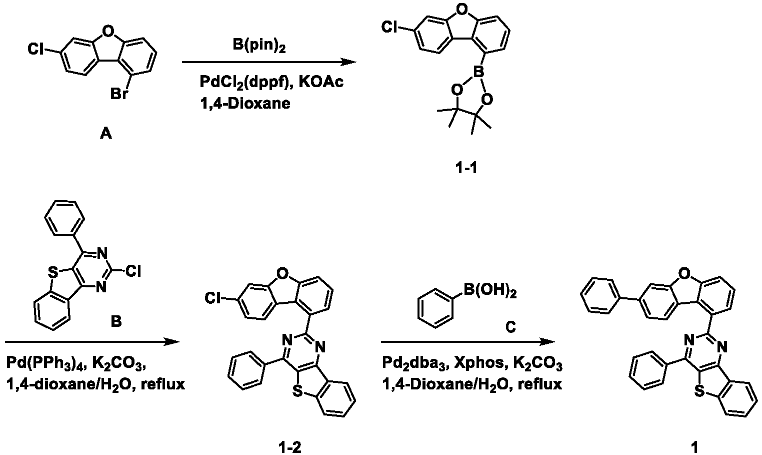

### 1) Preparation of Compound 1-1

After 10.0 g (35.5 mmol) of 1-bromo-7-chlorodibenzo[b,d]furan) (A) , 13.5 g (53.3 mmol) of 4,4,4',4',5,5,5',5'-octamethyl-2,2'-bi(1,3,2-dioxaborolane), 1.3 g (1.8 mmol) of PdCl₂(dppf), and 10.5 g (106.5 mmol) of KOAc were dissolved in 100 mL of 1,4-dioxane, the resulting solution was refluxed at 130°C for 3 hours. After the reaction was completed, the resulting product was filtered under reduced pressure at room temperature, and then the solvent was removed from the filtrate using a rotary evaporator. The reaction product was purified by column chromatography (DCM : Hex = 1 : 3) to obtain 9.8 g (81.4%) of Compound 1-1.

Here, DCM and Hex mean dichloromethane (hereinafter referred to as DCM) and hexane (hereinafter referred to as Hex), respectively. Furthermore, dichloromethane is also referred to as methylene chloride, and is also hereinafter referred to as MC.

### 2) Preparation of Compound 1-2

After 9.8 g (28.9 mmol) of Compound 1-1, 8.58 g (28.9 mmol) of 2-chloro-4-phenylbenzo[4,5]thieno[3,2-d]pyrimidine (B), 1.7 g (1.5 mmol) of Pd(PPh₃)₄, and 11.4 g (82.2 mmol) of K₂CO₃ were dissolved in 100 mL/20 mL of 1,4-dioxane/H₂O, the resulting solution was refluxed at 120°C for 5 hours. After the reaction was completed, extraction was performed using DCM and distilled water at room temperature. Water was removed by adding MgSO₄ to the organic layer. Thereafter, the organic layer was concentrated, then dissolved in DCM and purified with silica. After silica purification, DCM/MeOH recrystallization was performed to obtain 12.8 g (95%) of Compound 1-2.

Here, MeOH means methanol.

### 3) Preparation of Compound 1

After 12.8 g (27.7 mmol) of Compound 1-2, 3.74 g (27.7 mmol) of phenylboronic acid (C), 1.1 g (1.2 mmol of Pd₂dba₃, 1.2 g (2.3 mmol) of Xphos, and 9.6 g (69.2 mmol) of K₂CO₃ were dissolved in 120 mL/25 mL of 1,4-dioxane/H₂O, the resulting solution was refluxed at 120°C for 4 hours. After the reaction was completed, the resulting product was filtered under reduced pressure at room temperature. Thereafter, after the residue was dissolved in dichlorobenzene (hereinafter, referred to as DCB) and purified by silica chromatography, recrystallization was performed using DCB, and then 11.5 g (82%) of Compound 1 was obtained.

A target compound corresponding to Compound No. of the following Table 1 was synthesized by performing synthesis in the same manner as in Preparation Example 1, except that Intermediate A of the following Table 1 was used instead of 1-bromo-7-chlorodibenzo[b,d]furan (A) in Preparation Example 1, Intermediate B of the following Table 1 was used instead of 2-chloro-4-phenylbenzo[4,5]thieno[3,2-d]pyrimidine (B) in Preparation Example 1, and Intermediate C of the following Table 1 was used instead of phenylboronic acid (C) in Preparation Example 1.

**[Table 1]**

| Compoun d No. | Intermediate A | Intermediate B | Intermediate C | Yield |
|---|---|---|---|---|
| 2 | 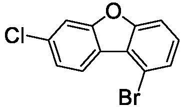 | 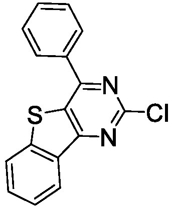 | 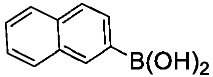 | 83% |
| 3 | | | 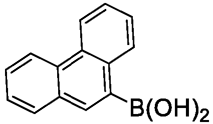 | 82% |
| 4 | | | 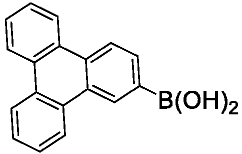 | 79$ |
| 22 | 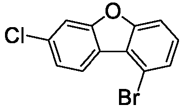 | 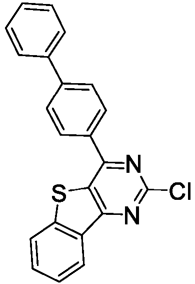 | 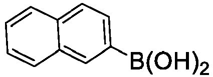 | 85% |
| 23 | | | 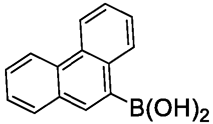 | 80% |
| 24 | | | 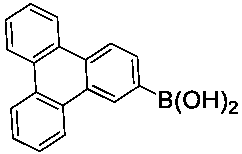 | 74% |
| 34 | | | 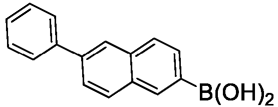 | 76% |
| 42 | 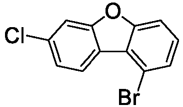 | 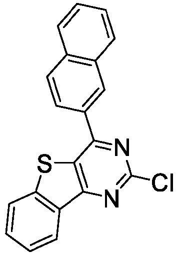 | 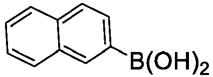 | 82% |
| 43 | | | 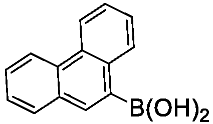 | 84% |
| 44 | | | 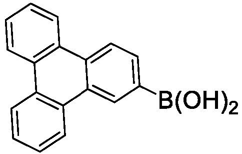 | 78% |
| 45 | | | 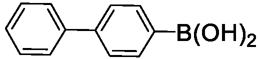 | 83% |
| 49 | | | 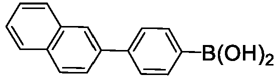 | 81% |
| 57 | 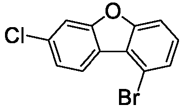 | 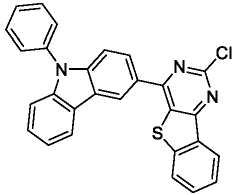 | 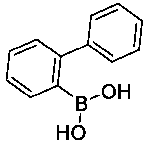 | 68% |
| 67 | 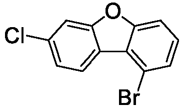 | 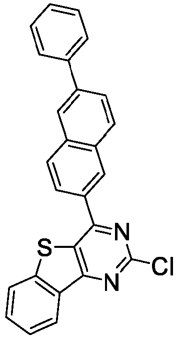 | 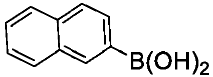 | 82% |
| 69 | 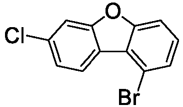 | 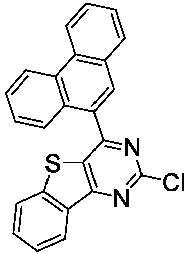 | 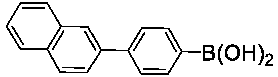 | 81% |
| 71 | 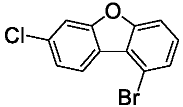 | 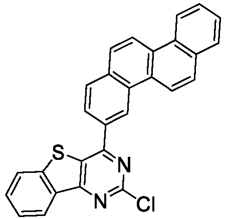 | 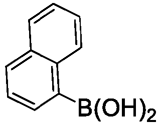 | 71% |
| 74 | 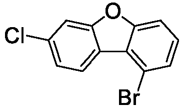 | 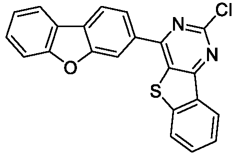 | 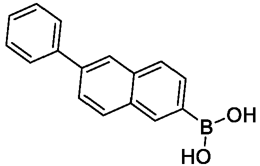 | 76% |
| 92 | 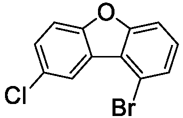 | 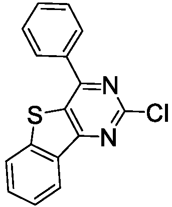 | 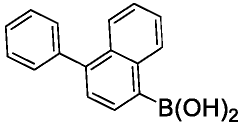 | 83% |
| 122 | | 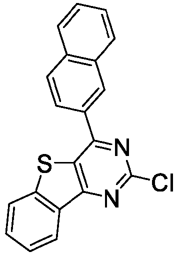 | 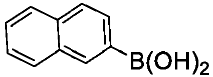 | 82% |
| 160 | | 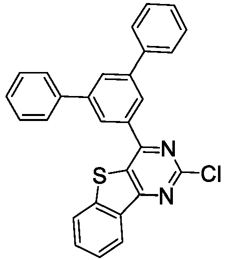 | 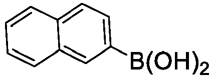 | 86% |
| 179 | 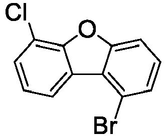 | 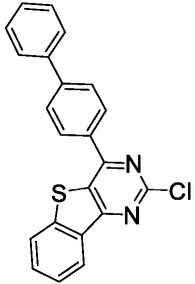 | 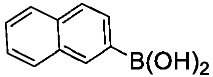 | 84% |
| 213 | 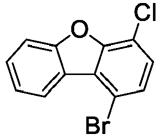 | 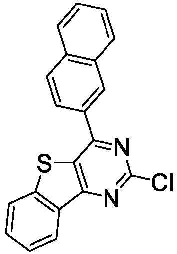 | 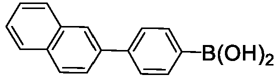 | 83% |
| 233 | | 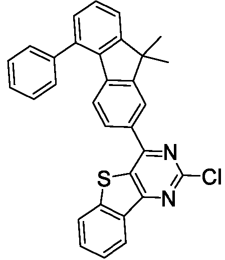 | 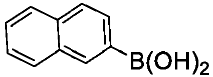 | 81% |
| 263 | 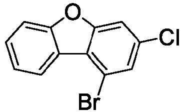 | 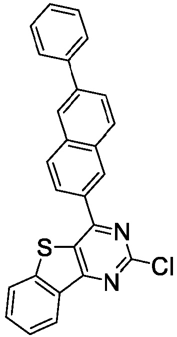 | 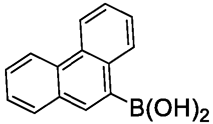 | 81% |
| 322 | 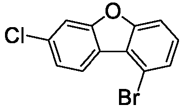 | 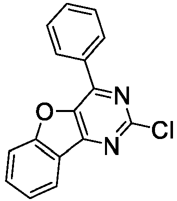 | 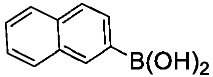 | 83% |
| 325 | | 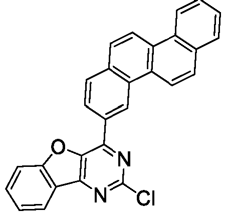 | 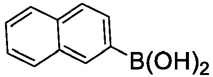 | 71% |
| 332 | | 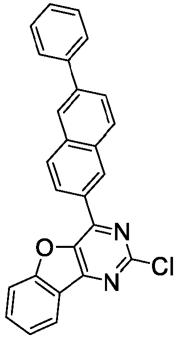 | 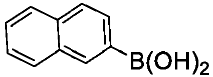 | 79$ |
| 358 | 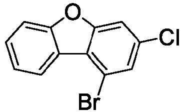 | 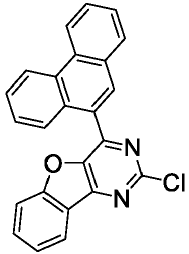 | 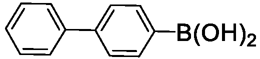 | 82% |
| 413 | 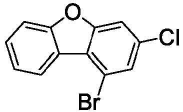 | 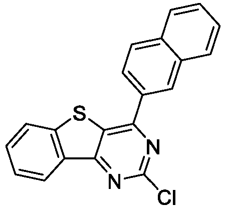 | 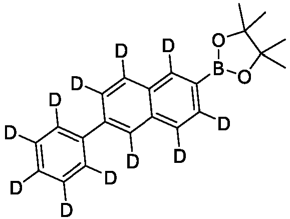 | 69% |
| 418 | 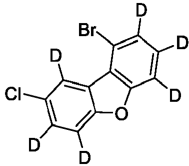 | 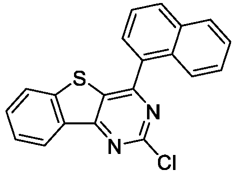 | 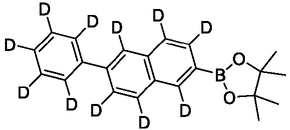 | 73% |

### <Preparation Example 2> Preparation of Compound 282

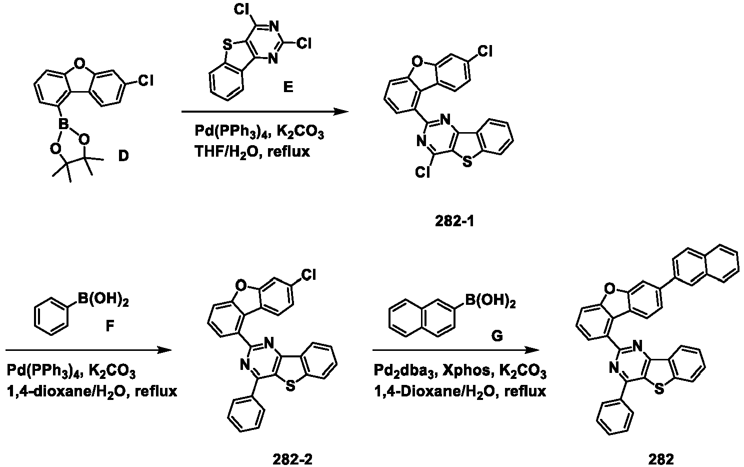

### 1) Preparation of Compound 282-1

After 30 g (91.3 mmol) of 2-(7-chlorodibenzo[b,d]furan-1-yl)-4,4,5,5-tetramethyl-1,3,2-dioxaborolane (D), 23.3 g (91.3 mmol) of 2,4-dichlorobenzo[4,5]thieno[3,2-d]pyrimidine (E), 5.27 g (4.56 mmol) of Pd(PPh₃)₄, and 31.54 g (228.24 mmol) of K₂CO₃ were dissolved in 300 mL/60 mL of THF/H₂O, the resulting solution was refluxed at 90°C for 1 hour. After the reaction was completed, extraction was performed using DCM and distilled water at room temperature. Thereafter, water was removed by adding MgSO₃ to the organic layer. Subsequently, the organic layer was concentrated, then dissolved in DCM and column-purified (DCM : Hex 1 : 4). After column purification, DCM/MeOH recrystallization was performed. Through this, 26 g (68%) of Compound 282-1 was obtained.

Here, THF means tetrahydrofuran (hereinafter, referred to as THF).

### 2) Preparation of Compound 282-2

After 10 g (23.74 mmol) of Compound 282-1, 2.95 g (23.74 mmol) of phenylboronic acid (F), 1.37 g (1.19 mmol) of Pd(PPh₃)₄, and 8.2 g (59.34 mmol) of K₂CO₃ were dissolved in 100 mL/20 mL of 1,4-dioxane/H₂O, the resulting solution was refluxed at 120°C for 3 hours. After the reaction was completed, extraction was performed using DCM and distilled water at room temperature. Thereafter, water was removed by adding MgSO₄ to the organic layer. Subsequently, the organic layer was concentrated, then dissolved in DCM, purified with silica, and then recrystalized with DCM/MeOH, and 10 g (91%) of Compound 282-2 was obtained.

### 3) Preparation of Compound 282

After 10 g (21.6 mmol) of Compound 282-2, 3.27 g (21.6 mmol) of naphthalen-2-ylboronic acid) (G), 0.99 g (1.08 mmol) of Pd₂dba₃, 1.03 g (2.16 mmol) of Xphos, and 7.46 g (54.0 mmol) of K₂CO₃ were dissolved in 150 mL/30 mL of 1,4-dioxane/H₂O, the resulting solution was refluxed at 120°C for 4 hours. After the reaction was completed, the resulting product was filtered under reduced pressure at room temperature. Subsequently, a base was removed by pouring water thereinto, and then the residue was dried. Thereafter, the dried residue was dissolved in DCB and purified with silica. After silica purification, recrystallization was performed using DCB to obtain 9.2 g (77%) of Compound 282.

A target compound corresponding to Compound No. of the following Table 2 was synthesized by performing synthesis in the same manner as in Preparation Example 2, except that Intermediate D of the following Table 2 was used instead of 2-(7-chlorodibenzo[b,d]furan-1-yl)-4,4,5,5-tetramethyl-1,3,2-dioxaborolane (D) in Preparation Example 2, Intermediate E of the following Table 2 was used instead of 2,4-dichlorobenzo[4,5]thieno[3,2-d]pyrimidine (E) in Preparation Example 2, Intermediate F of the following Table 2 was used instead of phenylboronic acid (F) in Preparation Example 2, and Intermediate G of the following Table 2 was used instead of naphthalen-2-ylboronic acid (G) in Preparation Example 2.

**[Table 2]**

| Compoun d No. | Intermediate D | Intermediate E | Intermediate F | Intermediate G | Yield |
|---|---|---|---|---|---|
| 290 | 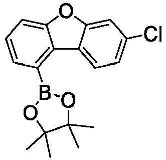 | 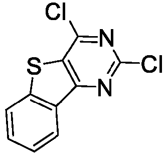 | 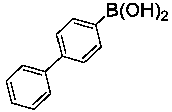 | 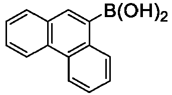 | 81% |
| 296 | 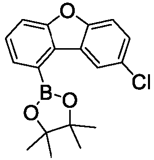 | 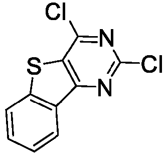 | 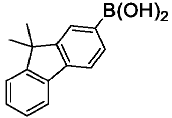 | 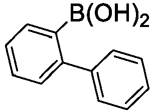 | 68% |
| 366 | 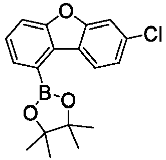 | 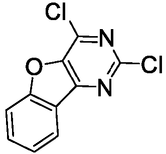 | 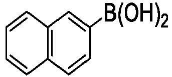 | 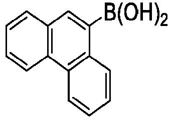 | 78% |
| 400 | 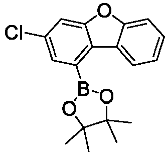 | 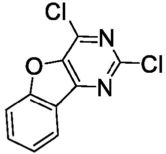 | 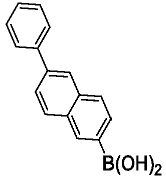 | 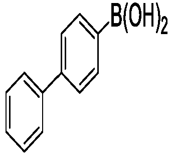 | 76% |

### <Preparation Example 3> Preparation of Compound 433

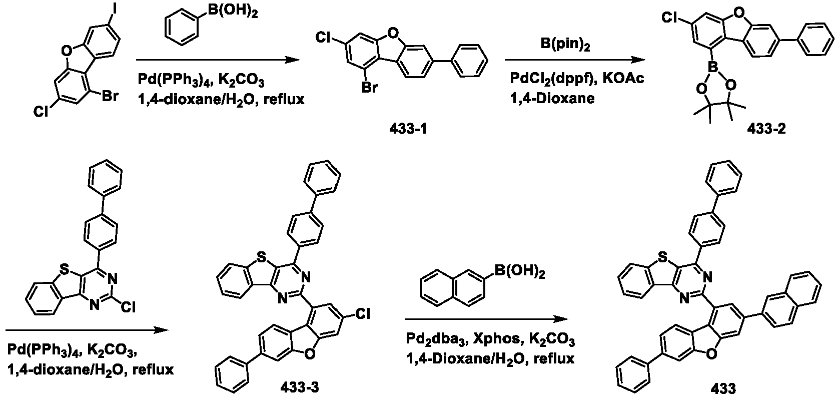

### 1) Preparation of Compound 433-1

After 15 g (36.82 mmol) of 1-bromo-3-chloro-7-iododibenzo[b,d]furan, 4.58 g (36.82 mmol) of phenylboronic acid, 2.13 g (1.84 mmol) of Pd(PPh₃)₄, and 12.72 g (92.04 mmol) of K₂CO₃ were dissolved in 150 mL/30 mL of 1,4-dioxane/H₂O, the resulting solution was refluxed at 130°C for 2 hours. After the reaction was completed, extraction was performed using DCM and distilled water at room temperature. Thereafter, the organic layer was treated with MgSO₄, and then concentrated. Subsequently, the organic layer was dissolved in DCM and subjected to column chromatography (DCM : Hex 1 : 6). After column chromatography, DCM/MeOH recrystallization was performed to obtain 8.3 g (63%) of Compound 433-1.

### 2) Preparation of Compound 433-2

After 8.3 g (23.21 mmol) of Compound 433-1, 8.84 g (34.81 mmol) of 4,4,4',4',5,5,5',5'-octamethyl-2,2'-bi(1,3,2-dioxaborolane), 0.81 g (1.16 mmol) of PdCl₂(dppf), and 5.69 g (58.02 mmol) of KOAc were dissolved in 80 mL of 1,4-dioxane, the resulting solution was refluxed at 130°C for 3 hours. After the reaction was completed, the resulting product was filtered under reduced pressure at room temperature, and then the solvent was removed from the filtrate using a rotary evaporator. Thereafter, the reaction product was purified by column chromatography (DCM : Hex = 1 : 4) to obtain 7.57 g (81%) of Compound 433-2.

### 3) Preparation of Compound 433-3

After 7.57 g (18.7 mmol) of Compound 433-2, 6.97 g (18.7 mmol) of 4-([1,1'-biphenyl]-4-yl)-2-chlorobenzo[4,5]thieno[3,2-d]pyrimidine, 1.08 g (0.93 mmol) of Pd(PPh₃)₄, and 6.46 g (46.75 mmol) of K₂CO₃ were dissolved in 100 mL/20 mL of 1,4-dioxane/H₂O, the resulting solution was refluxed for 5 hours. After the reaction was completed, the resulting product was filtered under reduced pressure at room temperature. Thereafter, the filtered product was dissolved in DCB and purified with silica. After silica purification, recrystallization was performed using toluene to obtain 8 g (70%) of Compound 433-3.

### 4) Preparation of Compound 433

After 8.0 g (13.01 mmol) of Compound 433-3, 2.24 g (13.01 mmol) of naphthalen-2-ylboronic acid, 0.6 g (0.65 mmol) of Pd₂dba₃, 0.62 g (1.3 mmol) of Xphos, and 4.49 g (32.51 mmol) of K₂CO₃ were dissolved in 120 mL/25 mL of 1,4-dioxane/H₂O, the resulting solution was refluxed at 120°C for 3 hours. After the reaction was completed, the resulting product was filtered under reduced pressure at room temperature. Thereafter, the filtered product was dissolved in DCB and purified with silica. After silica purification, recrystallization was performed using DCB to obtain 8.3 g (90%) of Compound 433.

### <Preparation Example 4> Preparation of Compound 401

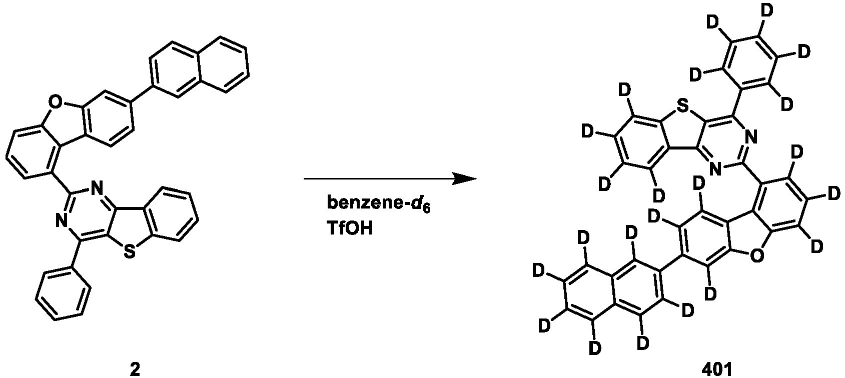

### 1) Preparation of Compound 401

8 g (14.42 mmol) of Compound 2(H) synthesized using the method of Preparation Example 1 was dissolved in 80 mL of benzene-d6. Thereafter, after the temperature was adjusted to 0°C using an ice bath, 9.07 mL (100.96 mmol) of trifluoromethanesulfonic acid was slowly added dropwise thereto. Thereafter, the resulting mixture was stirred at 60°C for 1 hour. After a mixed solution in which the reaction was completed was cooled to room temperature, the mixed solution was cooled by installing an ice bath. Thereafter, the mixed solution was neutralized using a K₃PO₄ aqueous solution. A solid was precipitated using methanol and filtered to obtain 7.8 g (94%) of Compound 401.

A target compound corresponding to Compound No. of the following Table 3 was synthesized by performing synthesis in the same manner as in Preparation Example 4, except that Compound H in the following Table 3 was used instead of Compound 2 in Preparation Example 4.

**[Table 3]**

| Compound No. | Compound H | Target compound | Yield |
|---|---|---|---|
| 408 | 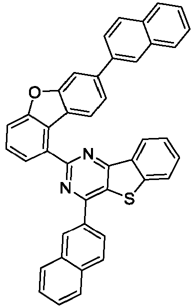 | 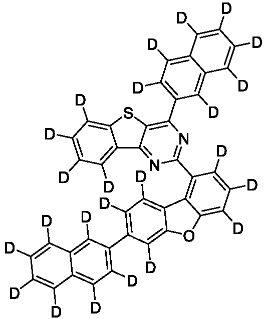 | 90% |
| 409 | 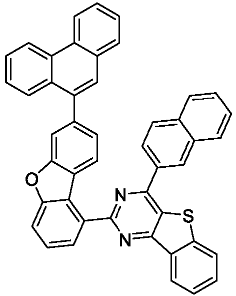 | 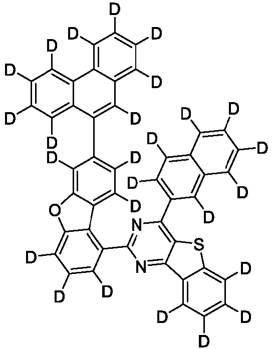 | 91% |
| 422 | 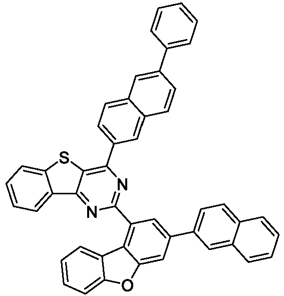 | 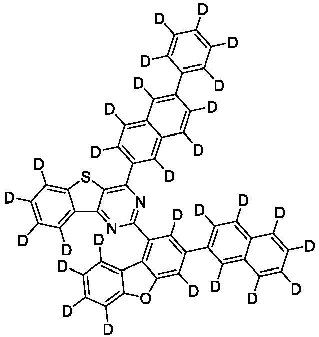 | 84% |
| 2-77 | 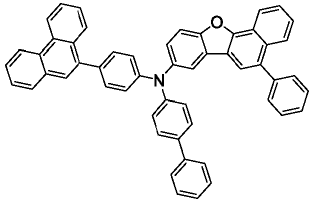 | 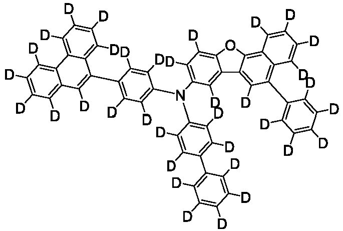 | 89% |

### <Preparation Example 5> Preparation of Compound 2-9

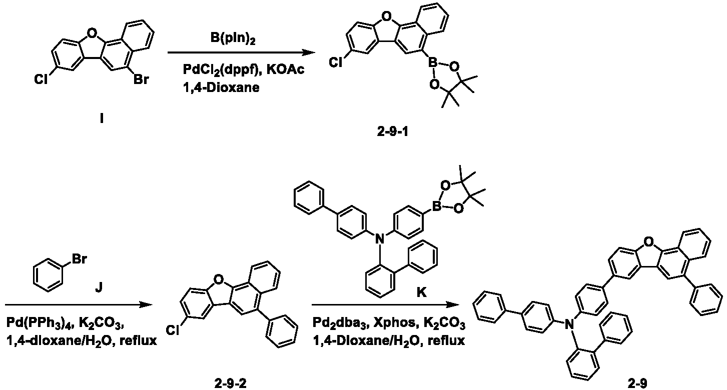

### 1) Preparation of Compound 2-9-1

After 10.0 g (30.16 mmol) of 5-bromo-8-chloronaphtho[1,2-b]benzofuran (I), 11.49 g (45.24 mmol) of 4,4,4',4',5,5,5',5'-octamethyl-2,2'-bi(1,3,2-dioxaborolane), 1.06 g (1.51 mmol) of PdCl₂(dppf), and 7.4 g (75.39 mmol) of KOAc were dissolved in 100 mL of 1,4-dioxane, the resulting solution was refluxed at 130°C for 5 hours. After the reaction was completed, the resulting product was filtered under reduced pressure at room temperature, and then the solvent was removed from the filtrate using a rotary evaporator. Subsequently, the reaction product was purified by column chromatograph (DCM : Hex = 1 : 5) to obtain 10.1 g (88%) of Compound 2-9-1.

### 2) Preparation of Compound 2-9-2

After 10.1 g (26.67 mmol) of Compound 2-9-1, 4.19 g (26.67 mmol) of bromobenzene (J), 1.54 g (1.33 mmol) of Pd(PPh₃)₄, and 9.22 g (66.68 mmol) of K₂CO₃ were dissolved in 100 mL/20 mL of 1,4-dioxane/H₂O), the resulting solution was refluxed at 130°C for 4 hours. After the reaction was completed, extraction was performed using DCM and distilled water at room temperature. Thereafter, water was removed by adding MgSO₄ to the organic layer. Subsequently, the organic layer was concentrated, then dissolved in DCM and purified by column chromatography (DCM : Hex = 1 : 5) to obtain 7.5 g (86%) of Compound 2-9-2.

### 3) Preparation of Compound 2-9

After 7.5 g (22.81 mmol) of Compound 2-9-2, 11.94 g (22.81 mmol) of N-([1,1'-biphenyl]-4-yl)-N-(4-(4,4,5,5-tetramethyl-1,3,2-dioxaborolan-2-yl)phenyl)-[1,1'-biphenyl]-2-amine (K), 1.04 g (1.14 mmol) of Pd₂dba₃, 1.09 g (2.28mmol) of Xphos, and 7.88 g (57.03 mmol) of K₂CO₃ were dissolved in 150 mL/30 mL of 1,4-dioxane/H₂O, the resulting solution was refluxed at 130°C for 4 hours. After the reaction was completed, the resulting product was filtered under reduced pressure at room temperature. Thereafter, the filtered product was dissolved in DCB and purified with silica. After silica purification, recrystallization was performed using DCB to obtain 13.7 g (87%) of Compound 2-9.

A target compound corresponding to Compound No. of the following Table 4 was synthesized by performing synthesis in the same manner as in Preparation Example 5, except that Intermediate I of the following Table 4 was used instead of 5-bromo-8-chloronaphtho[1,2-b]benzofuran (I) in Preparation Example 5, Intermediate J of the following Table 4 was used instead of bromobenzene (J) in Preparation Example 5, and Intermediate K of the following Table 4 was used instead of N-([1,1'-biphenyl]-4-yl)-N-(4-(4,4,5,5-tetramethyl-1,3,2-dioxaborolan-2-yl)phenyl)-[1,1'-biphenyl]-2-amine (K) in Preparation Example 5.

**[Table 4]**

| Compoun d No. | Intermediate I | Intermediate J | Intermediate K | Yield |
|---|---|---|---|---|
| 2-33 | 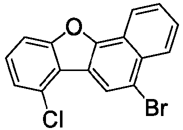 | 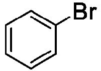 | 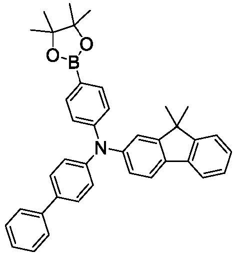 | 81% |
| 2-66 | 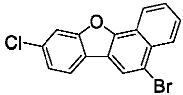 | 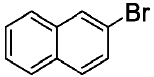 | 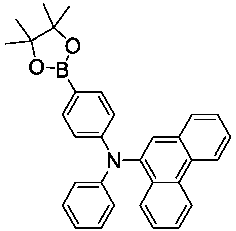 | 78% |
| 2-70 | 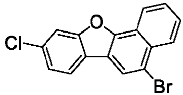 | 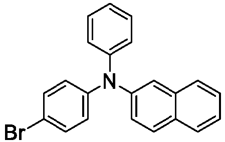 | 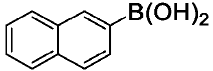 | 69% |
| 2-83 | 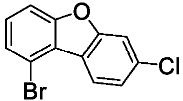 | 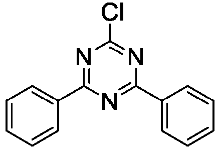 | 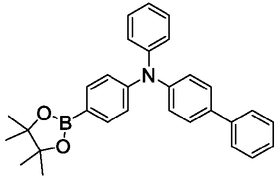 | 84% |
| 2-91 | 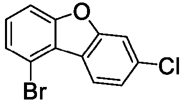 | 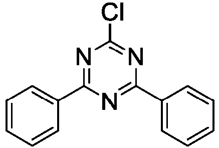 | 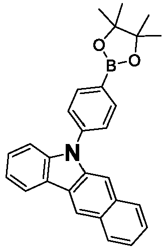 | 77% |
| 2-96 | 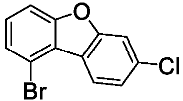 | 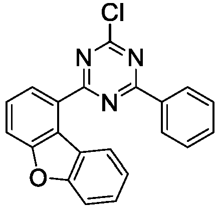 | 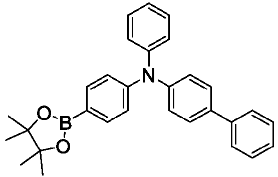 | 82% |
| 2-103 | 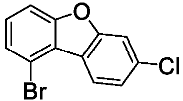 | 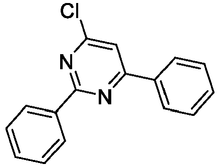 | 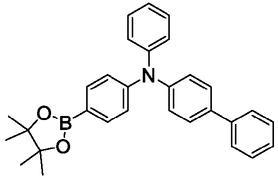 | 84% |
| 2-114 | 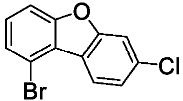 | 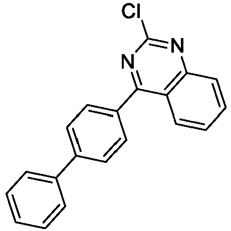 | 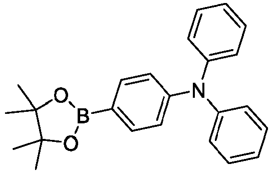 | 73% |

### <Preparation Example 6> Preparation of Compound 2-12

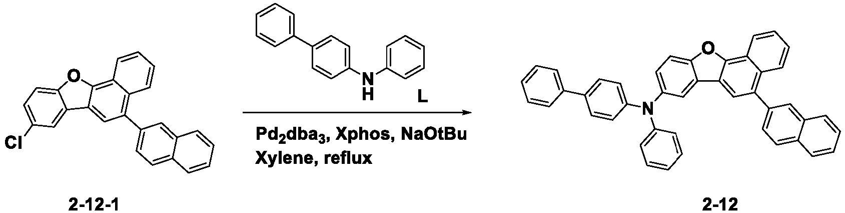

### 1) Preparation of Compound 2-12-1

Compound 2-12-1 was synthesized in the same manner as in Preparation Examples 5-1 and 5-2, except that 2-bromonaphthalene was used instead of bromobenzene (J) in Preparation Examples 5-1 and 5-2. That is, 5-bromo-8-chloronaphtho[1,2-b]benzofuran (I) was used in the same manner as in Preparation Examples 5-1 and 5-2.

### 2) Preparation of Compound 2-12

After 7 g (18.48 mmol) of Compound 2-12-1, 4.6 g (18.48 mmol) of N-phenyl-[1,1'-biphenyl]-4-amine (L), 0.85 g (0.92 mmol) of Pd₂dba₃, 0.88 g (1.85 mmol) of Xphos, and 4.44 g (46.19 mmol) of sodium tert-butoxide were dissolved in 70 mL of xylene, the resulting solution was refluxed at 160°C for 5 hours. After the reaction is completed, a base is removed by performing filtration under reduced pressure at room temperature, and then the solution was concentrated. The reaction product was dissolved in DCM and purified by column chromatography (DCM : Hex = 1 : 2), and 8 g (74%) of Compound 2-12 was obtained.

A target compound corresponding to Compound No. of the following Table 5 was synthesized by performing synthesis in the same manner as in Preparation Example 6, except that Intermediate I of the following Table 5 was used instead of 5-bromo-8-chloronaphtho[1,2-b]benzofuran (I) in Preparation Example 6, Intermediate J of the following Table 5 was used instead of bromobenzene (J) in Preparation Example 6, and Intermediate L of the following Table 5 was used instead of N-phenyl-[1,1'-biphenyl]-4-amine (L) in Preparation Example 6.

**[Table 5]**

| Compo und No. | Intermediate I | Intermediate J | Intermediate L | Yiel d |
|---|---|---|---|---|
| 2-22 | 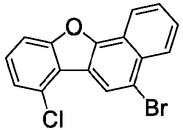 | 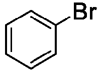 | 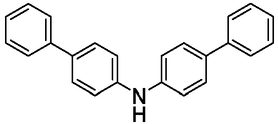 | 86% |
| 2-85 | 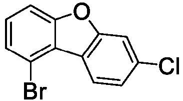 | 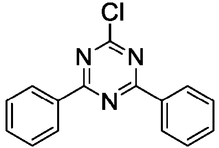 | 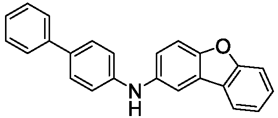 | 91% |
| 2-119 | 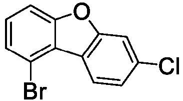 | 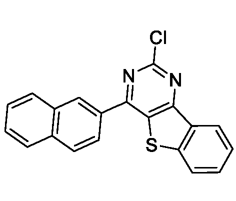 | 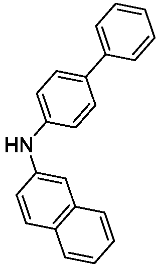 | 76% |
| 2-120 | 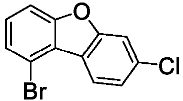 | 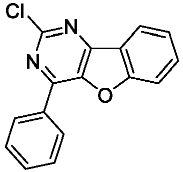 | 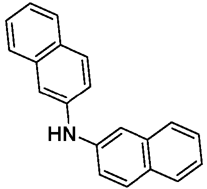 | 81% |
| 2-124 | 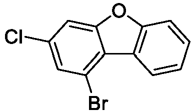 | 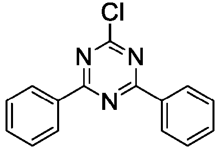 | 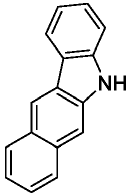 | 69% |
| 2-146 | 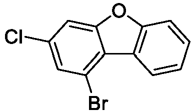 | 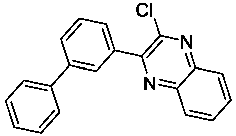 | 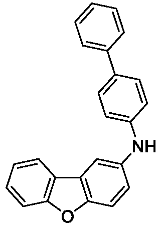 | 75% |
| 2-170 | 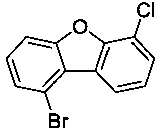 | 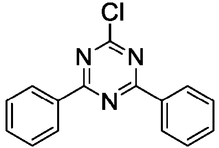 | 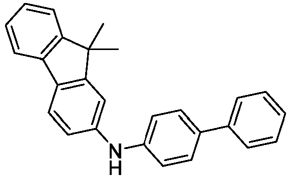 | 77% |

The Compound Nos. of Tables 1 to 5 correspond to the numbers described in the compound which may be represented by any one of Chemical Formula 1 and the compound which may be represented by any one of Chemical Formula 2 according to the present application described above, respectively. That is, for example, Compound No. 2 and Compound No. 2-22 each mean the following compounds.

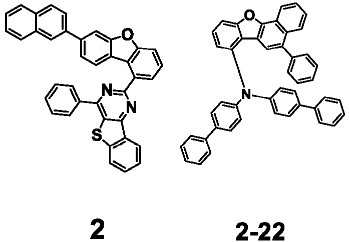

The synthetic confirmation data of the compounds prepared above are as shown in the following Tables 6 and 7. Specifically, the following Tables 6 and 7 are the ¹H NMR data and FD-MS data of the compounds synthesized respectively, and it can be confirmed through the following data that the desired compound was synthesized.

**[Table 6]**

| Compound No. | ¹H NMR(CDCl₃, 400 Mz) |
|---|---|
| 1 | δ = 8.05(d, 1H), 8.03(d, 1H), 7.93(d, 1H), 7.84-7.69(m, 8H), 7.57-7.41(m, 9H) |
| 2 | δ = 8.05-7.82(m, 9H), 7.76(s, 1H), 7.69-7.38(m, 12H) |
| 3 | δ = 9.08(d, 1H), 8.84(d, 1H), 8.72(d, 1H), 8.05(s, 1H), 8.03(d, 1H), 7.93-7.42(m, 18H) |
| 4 | δ = 9.60(d, 1H), 9.27(s, 1H), 8.37-8.30(m, 3H), 8.05-8.03(m, 2H), 7.93(d, 1H), 7.84-7.42(m, 18H) |
| 22 | δ = 8.30(d, 2H), 8.09-7.38(m, 24H) |
| 23 | δ = 9.08(d, 1H), 8.84(d, 1H), 8.30-8.27(m, 3H), 8.05-8.03(m, 3H), 7.93-7.41(m, 20H) |
| 24 | δ = 9.60(d, 1H), 9.27(s, 1H), 8.37-8.30(m, 5H), 8.05(d, 1H), 8.03(d, 1H), 7.93-7.41(m, 11H) |
| 34 | δ = 8.30(d, 2H), 8.05-7.93(m, 5H), 7.85-7.69(m, 10H), 7.61-7.40(m, 13H) |
| 42 | δ = 8.46(s, 1H), 8.09-7.93(m, 10H), 7.82-7.76(m, 3H), 7.69-7.38(m, 10H) |
| 43 | δ = 9.08(d, 1H), 8.84(d, 1H), 8.46(s, 1H), 8.27(d, 1H), 8.06-7.42(m, 22H) |
| 44 | δ = 9.60(d, 1H), 9.27(s, 1H), 8.46(s, 1H), 8.37-8.30(m, 3H), 8.06-7.93(m, 7H), 7.82-7.42(m, 15H) |
| 45 | δ = 8.46(s, 1H), 8.06-7.93(m, 7H), 7.82-7.41(m, 14H), 7.25(d, 4H) |
| 49 | δ = 8.46(s, 1H), 8.09-7.93(m, 10H), 7.82(d, 2H), 7.76(s, 1H), 7.69-7.38(m, 10H), 7.25(d, 4H) |
| 57 | δ = 8.30(d, 1H), 8.19-8.13(m, 2H), 8.05-7.79(m, 11H), 7.69-7.41(m, 16H), 7.20(t, 1H) |
| 67 | δ = 8.52(s, 1H), 8.09-7.38(m, 27H) |
| 69 | δ = 9.08(d, 1H), 8.84(d, 1H), 8.17-7.38(m, 24H), 7.25 (d, 4) |
| 71 | δ = 9.27(s, 1H), 8.95-8.84(m, 3H), 8.52-8.50(m, 2H), 8.20-8.03(m, 6H), 7.93-7.39(m, 6H) |
| 74 | δ = 8.05-7.93(m, 7H), 7.82-7.69(m, 8H), 7.61-7.31(m, 13H) |
| 92 | δ = 9.00(d, 2H), 8.05(d, 1H), 7.93-7.79(m, 9H), 7.69(d, 1H), 7.61-7.39(m, 13H) |
| 122 | δ = 8.46(s, 1H), 8.09-7.79(m, 13H), 7.69-7.42(m, 10H) |
| 160 | δ = 8.09-8.05(m, 3H), 8.04(s, 3H), 7.99-7.41(m, 24H) |
| 179 | δ = 8.30(d, 2H), 8.08-7.41(m, 24H) |
| 213 | δ = 8.46(s, 1H), 8.09-7.93(m, 12H), 7.63-7.25(m, 15H) |
| 233 | δ = 8.09-7.89(m, 10H), 7.79-7.78(m, 4H), 7.65-7.31(m, 14H), 1.69(s, 6H) |
| 263 | δ = 9.08(d, 1H), 8.84(d, 1H), 8.52(s, 1H), 8.27(d, 1H), 8.05-7.38(m, 26H) |
| 282 | δ = 8.35(d, 2H), 8.09-7.93(m, 6H), 7.82-7.76(m, 3H), 7.69-7.38(m, 11H) |
| 290 | δ = 9.08(d, 1H), 8.84(d, 1H), 8.27(d, 1H), 8.05-7.41(m, 21H), 7.25(d, 2H) |
| 296 | δ = 8.09-8.05(m, 2H), 7.96-7.79(m, 12H), 7.69(d, 1H), 7.60-7.38(m, 10H), 7.28(t, 1H), 1.69(s, 6H) |
| 322 | δ = 8.09-7.99(m, 4H), 7.84-7.53(m, 15H), 7.38(d, 1H), 7.36(d, 1H), 7.22(t, 1H) |
| 325 | δ = 9.11(d, 1H), 8.92(d, 1H), 8.84(d, 1H), 8.46(s, 1H), 8.21(d, 1H), 8.09-7.55(m, 20H), 7.36(t, 1H), 7.22(t, 1H) |
| 332 | δ = 8.52(s, 1H), 8.09-7.99(m, 7H), 7.82-7.36(m, 19H), 7.22(t, 1H) |
| 358 | δ = 9.08(d, 1H), 8.84(d, 1H), 8.17(d, 1H), 8.05(s, 1H), 7.90-7.22(m, 23H) |
| 366 | δ = 9.09(s, 1H), 9.08(d, 1H), 8.84(d, 1H), 8.49(d, 1H), 8.27(d, 1H), 8.16-8.03(m, 5H), 7.90-7.57(m, 14H), 7.36(t, 1H), 7.22(t, 1H) |
| 400 | δ = 9.15(s, 1H), 8.51(d, 1H), 7.99-7.65(m, 11H), 7.55-7.22(m, 17H) |
| 413 | δ = 8.46(s, 1H), 8.06-7.93(m, 7H), 7.82-7.42(m, 9H) |
| 418 | δ = 8.97(d, 1H), 8.25(d, 1H), 8.15-7.93(m, 6H), 7.59-7.42(m, 4H) |
| 433 | δ = 8.30(d, 2H), 8.09-7.75(m, 16H), 7.63-7.38(m, 12H) |
| 2-9 | δ = 8.97(d, 1H), 8.18(d, 1H), 8.10(d, 1H), 7.88-7.75(m, 7H), 7.64-7.37(m, 22H), 7.14(t, 1H), 7.08(d, 2H) |
| 2-12 | δ = 8.97(d, 1H), 8.22(s, 1H), 8.18(d, 1H), 8.09-7.99(m, 3H), 7.75(d, 2H), 7.64-7.37(m, 15H), 7.24(t, 2H), 7.80(d, 2H), 7.00(t, 1H), 6.97(d, 1H) |
| 2-22 | δ = 8.97(d, 1H), 8.18(d, 1H), 7.79-7.75(m, 6H), 7.64-7.37(m, 21H), 7.25(d, 1H), 6.91(d, 1H) |
| 2-33 | δ = 8.97(d, 1H), 8.18(d, 1H), 7.90-7.28(m, 30H), 7.16(d, 1H), 1.69(s, 6H) |
| 2-66 | δ = 8.98(d, 1H), 8.84(d, 1H), 8.18-7.99(m, 6H), 7.90(d, 1H), 7.82-7.49(m, 14H), 7.38-7.37(m, 4H), 7.24(t, 2H), 7.08(d, 2H), 7.00(t, 1H) |
| 2-70 | δ = 8.97(d, 1H), 8.18(d, 1H), 8.09-7.99(m, 4H), 7.82-7.37(m, 19H), 7.24(t, 2H), 7.11(s, 1H), 7.08(d, 2H), 7.00(t, 1H) |
| 2-83 | δ = 8.36(d, 4H), 8.03(d, 1H), 7.82-7.69(m, 6H), 7.57-7.37(m, 18H), 7.24(t, 2H), 7.08(d, 2H), 7.00(t, 1H) |
| 2-85 | δ = 8.36(d, 4H), 8.22(s, 1H), 8.03(s, 1H), 7.98(d, 1H), 7.82-7.69(m, 5H), 7.57-7.31(m, 18H), 6.97(d, 1H), 6.91(d, 1H) |
| 2-91 | δ = 8.55(d, 1H), 8.36-8.28(m, 5H), 8.11(d, 1H), 8.03(d, 1H), 7.94-7.91(m, 5H), 7.82-7.69(m, 6H), 7.57-7.50(m, 8H), 7.40-7.35(m, 2H), 7.16(t, 1H) |
| 2-96 | δ = 8.36(d, 2H), 8.03(d, 1H), 7.98(d, 1H), 7.82-7.69(m, 8H), 7.57-7.24(m, 21H), 7.08(d, 2H), 7.00(s, 1H) |
| 2-103 | δ = 8.35(d, 2H), 8.23(s, 1H), 8.03(d, 1H), 7.94(d, 2H), 7.82-7.69(m, 6H), 7.57-7.37(m, 18H), 7.24(t, 2H), 7.08-7.00(m, 3H) |
| 2-114 | δ = 8.30(d, 2H), 8.13(d, 1H), 8.03(d, 1H), 7.85-7.69(m, 10H), 7.58-7.37(m, 9H), 7.24(t, 4H), 7.08-7.00(m, 6H) |
| 2-119 | δ = 8.46(s, 1H), 8.06-7.93(m, 7H), 7.82-7.37(m, 23H), 7.11(s, 1H), 6.91(d, 1H) |
| 2-120 | δ = 8.03(s, 1H), 7.84-7.40(m, 24H), 7.22(t, 1H), 7.11(s, 2H), 6.91(d, 1H) |
| 2-124 | δ = 8.55(d, 1H), 8.36-8.28(m, 5H), 8.11(d, 1H), 7.98-7.94(m, 2H), 7.75-7.50(m, 12H), 7.40-7.31(m, 4H), 7.16(t, 1H) |
| 2-146 | δ = 8.76(s, 1H), 8.50(m, 2H), 8.23-8.22(m, 2H), 7.98(d, 2H), 7.80-7.67(m, 10H), 7.55-7.31(m, 17H), 6.97(d, 1H) |
| 2-170 | δ = 8.36(d, 4H), 7.90-7.28(m, 26H), 7.16(d, 1H), 6.97(d, 1H), 1.69(s, 6H) |

**[Table 7]**

| Compound | FD-Mass | Compound | FD-Mass |
|---|---|---|---|
| 1 | m/z= 504.61 (C34H20N2OS, 504.13) | 332 | m/z= 664.76(C48H28N2O2, 664.22) |
| 2 | m/z= 554.67(C38H22N2OS, 554.15) | 358 | m/z= 664.76(C48H28N2O2, 664.22) |
| 3 | m/z= 604.73(C42H24N2OS, 604.16) | 366 | m/z= 638.73(C46H26N2O2, 638.20) |
| 4 | m/z= 654.79(C46H26N2OS, 654.18) | 400 | m/z= 690.80(C50H30N2O2, 690.23) |
| 22 | m/z= 630.76(C44H26N2OS, 630.18) | 401 | m/z= 576.80(C38D22N2OS, 576.28) |
| 23 | m/z= 680.83(C48H28N2OS, 680.19) | 408 | m/z= 628.87(C42D24N2OS, 628.31) |
| 24 | m/z= 730.88(C52H30N2OS, 730.21) | 409 | m/z= 680.95(C46D26N2OS, 680.34) |
| 34 | m/z= 706.83(C50H30N2OS, 706.21) | 413 | m/z= 691.89(C48H17D11N2OS, 691.26) |
| 42 | m/z= 604.73(C42H24N2OS, 604.16) | 418 | m/z= 697.93(C48H11D17N2OS, 697.30) |
| 43 | m/z= 654.79(C46H26N2OS, 654.18) | 422 | m/z= 709.00(C48D28N2OS, 708.37) |
| 44 | m/z= 704.85(C50H28N2OS, 704.19) | 433 | m/z= 706.86(C50H30N2OS, 706.21) |
| 45 | m/z= 630.76(C44H26N2OS, 630.18) | 2-9 | m/z= 689.86(C52H35NO, 689.27) |
| 49 | m/z= 680.83(C48H28N2OS, 680.19) | 2-12 | m/z= 587.72(C44H29NO, 587.22) |
| 57 | m/z= 745.90(C52H31N3OS, 745.22) | 2-22 | m/z= 613.76(C46H31NO, 613.24) |
| 67 | m/z= 680.83(C48H28N2OS, 680.19) | 2-33 | m/z= 729.92(C55H39NO, 729.30) |
| 69 | m/z= 730.88(C52H30N2OS, 730.21) | 2-66 | m/z= 687.84(C52H33NO, 687.26) |
| 71 | m/z= 704.85(C50H28N2OS, 704.19) | 2-70 | m/z= 637.78(C48H31NO, 637.24) |
| 74 | m/z= 720.85(C50H28N2O2S, 720.19) | 2-77 | m/z= 749.09(C54D35NO, 748.49) |
| 92 | m/z= 630.76(C44H26N2OS, 630.18) | 2-83 | m/z= 718.86(C51H34N4O, 718.27) |
| 122 | m/z= 604.73(C42H24N2OS, 604.16) | 2-85 | m/z= 732.84(C51H32N4O2, 732.25) |
| 160 | m/z= 706.86(C50H30N2OS, 706.21) | 2-91 | m/z= 690.81(C49H30N4O, 690.24) |
| 179 | m/z= 630.76(C44H26N2OS, 630.18) | 2-96 | m/z= 808.94(C57H36N4O2, 808.28) |
| 213 | m/z= 680.83(C48H28N2OS, 680.19) | 2-103 | m/z= 717.87(C52H35N3O, 717.28) |
| 233 | m/z= 746.93 (C53H34N2OS, 746.24) | 2-114 | m/z= 691.83(C50H33N3O, 691.26) |
| 263 | m/z= 730.88(C52H30N2OS, 730.21) | 2-119 | m/z= 771.94 (C54H33N3OS, 771.23) |
| 282 | m/z= 554.67(C38H22N2OS, 554.15) | 2-120 | m/z= 679.78(C48H29N3O2, 679.23) |
| 290 | m/z= 680.83(C48H28N2OS, 680.19) | 2-124 | m/z= 614.71(C43H26N4O, 614.21) |
| 296 | m/z= 696.87(C49H32N2OS, 696.22) | 2-146 | m/z= 781.91(C56H35N3O2, 781.27) |
| 322 | m/z= 538.61(C38H22N2O2, 538.17) | 2-170 | m/z= 758.92(C54H38N4O, 758.30) |
| 325 | m/z= 688.79(C50H28N2O2, 688.22) | | |

### <Experimental Example 1> - Manufacture of organic light emitting device

A glass substrate, in which indium tin oxide (ITO) was thinly coated to have a thickness of 1,500 Å, was ultrasonically washed with distilled water. When the washing with distilled water was finished, the glass substrate was ultrasonically washed with a solvent such as acetone, methanol, and isopropyl alcohol, dried and then was subjected to UVO treatment for 5 minutes using UV in a UV cleaning machine. Thereafter, the substrate was transferred to a plasma washing machine (PT), and then was subjected to plasma treatment in a vacuum state for an ITO work function and in order to remove a residual film, and was transferred to a thermal deposition apparatus for organic deposition.

As the common layers, the hole injection layer 4,4',4''-tris[2-naphthyl(phenyl)amino]triphenylamine (2-TNATA) and the hole transport layer N,N'-di(1-naphthyl)-N,N'-diphenyl-(1,1'-biphenyl)-4,4'-diamine (NPB) were formed on the ITO transparent electrode (positive electrode).

A light emitting layer was thermally vacuum deposited thereon as follows. The light emitting layer was deposited to have a thickness of 500 Å by using a combination compound of Chemical Formulae 1 and 2 described in the following Table 8 as a host and (piq)₂(Ir) (acac) as a red phosphorescent dopant to dope the host with (piq)₂(Ir) (acac) in an amount of 3%. Thereafter, BCP as a hole blocking layer was deposited to have a thickness of 60 Å, and Alq₃ as an electron transport layer was deposited to have a thickness of 200 Å thereon. Finally, lithium fluoride (LiF) was deposited to have a thickness of 10 Å on the electron transport layer to form an electron injection layer, and then an aluminum (Al) negative electrode was deposited to have a thickness of 1,200 Å on the electron injection layer to form a negative electrode, thereby manufacturing an organic electroluminescence device.

Meanwhile, all the organic compounds required for manufacturing an OLED device were subjected to vacuum sublimed purification under 10⁻⁶ to 10⁻⁸ torr for each material, and used for the manufacture of OLED.

For the organic electroluminescence device manufactured as described above, electroluminescence (EL) characteristics were measured by M7000 manufactured by McScience Inc., and based on the measurement result thereof, T₉₀ (unit: hour) was measured by a service life measurement equipment (M6000) manufactured by McScience Inc., when the reference luminance was 6,000 cd/m². Characteristics of the organic electroluminescence device of the present invention are as shown in the following Table 8. The ratios in the following Table 8 mean weight ratios. For example, the case of Example 1 means that Compound 1 and Compound 2-9 are used at a weight ratio of 5:1.

**[Table 8]**

| | Compound | Ratio (N:P) | Turn-on (V) | Driving voltage (V) | efficiency (cd/A) | Color coordinate (x, y) | Service life (T₉₀) |
|---|---|---|---|---|---|---|---|
| Comparative Example 1 | U | - | 3.41 | 5.28 | 25.7 | (0.685, 0.315) | 43 |
| Comparative Example 2 | V | - | 3.58 | 5.34 | 18.12 | (0.682, 0.316) | 24 |
| Comparative Example 3 | W | - | 3.59 | 5.23 | 25.82 | (0.681, 0.319) | 40 |
| Comparative Example 4 | X | - | 3.41 | 4.99 | 19.91 | (0.682, 0.316) | 35 |
| Comparative Example 5 | Y | - | 3.57 | 5.45 | 26.00 | (0.683, 0.315) | 36 |
| Comparative Example 6 | 1 | - | 3.15 | 4.63 | 31.03 | (0.681, 0.318) | 71 |
| Comparative Example 7 | 2 | - | 2.79 | 3.61 | 54.97 | (0.680, 0.319) | 108 |
| Comparative Example 8 | 3 | - | 2.91 | 4.01 | 55.98 | (0.683, 0.316) | 97 |
| Comparative Example 9 | 4 | - | 3.13 | 4.33 | 56.48 | (0.685, 0.315) | 102 |
| Comparative Example 10 | 22 | - | 2.81 | 3.68 | 57.88 | (0.687, 0.312) | 94 |
| Comparative Example 11 | 23 | - | 2.91 | 3.99 | 58.31 | (0.686, 0.313) | 98 |
| Comparative Example 12 | 24 | - | 3.11 | 4.41 | 58.65 | (0.686, 0.313) | 102 |
| Comparative Example 13 | 34 | - | 2.60 | 3.75 | 45.29 | (0.686, 0.313) | 112 |
| Comparative Example 14 | 42 | - | 2.42 | 3.37 | 56.49 | (0.685, 0.315) | 97 |
| Comparative Example 15 | 43 | - | 2.43 | 3.48 | 52.05 | (0.686, 0.313) | 103 |
| Comparative Example 16 | 44 | - | 2.51 | 3.79 | 51.31 | (0.686, 0.313) | 114 |
| Comparative Example 17 | 45 | - | 2.41 | 3.65 | 43.14 | (0.685, 0.315) | 132 |
| Comparative Example 18 | 49 | - | 2.55 | 3.47 | 63.98 | (0.687, 0.312) | 105 |
| Comparative Example 19 | 57 | | 2.48 | 3.81 | 56.11 | (0.686, 0.313) | 98 |
| Comparative Example 20 | 67 | - | 2.77 | 3.90 | 49.39 | (0.686, 0.313) | 109 |
| Comparative Example 21 | 69 | - | 2.62 | 4.07 | 52.79 | (0.686, 0.313) | 125 |
| Comparative Example 22 | 71 | - | 3.16 | 4.61 | 54.64 | (0.684, 0.315) | 100 |
| Comparative Example 23 | 74 | | 2.58 | 3.50 | 59.82 | (0.686, 0.313) | 94 |
| Comparative Example 24 | 92 | - | 2.88 | 3.92 | 43.86 | (0.685, 0.315) | 98 |
| Comparative Example 25 | 122 | - | 2.92 | 4.28 | 45.27 | (0.684, 0.315) | 124 |
| Comparative Example 26 | 160 | - | 2.87 | 4.11 | 44.91 | (0.685, 0.315) | 141 |
| Comparative Example 27 | 179 | - | 3.04 | 4.58 | 48.48 | (0.686, 0.313) | 100 |
| Comparative Example 28 | 213 | - | 3.11 | 4.52 | 51.26 | (0.685, 0.315) | 94 |
| Comparative Example 29 | 233 | - | 3.08 | 4.25 | 52.70 | (0.685, 0.315) | 87 |
| Comparative Example 30 | 263 | - | 3.38 | 5.01 | 30.90 | (0.685, 0.315) | 62 |
| Comparative Example 31 | 282 | - | 2.80 | 3.79 | 39.13 | (0.684, 0.315) | 67 |
| Comparative Example 32 | 290 | - | 2.85 | 3.90 | 42.21 | (0.685, 0.314) | 73 |
| Comparative Example 33 | 296 | - | 2.90 | 4.21 | 30.11 | (0.687, 0.312) | 65 |
| Comparative Example 34 | 322 | - | 2.87 | 4.10 | 35.39 | (0.686, 0.313) | 48 |
| Comparative Example 35 | 325 | - | 3.20 | 4.71 | 38.15 | (0.686, 0.313) | 61 |
| Comparative Example 36 | 332 | - | 2.88 | 4.02 | 40.29 | (0.686, 0.313) | 69 |
| Comparative Example 37 | 358 | - | 2.89 | 3.97 | 38.49 | (0.685, 0.315) | 43 |
| Comparative Example 38 | 366 | - | 3.02 | 4.95 | 35.15 | (0.686, 0.313) | 67 |
| Comparative Example 39 | 400 | - | 3.00 | 4.90 | 37.31 | (0.685, 0.315) | 38 |
| Comparative Example 40 | 401 | - | 2.79 | 3.61 | 57.71 | (0.685, 0.314) | 121 |
| Comparative Example 41 | 408 | - | 2.42 | 3.37 | 56.49 | (0.686, 0.313) | 139 |
| Comparative Example 42 | 409 | - | 2.43 | 3.48 | 52.05 | (0.685, 0.314) | 149 |
| Comparative Example 43 | 413 | | 2.55 | 3.47 | 61.98 | (0.687, 0.312) | 111 |
| Comparative Example 44 | 418 | | 2.53 | 3.36 | 58.72 | (0.687, 0.312) | 148 |
| Comparative Example 45 | 422 | - | 3.37 | 5.01 | 32.21 | (0.686, 0.313) | 80 |
| Comparative Example 46 | 433 | - | 3.41 | 5.10 | 31.64 | (0.685, 0.314) | 61 |
| Comparative Example 47 | 2-9 | - | 3.04 | 4.51 | 33.86 | (0.684, 0.315) | 189 |
| Comparative Example 48 | 2-12 | - | 3.20 | 5.00 | 28.30 | (0.686, 0.313) | 194 |
| Comparative Example 49 | 2-22 | - | 3.05 | 4.65 | 29.90 | (0.686, 0.313) | 184 |
| Comparative Example 50 | 2-33 | - | 2.98 | 4.35 | 32.10 | (0.685, 0.314) | 202 |
| Comparative Example 51 | 2-66 | - | 3.11 | 5.20 | 37.15 | (0.685, 0.314) | 195 |
| Comparative Example 52 | 2-70 | - | 3.08 | 5.08 | 32.35 | (0.686, 0.313) | 192 |
| Comparative Example 53 | 2-77 | - | 3.05 | 4.61 | 28.86 | (0.686, 0.313) | 249 |
| Comparative Example 54 | 2-83 | - | 3.04 | 4.53 | 35.21 | (0.686, 0.313) | 182 |
| Comparative Example 55 | 2-85 | - | 3.07 | 4.85 | 35.50 | (0.686, 0.313) | 215 |
| Comparative Example 56 | 2-91 | - | 3.15 | 4.92 | 31.28 | (0.687, 0.312) | 214 |
| Comparative Example 57 | 2-96 | - | 3.13 | 5.14 | 36.32 | (0.686, 0.313) | 199 |
| Comparative Example 58 | 2-103 | - | 3.00 | 4.48 | 39.82 | (0.685, 0.314) | 169 |
| Comparative Example 59 | 2-114 | - | 3.02 | 4.51 | 37.24 | (0.686, 0.313) | 170 |
| Comparative Example 60 | 2-119 | - | 3.04 | 4.56 | 36.55 | (0.687, 0.312) | 184 |
| Comparative Example 61 | 2-120 | - | 3.03 | 4.49 | 37.11 | (0.687, 0.312) | 179 |
| Comparative Example 62 | 2-124 | - | 3.18 | 4.87 | 32.02 | (0.687, 0.312) | 208 |
| Comparative Example 63 | 2-146 | - | 3.08 | 4.86 | 36.12 | (0.687, 0.312) | 170 |
| Comparative Example 64 | 2-170 | - | 3.17 | 4.90 | 39.12 | (0.687, 0.312) | 166 |
| Comparative Example 65 | Z | - | 3.68 | 5.83 | 25.41 | (0.685, 0.315) | 53 |
| Comparative Example 66 | 2 : Z | 3:1 | 3.18 | 5.34 | 46.68 | (0.685, 0.315) | 227 |
| Comparative Example 67 | | 1:1 | 2.92 | 4.88 | 45.16 | (0.687, 0.312) | 258 |
| Comparative Example 68 | | 1:3 | 3.24 | 5.47 | 42.77 | (0.685, 0.315) | 269 |
| Example 1 | 1:2-9 | 5:1 | 2.58 | 4.12 | 55.13 | (0.687, 0.312) | 430 |
| Example 2 | | 3:1 | 2.51 | 3.81 | 62.10 | (0.687, 0.312) | 519 |
| Example 3 | | 1:1 | 2.40 | 3.62 | 65.35 | (0.686, 0.313) | 630 |
| Example 4 | | 1:3 | 2.54 | 3.95 | 60.00 | (0.686, 0.313) | 582 |
| Example 5 | | 1:5 | 2.57 | 4.03 | 55.35 | (0.686, 0.313) | 602 |
| Example 6 | 2:2-22 | 3:1 | 2.39 | 3.65 | 72.11 | (0.687, 0.312) | 632 |
| Example 7 | | 1:1 | 2.23 | 3.35 | 78.35 | (0.686, 0.313) | 750 |
| Example 8 | | 1:3 | 2.51 | 3.81 | 68.35 | (0.685, 0.315) | 680 |
| Example 9 | 3:2-77 | 1:1 | 2.31 | 3.42 | 80.15 | (0.685, 0.315) | 914 |
| Example 10 | 4:2-12 | 1:1 | 2.45 | 3.61 | 77.10 | (0.687, 0.312) | 761 |
| Example 11 | 22:2-33 | 1:1 | 2.25 | 3.30 | 75.39 | (0.685, 0.315) | 690 |
| Example 12 | 23:2-124 | 1:1 | 2.35 | 3.55 | 80.13 | (0.686, 0.313) | 702 |
| Example 13 | 24:2-83 | 1:1 | 2.30 | 3.38 | 82.53 | (0.686, 0.313) | 681 |
| Example 14 | 34:2-85 | 1:1 | 2.36 | 3.69 | 72.93 | (0.685, 0.315) | 750 |
| Example 15 | 42:2-66 | 1:1 | 2.29 | 3.20 | 83.84 | (0.685, 0.315) | 590 |
| Example 16 | 43:2-70 | 1:1 | 2.33 | 3.49 | 80.11 | (0.686, 0.313) | 624 |
| Example 17 | 44:2-96 | 1:1 | 2.41 | 3.86 | 82.55 | (0.687, 0.312) | 677 |
| Example 18 | 45:2-22 | 1:1 | 2.38 | 3.41 | 79.23 | (0.686, 0.313) | 718 |
| Example 19 | 49:2-83 | 1:1 | 2.43 | 3.67 | 80.21 | (0.685, 0.315) | 682 |
| Example 20 | 57:2-114 | 1:1 | 2.41 | 3.73 | 80.21 | (0.686, 0.313) | 635 |
| Example 21 | 67:2-85 | 1:1 | 2.39 | 3.66 | 78.59 | (0.685, 0.315) | 680 |
| Example 22 | 69:2-9 | 1:1 | 2.48 | 3.71 | 73.14 | (0.686, 0.313) | 705 |
| Example 23 | 71:2-22 | 1:1 | 2.43 | 3.61 | 76.57 | (0.686, 0.313) | 692 |
| Example 24 | 74:2-91 | 1:1 | 2.44 | 3.80 | 75.22 | (0.685, 0.315) | 712 |
| Example 25 | 92:2-83 | 1:1 | 2.44 | 3.67 | 68.51 | (0.685, 0.314) | 683 |
| Example 26 | 122:2-77 | 1:1 | 2.39 | 3.54 | 67.91 | (0.685, 0.314) | 911 |
| Example 27 | 160:2-170 | 1:1 | 2.45 | 3.63 | 68.88 | (0.686, 0.313) | 713 |
| Example 28 | 179:2-70 | 1:1 | 2.55 | 3.85 | 70.23 | (0.687, 0.312) | 698 |
| Example 29 | 213:2-119 | 1:1 | 2.54 | 3.78 | 72.14 | (0.685, 0.315) | 681 |
| Example 30 | 233:2-83 | 1:1 | 2.51 | 3.71 | 74.22 | (0.686, 0.313) | 676 |
| Example 31 | 263:2-85 | 1:1 | 3.02 | 4.82 | 52.02 | (0.686, 0.313) | 391 |
| Example 32 | 282:2-120 | 1:1 | 2.44 | 3.50 | 71.48 | (0.685, 0.315) | 603 |
| Example 33 | 290:2-22 | 1:1 | 2.48 | 3.61 | 73.29 | (0.685, 0.315) | 624 |
| Example 34 | 296:2-83 | 1:1 | 2.49 | 3.51 | 67.11 | (0.687, 0.312) | 652 |
| Example 35 | 322:2-22 | 1:1 | 2.39 | 3.44 | 70.25 | (0.686, 0.313) | 686 |
| Example 36 | 325:2-96 | 1:1 | 2.41 | 3.57 | 69.23 | (0.686, 0.313) | 637 |
| Example 37 | 332:2-85 | 1:1 | 2.45 | 3.63 | 67.91 | (0.686, 0.313) | 622 |
| Example 38 | 358:2-85 | 1:1 | 2.49 | 3.74 | 70.14 | (0.687, 0.312) | 579 |
| Example 39 | 366:2-83 | 1:1 | 2.52 | 3.75 | 68.22 | (0.686, 0.313) | 608 |
| Example 40 | 400:2-85 | 1:1 | 2.51 | 3.69 | 67.11 | (0.685, 0.315) | 533 |
| Example 41 | 401:2-22 | 1:1 | 2.25 | 3.42 | 78.35 | (0.686, 0.313) | 821 |
| Example 42 | 408:2-66 | 1:1 | 2.29 | 3.24 | 82.94 | (0.687, 0.312) | 709 |
| Example 43 | 409:2-70 | 1:1 | 2.34 | 3.47 | 80.21 | (0.686, 0.313) | 817 |
| Example 44 | 413:2-103 | 1:1 | 2.43 | 3.67 | 79.23 | (0.685, 0.315) | 679 |
| Example 45 | 418:2-146 | 1:1 | 2.38 | 3.56 | 81.08 | (0.685, 0.315) | 702 |
| Example 46 | 422:2-85 | 1:1 | 2.84 | 4.45 | 71.66 | (0.685, 0.315) | 721 |
| Example 47 | 433:2-85 | 1:1 | 3.51 | 5.08 | 48.32 | (0.685, 0.315) | 398 |

In Table 8, Comparative Compounds U, V, W, X, Y and Z used in Comparative Examples 1 to 5 are as follows.

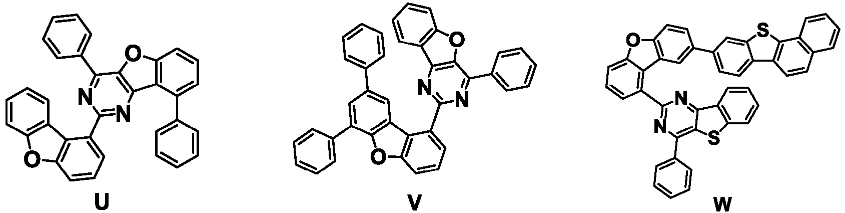

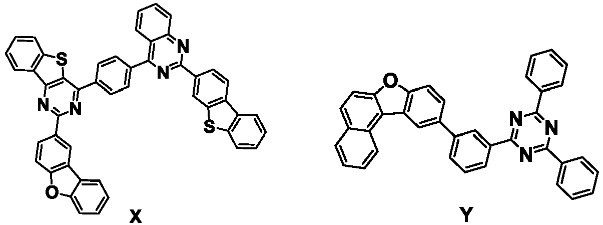

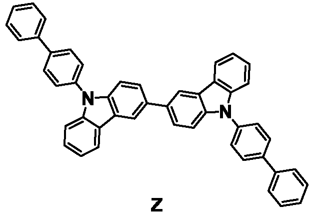

The heterocyclic compound of Chemical Formula 1 of the present invention has high thermal stability and appropriate molecular weight and band-gap. An appropriate band-gap of the light emitting layer prevents the loss of electrons and holes to help the effective formation of a recombination zone.

Therefore, as can be seen from the device evaluation in Table 8, it could be confirmed that the organic light emitting device using the heterocyclic compound represented by Chemical Formula 1 of the present invention alone exhibits improved performance compared to the organic light emitting device using Comparative Compounds U, V, W, X, Y and Z. However, it could be confirmed that the T₉₀, which is the service life of the device, was less than 150 hours, indicating that the service life characteristics were slightly low.

In addition, when the heterocyclic compound represented by Chemical Formula 2 of the present invention is used alone in an organic light emitting device, service life characteristics were good due to high thermal stability, but holes are not easily injected because the highest occupied molecular orbital (HOMO) level is high, so that it could be confirmed that the charge imbalance resulted in high driving voltage and low efficiency performance.

Conversely, when the heterocyclic compound represented by Chemical Formula 1 of the present invention and the heterocyclic compound represented by Chemical Formula 2 of the present invention are simultaneously used in an organic light emitting device, it could be confirmed that performance remarkably improved in terms of driving voltage, efficiency, and service life was exhibited.

That is, as can be seen from Table 8, the case where the combination of the heterocyclic compound represented by Chemical Formula 1 and the heterocyclic compound represented by Chemical Formula 2 is used as a light emitting layer in the organic light emitting device showed improved driving voltage, efficiency and service life characteristics compared to when the compound is used alone.

This corresponds to a result in which by using both the heterocyclic compound of Chemical Formula 1 of the present invention and the heterocyclic compound of Chemical Formula 2 of the present invention for the light emitting layer of the organic light emitting device, an acceptor with a good electron transport ability (n-host) and a donor with a good hole transport ability (p-host) can be used as hosts of the light emitting layer to lower the driving voltage at which electrons and holes are injected, and the efficiency and service life are improved through the effective formation of a recombination zone.

### <Experimental Example> Manufacture of organic light emitting device (2stack Red N+P mixed host)

A glass substrate, in which indium tin oxide (ITO) was thinly coated to have a thickness of 1,500 Å, was ultrasonically washed with distilled water. When the washing with distilled water was finished, the glass substrate was ultrasonically washed with a solvent such as acetone, methanol, and isopropyl alcohol, dried and then subjected to ultraviolet ozone (UVO) treatment for 5 minutes using UV in an ultraviolet (UV) washing machine. Thereafter, the substrate was transferred to a plasma washing machine (PT), and then was subjected to plasma treatment in a vacuum state for an ITO work function and in order to remove a residual film, and was transferred to a thermal deposition apparatus for organic deposition.

A hole injection layer 4,4',4"-tris[2-naphthyl(phenyl)amino]triphenylamine (2-TNATA) and a hole transport layer N,N'-di(1-naphthyl)-N,N'-diphenyl-(1,1'-biphenyl)-4,4'-diamine (NPB), which are common layers, were formed on the ITO transparent electrode (positive electrode).

A light emitting layer was thermally vacuum deposited thereon as follows. The light emitting layer was deposited to have a thickness of 400 Å by using a compound described in the following Table 9 as a red host and (piq)₂(Ir) (acac) as a red phosphorescent dopant to dope the host with (piq)₂(Ir) (acac) in an amount of 2%.

Thereafter, Alq₃ was deposited to have a thickness of 120 Å as an electron transport layer, Bphen was deposited to have a thickness of 120 Å as an N-type charge generation layer thereon, and MoO₃ was also deposited to have a thickness of 100 Å as a P-type charge generation layer thereon. Subsequently, a hole transport layer N,N'-Di(1-naphthyl)-N,N'-diphenyl-(1,1'-biphenyl)-4,4'-diamine (NPB) was formed.

A light emitting layer was thermally vacuum deposited thereon as follows. The light emitting layer was deposited to have a thickness of 400 Å by using a compound described in the following Table 9 as a red host and (piq)₂(Ir) (acac) as a red phosphorescent dopant to dope the host with (piq)₂(Ir) (acac) in an amount of 2%.

Thereafter, Alq₃ was deposited to have a thickness of 300 Å as an electron transport layer. Finally, lithium fluoride (LiF) was deposited to have a thickness of 20 Å on the electron transport layer to form an electron injection layer, and then aluminum (Al) negative electrode was deposited to have a thickness of 1,200 Å on the electron injection layer to form a negative electrode, thereby manufacturing an organic electroluminescence device.

Meanwhile, all the organic compounds required for manufacturing an OLED device were subjected to vacuum sublimed purification under 10⁻⁶ to 10⁻⁸ torr for each material, and used for the manufacture of OLED.

For the organic electroluminescence device manufactured as described above, electroluminescence (EL) characteristics were measured by M7000 manufactured by McScience Inc., and based on the measurement result thereof, T₉₀ was measured by a service life measurement equipment (M6000) manufactured by McScience Inc., when the reference luminance was 6,000 cd/m². Characteristics of the organic electroluminescence device of the present invention are as shown in the following Table 9. The ratios in the following Table 9 mean weight ratios. For example, the case of Example 48 means that Compound 22 and Compound 2-83 are used at a weight ratio of 2:1.

**[Table 9]**

| | Compound | Ratio (N:P) | Turn-on (V) | Driving voltage (V) | efficiency (cd/A) | Color coordinate (x, y) | Service life (T₉₀) |
|---|---|---|---|---|---|---|---|
| Comparative Example 69 | 22 | - | 4.46 | 5.61 | 93.75 | (0.686, 0.313) | 160 |
| Comparative Example 70 | 43 | - | 3.88 | 5.24 | 84.28 | (0.685, 0.315) | 183 |
| Comparative Example 71 | 49 | - | 4.02 | 5.31 | 98.11 | (0.686, 0.313) | 199 |
| Comparative Example 72 | 2-83 | - | 5.24 | 6.20 | 71.50 | (0.685, 0.315) | 341 |
| Comparative Example 73 | 2-85 | - | 5.32 | 6.33 | 70.64 | (0.686, 0.313) | 387 |
| Example 48 | 22:2-83 | 2:1 | 3.70 | 4.98 | 129.39 | (0.686, 0.313) | 790 |
| Example 49 | | 1:1 | 3.51 | 4.43 | 135.83 | (0.686, 0.313) | 950 |
| Example 50 | | 1:2 | 3.53 | 4.79 | 128.36 | (0.686, 0.313) | 800 |
| Example 51 | 43:2-85 | 2:1 | 3.68 | 4.90 | 123.08 | (0.686, 0.313) | 873 |
| Example 52 | | 1:1 | 3.36 | 4.59 | 130.21 | (0.686, 0.313) | 1082 |
| Example 53 | | 1:2 | 3.55 | 4.65 | 119.88 | (0.686, 0.313) | 954 |
| Example 54 | 49:2-85 | 1:1 | 3.40 | 4.51 | 138.37 | (0.686, 0.313) | 1128 |

As can be seen from the device evaluation, the case of 2-stack is the case where the light emitting layer is deposited twice, and it could be confirmed that efficiency and service life are increased compared to a single light emitting layer.

Furthermore, similarly in Table 9, through the device evaluation results of the combination of the heterocyclic compound of Chemical Formula 1 and the heterocyclic compound of Chemical Formula 2, it could be confirmed that when the compound corresponding to the above invention is used as the light emitting layer of the organic light emitting device, effects excellent in driving voltage, efficiency, and service life characteristics were exhibited compared to the case where the compound was not used as the light emitting layer of the organic light emitting device.

This shows the results that when a donor with a hole transport ability (p-host) and an acceptor with an electron transport ability (n-host) are used as hosts of the light emitting layer, the driving voltage at which electrons and holes are injected can be lowered, and the efficiency and service life are improved through the formation of a recombination zone.

### <Explanation of Reference Numerals and Symbols>

- 100:: Substrate
- 200:: Positive electrode
- 300:: Organic material layer
- 301:: Hole injection layer
- 302:: Hole transport layer
- 303:: Light emitting layer
- 304:: Hole blocking layer
- 305:: Electron transport layer
- 306:: Electron injection layer
- 400:: Negative electrode

## Claims

1. An organic light emitting device comprising a first electrode, a second electrode and an organic material layer having one or more layers provided between the first electrode and the second electrode, wherein one or more layers of the organic material layer comprise a heterocyclic compound represented by the following Chemical Formula 1 and a heterocyclic compound represented by the following Chemical Formula 2: 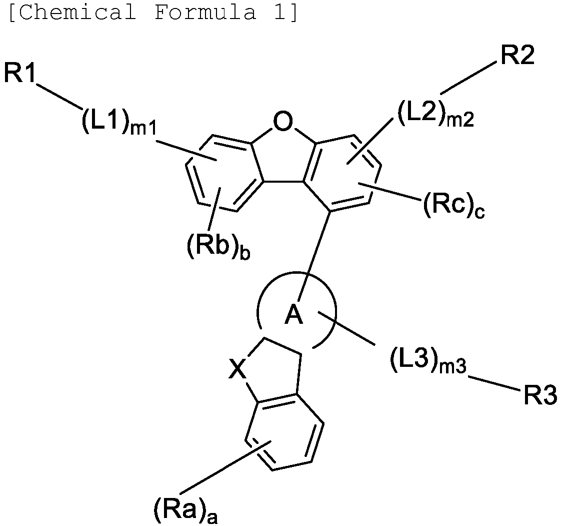 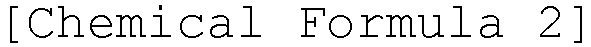 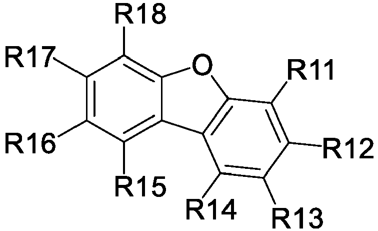 in Chemical Formula 1,
X is O; or S,
A is a pyrimidine ring group,
L1 to L3 are the same as or different from each other, and are each independently a direct bond; a substituted or unsubstituted C6 to C60 arylene group; or a substituted or unsubstituted C2 to C60 heteroarylene group, m1 to m3 are each independently an integer from 0 to 3, and when m1 to m3 are each 2 or higher, substituents in the parenthesis are the same as or different from each other,
R1 and R2 are the same as or different from each other, and are each independently hydrogen; deuterium; or a substituted or unsubstituted C6 to C60 aryl group,
R3 is a C6 to C60 aryl group; or a substituted or unsubstituted C2 to C60 heteroaryl group,
Ra to Rc are the same as or different from each other, and are each independently hydrogen; deuterium; a halogen group; a cyano group; or a substituted or unsubstituted alkyl group having 1 to 60 carbon atoms, a is an integer from 0 to 3, and when a is an integer of 2 or higher, Ra's in the parenthesis are the same as or different from each other, b is an integer from 0 to 2, and when b is 2, Rb's in the parenthesis are the same as or different from each other, and c is an integer from 0 to 4, and when c is an integer of 2 or higher, Re's in the parenthesis are the same as or different from each other,
in Chemical Formula 2,
one of R11 to R18 is a group represented by the following Chemical Formula A, one of the others is a group represented by the following Chemical Formula B, and the rest are the same as or different from each other, and are each independently hydrogen; or deuterium, or bonded to an adjacent group to form a benzene ring, 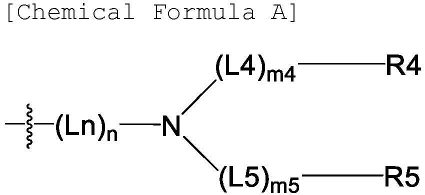 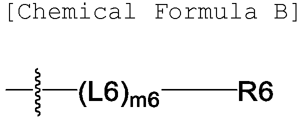
in Chemical Formulae A and B,
L4 to L6 and Ln are the same as or different from each other, and are each independently a direct bond; a substituted or unsubstituted C6 to C60 arylene group; or a substituted or unsubstituted C2 to C60 heteroarylene group, m4 to m6 and n are each independently an integer from 0 to 3, and when m4 to m6 and n are each 2 or higher, substituents in the parenthesis are the same as or different from each other,
R4 and R5 are the same as or different from each other, and are each independently a substituted or unsubstituted C6 to C60 aryl group; or a substituted or unsubstituted C2 to C60 heteroaryl group, or R4 and R5 are bonded to each other to form a ring,
R6 is a substituted or unsubstituted C6 to C60 aryl group; or a monocyclic or polycyclic heterocyclic group which is substituted or unsubstituted and includes one or more N's, and 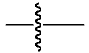
means a position bonded to Chemical Formula 2.

2. The organic light emitting device of claim 1, wherein Chemical Formula 1 is represented by the following Chemical Formula 1-1 or 1-2: 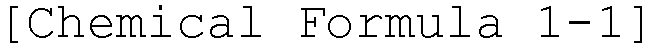 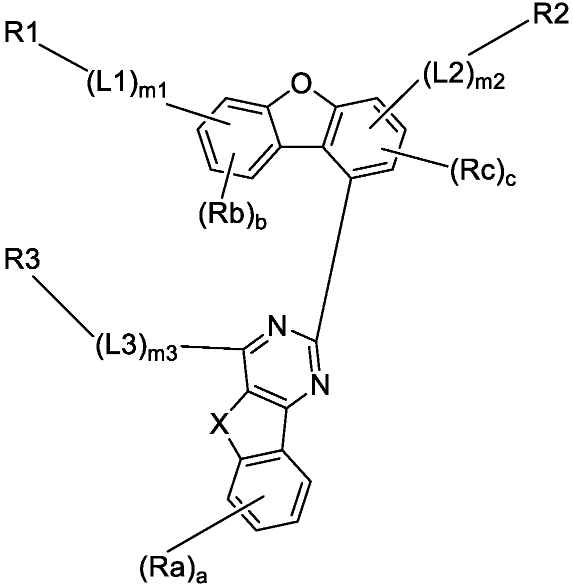 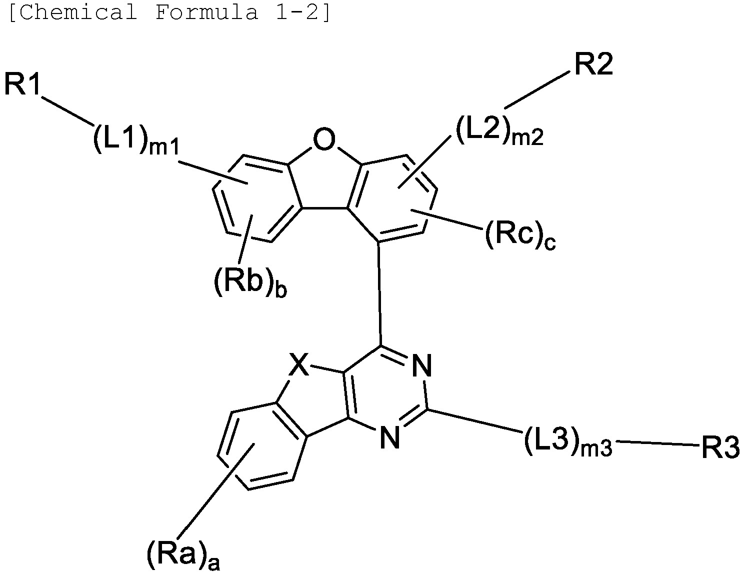 in Chemical Formulae 1-1 and 1-2, the definitions of X, L1 to L3, R1 to R3, Ra to Rc, m1 to m3, a, b and c are the same as those in Chemical Formula 1.

3. The organic light emitting device of claim 1, wherein Chemical Formula 2 is represented by any one of the following Chemical Formulae 2-1 to 2-4: 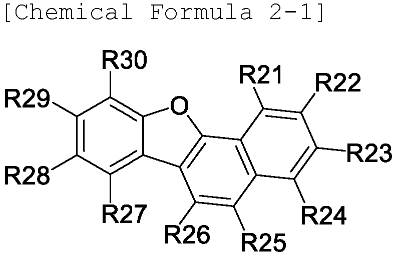 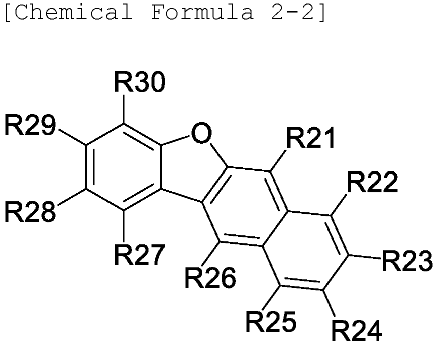 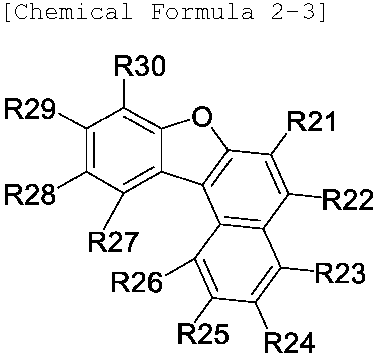 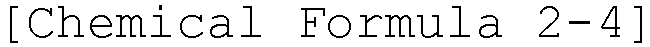 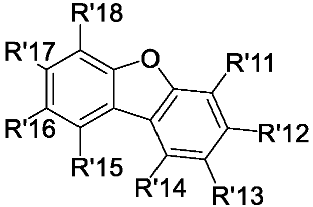
in Chemical Formulae 2-1 to 2-3, one of R21 to R30 is the group represented by Chemical Formula A, one of the others is the group represented by Chemical Formula B, and the rest are the same as or different from each other, and are each independently hydrogen; or deuterium, and
in Chemical Formula 2-4, one of R'11 to R'18 is the group represented by Chemical Formula A, one of the others is the group represented by Chemical Formula B, and the rest are the same as or different from each other, and are each independently hydrogen; or deuterium.

4. The organic light emitting device of claim 1, wherein when the heterocyclic compound represented by Chemical Formula 1 does not comprise deuterium, or
comprises deuterium, a deuterium content of the heterocyclic compound represented by Chemical Formula 1 is 10% or more and 100% or less.

5. The organic light emitting device of claim 1, wherein when the heterocyclic compound represented by Chemical Formula 2 does not comprise deuterium, or
comprises deuterium, a deuterium content of the heterocyclic compound represented by Chemical Formula 2 is 10% or more and 100% or less.

6. The organic light emitting device of claim 1, wherein Chemical Formula 1 is represented by any one of the following compounds:

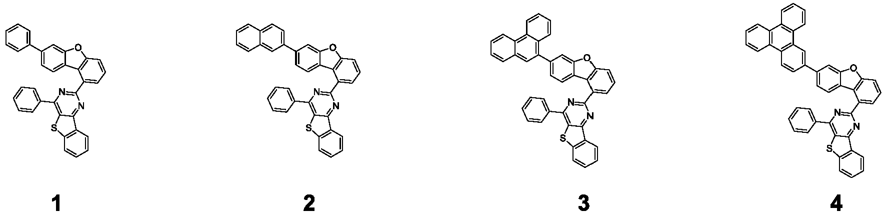

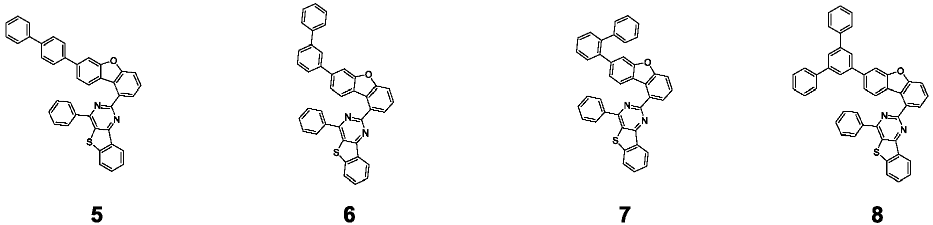

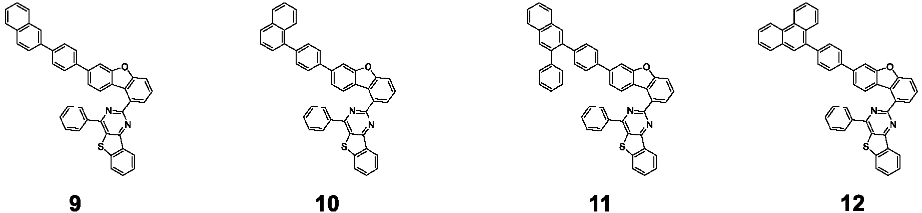

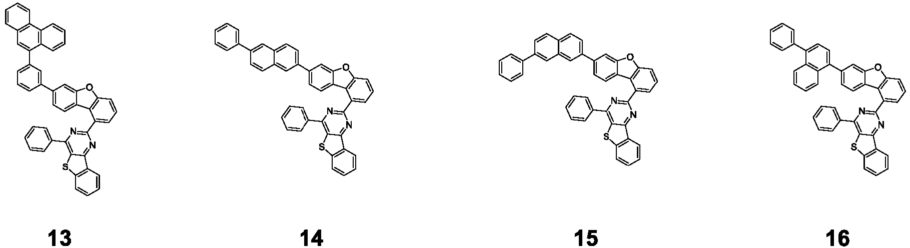

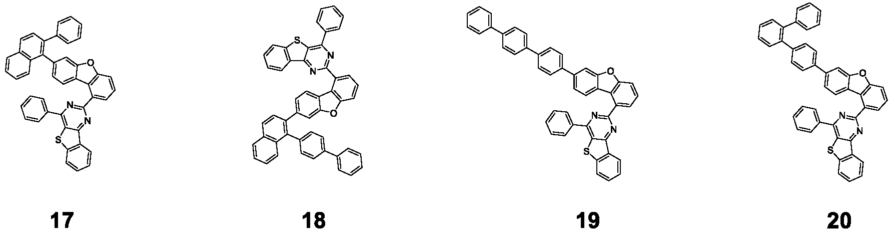

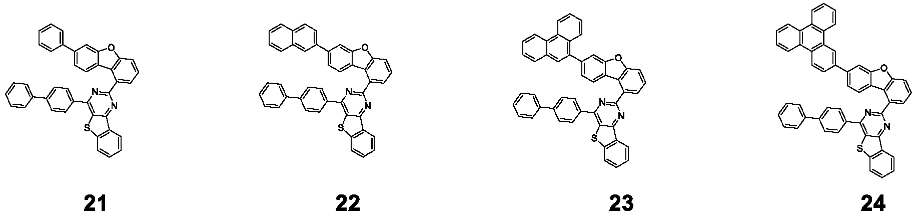

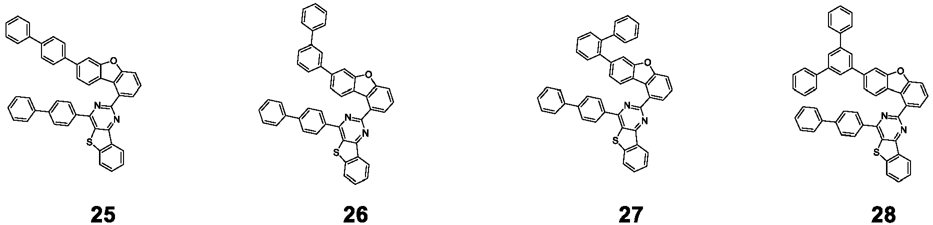

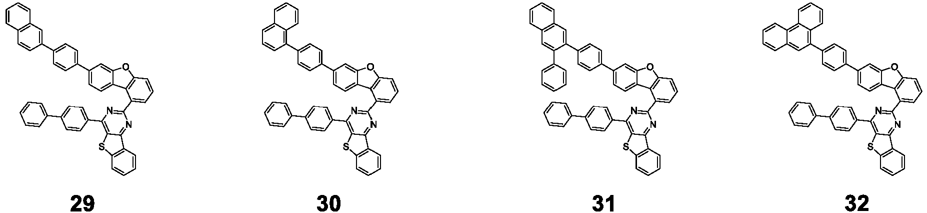

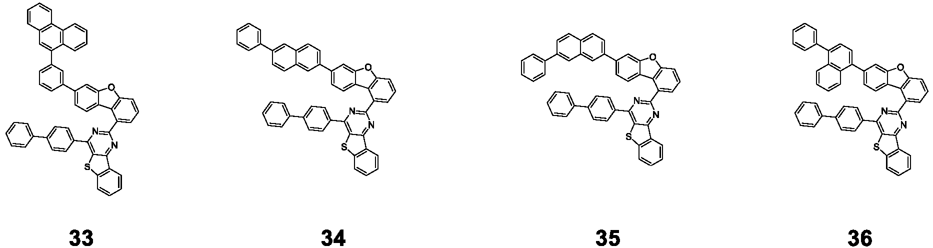

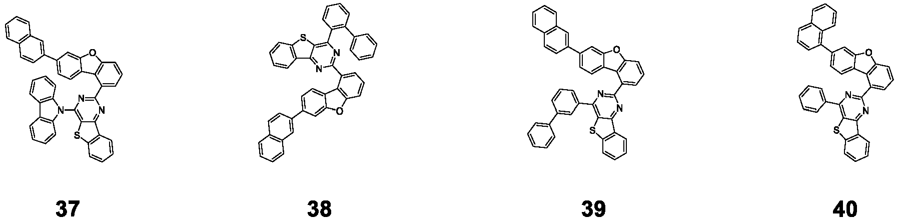

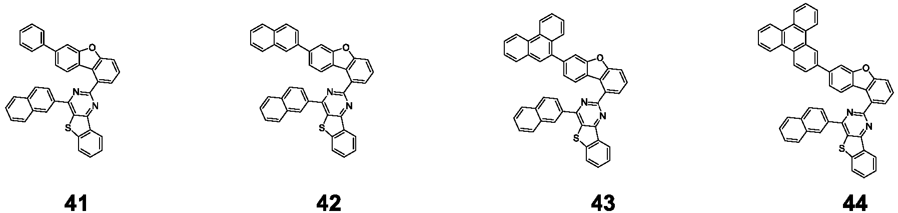

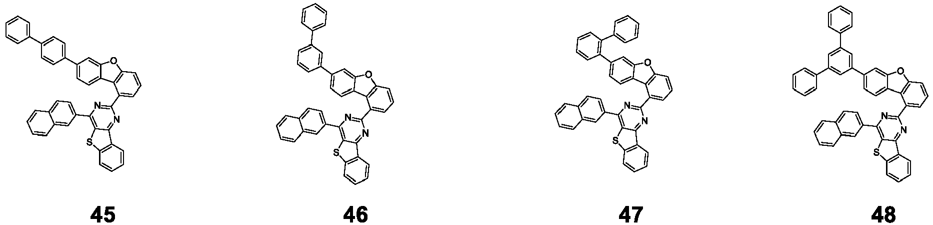

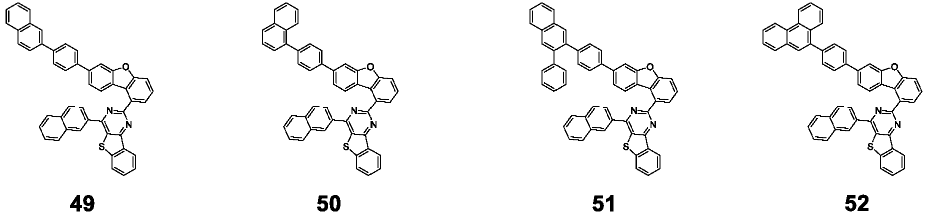

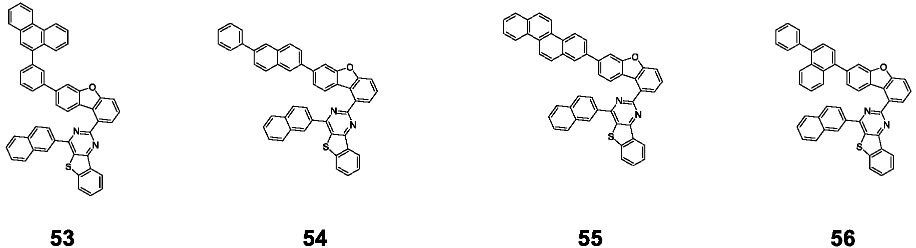

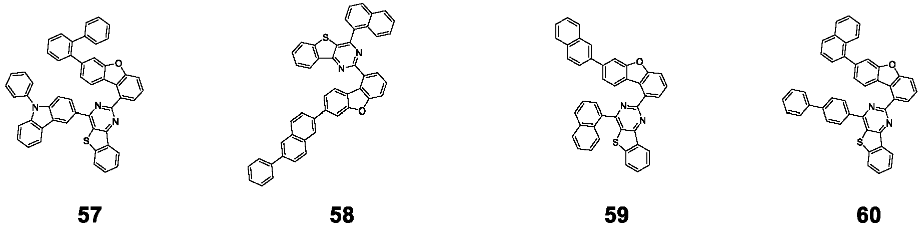

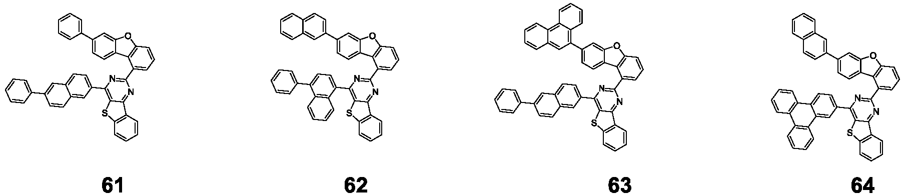

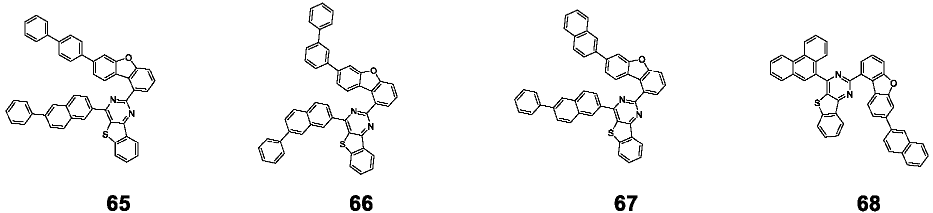

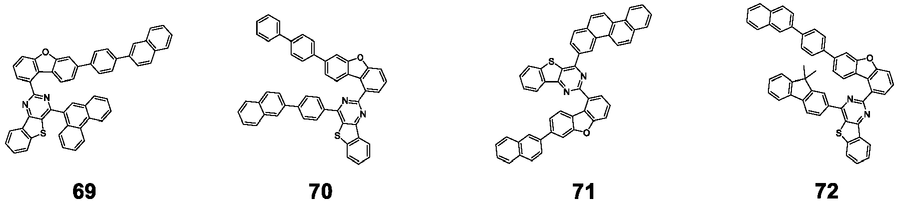

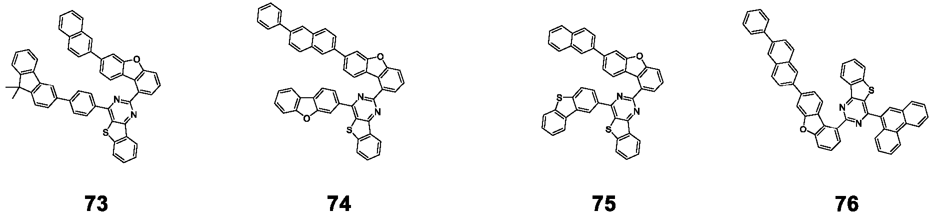

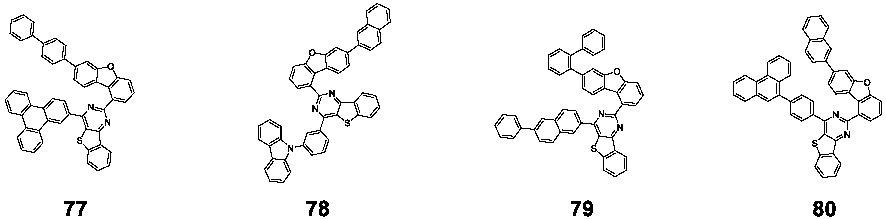

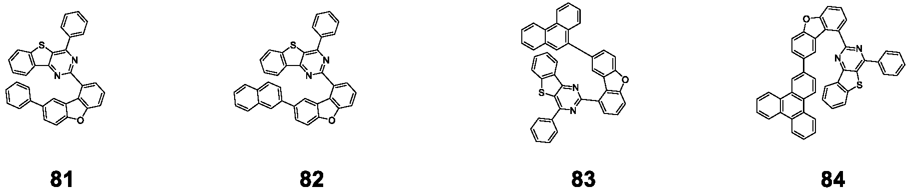

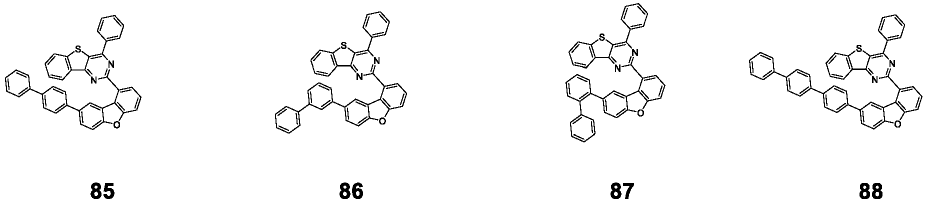

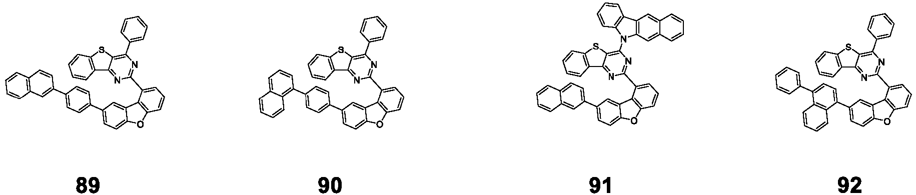

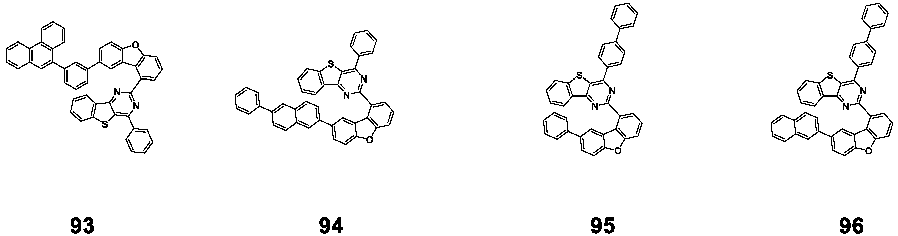

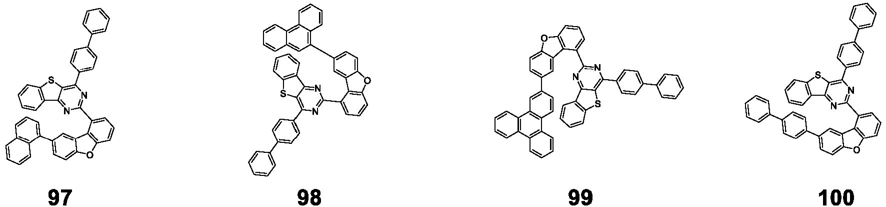

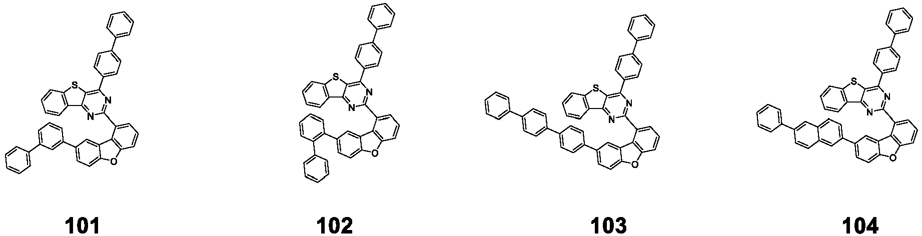

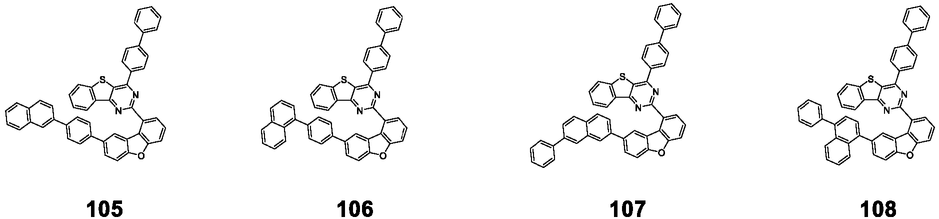

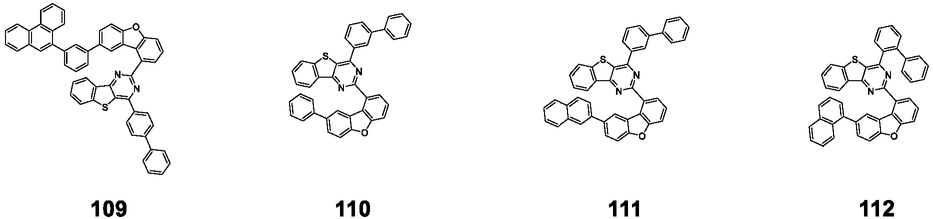

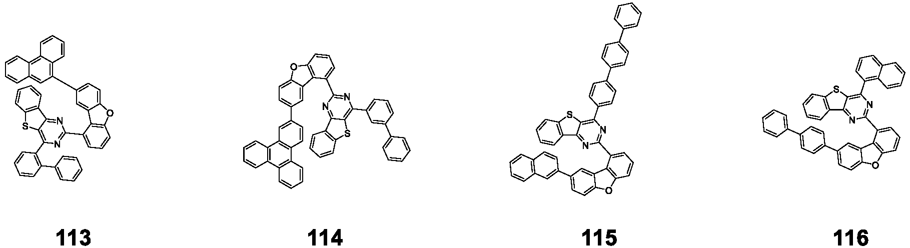

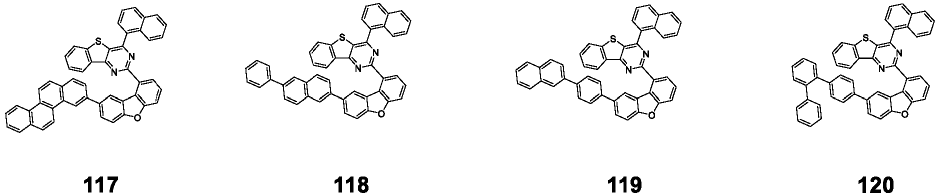

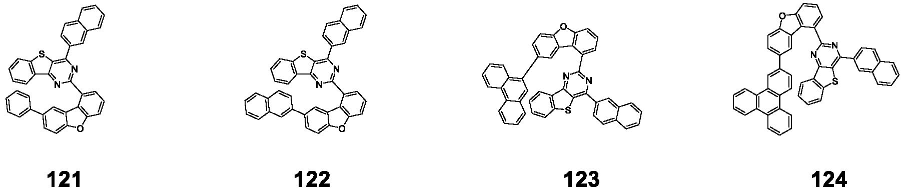

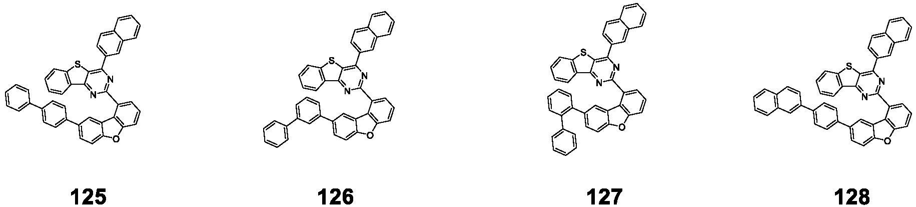

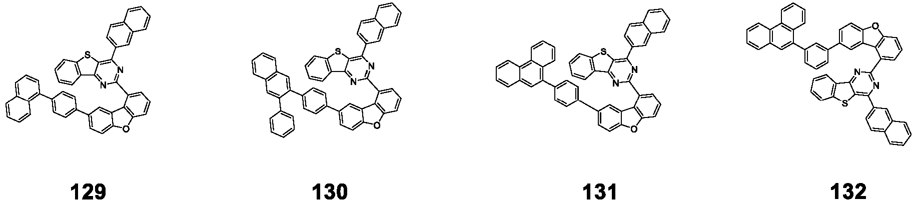

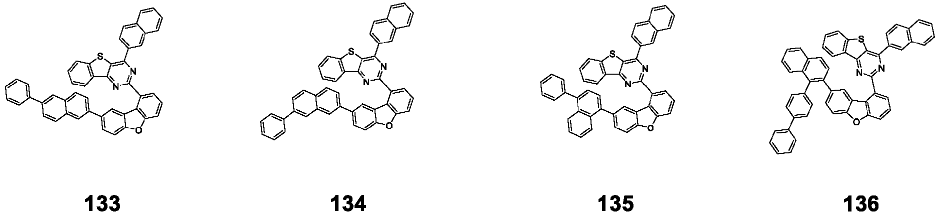

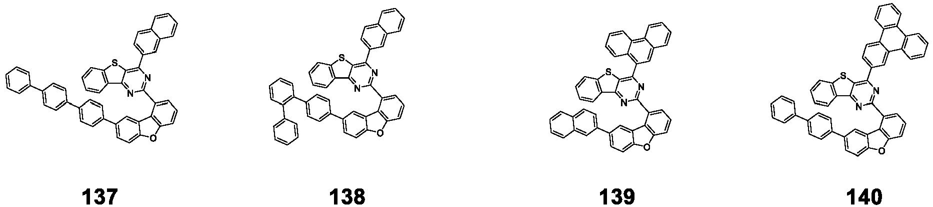

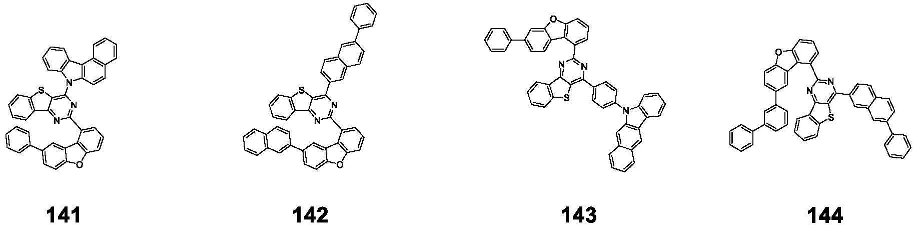

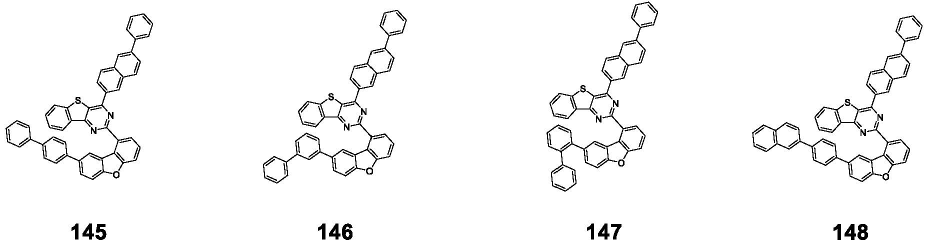

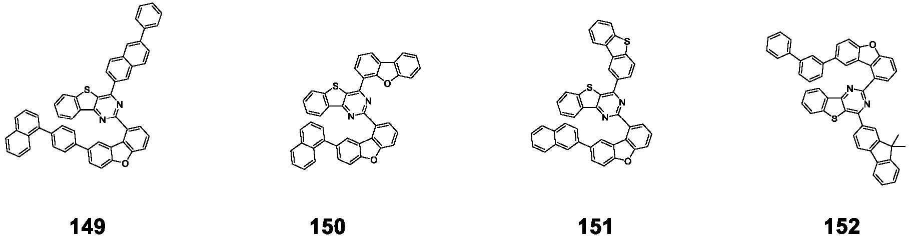

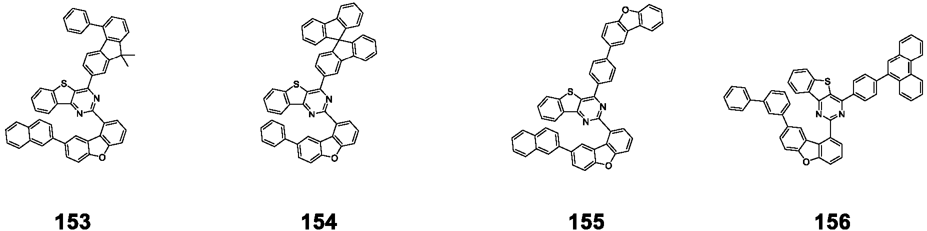

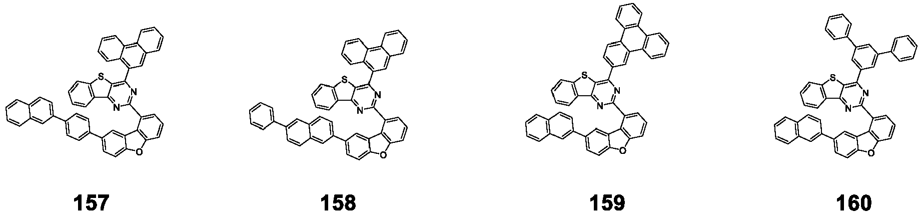

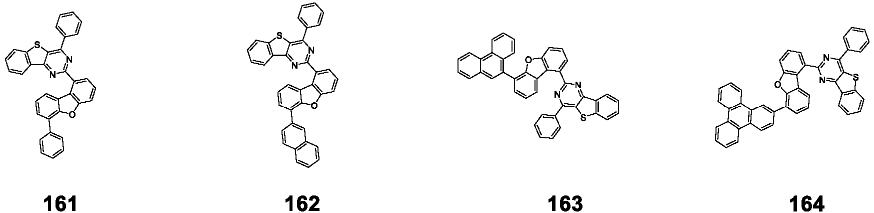

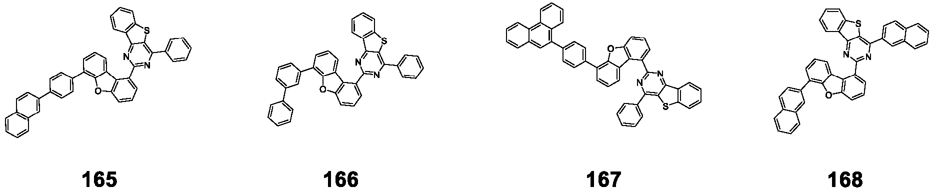

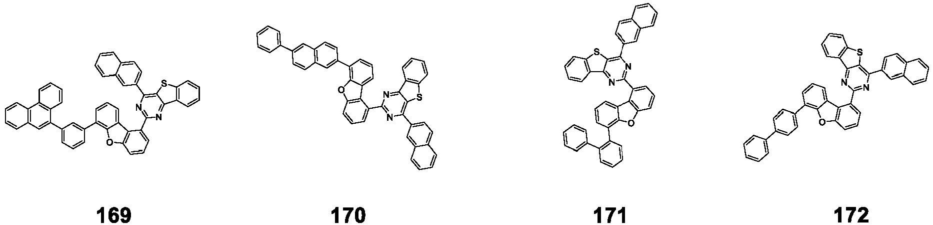

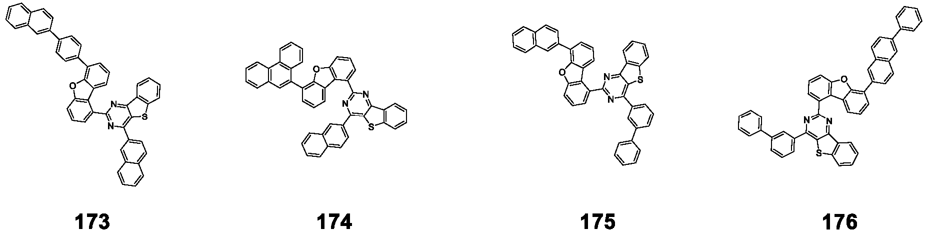

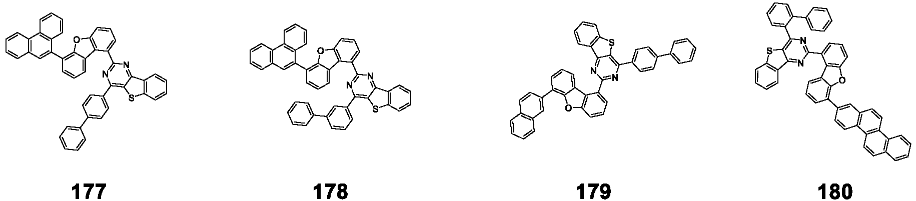

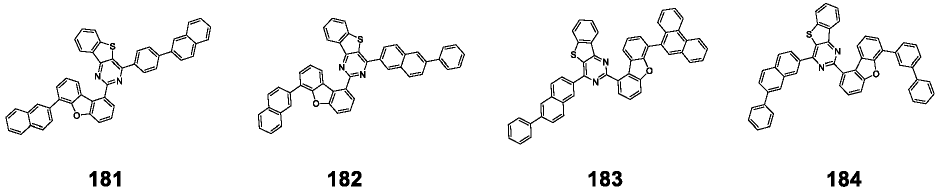

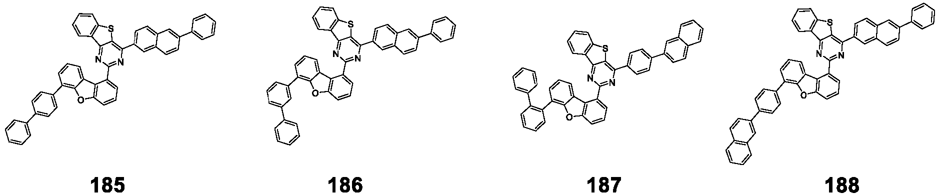

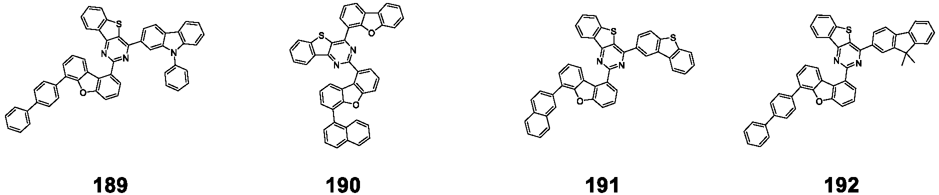

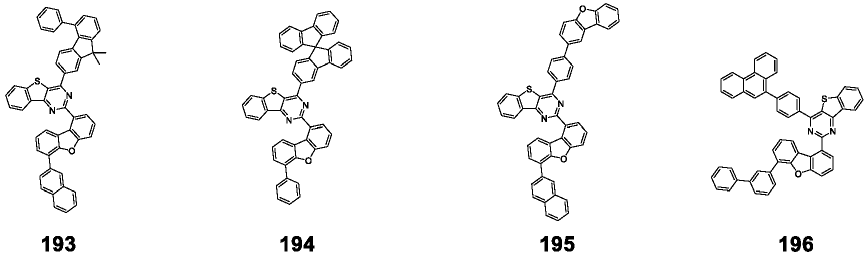

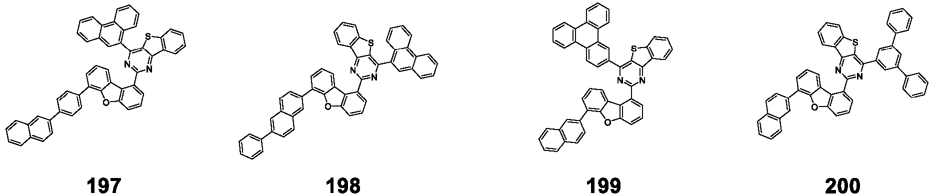

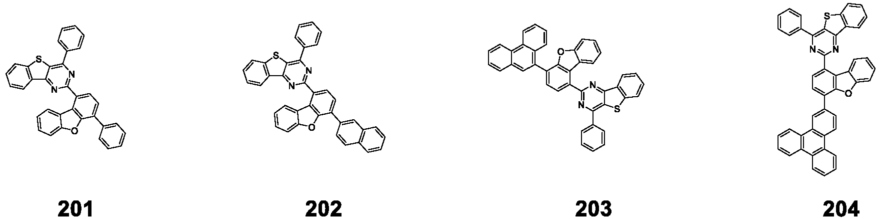

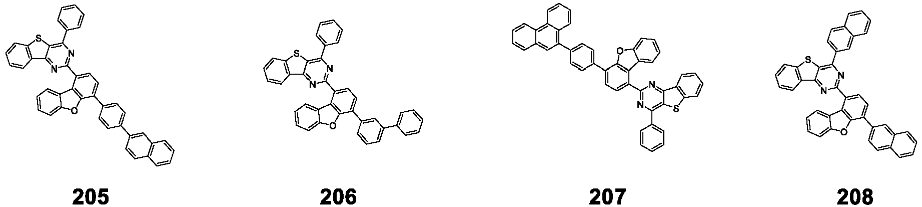

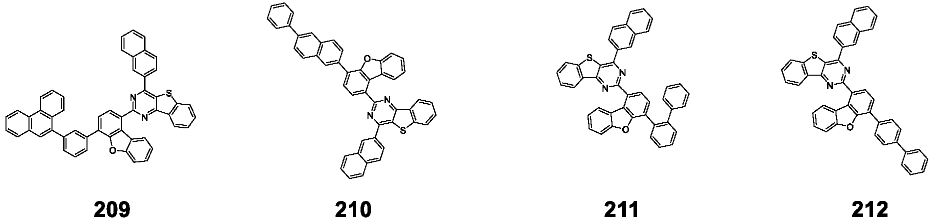

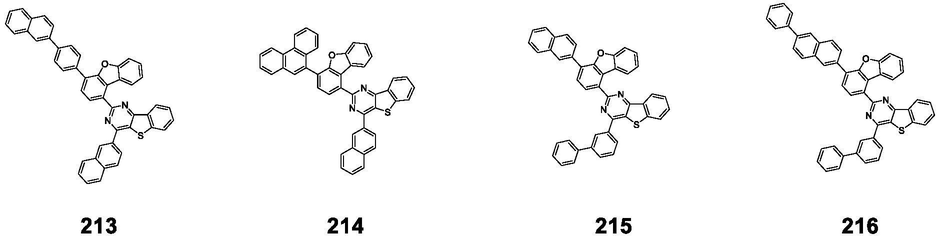

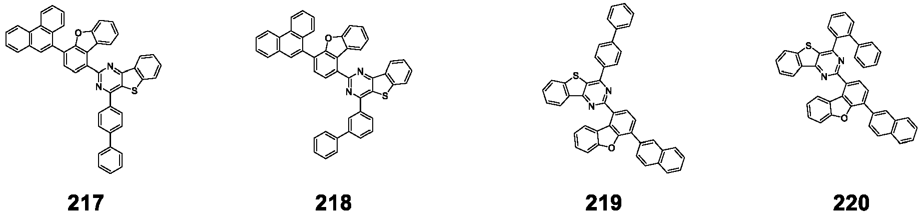

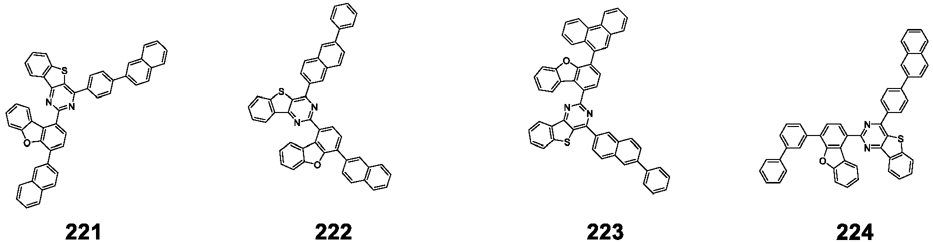

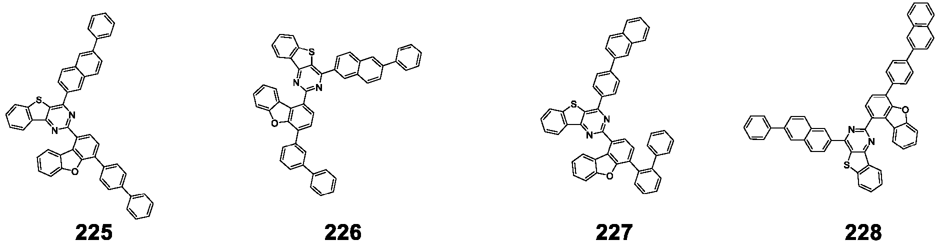

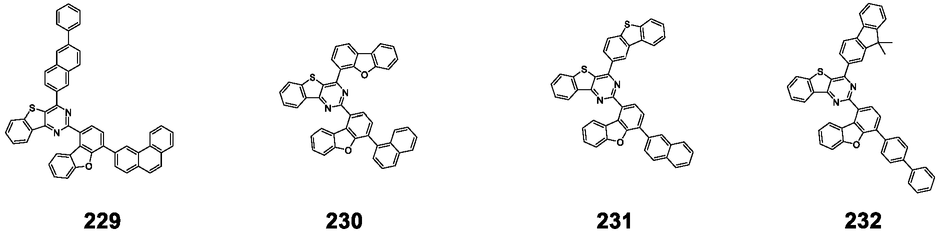

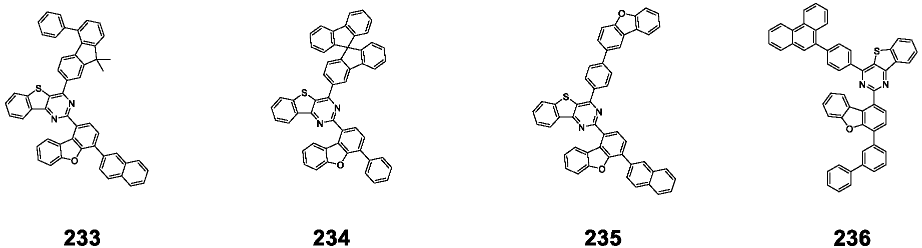

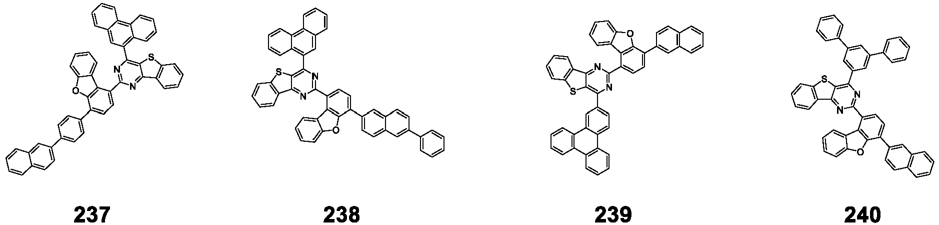

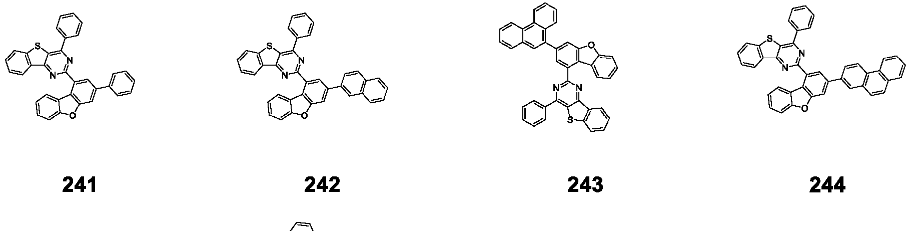

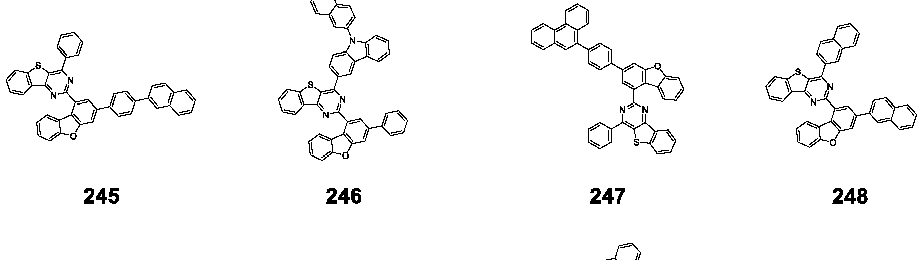

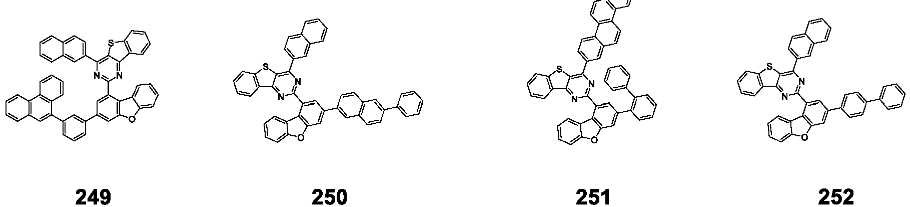

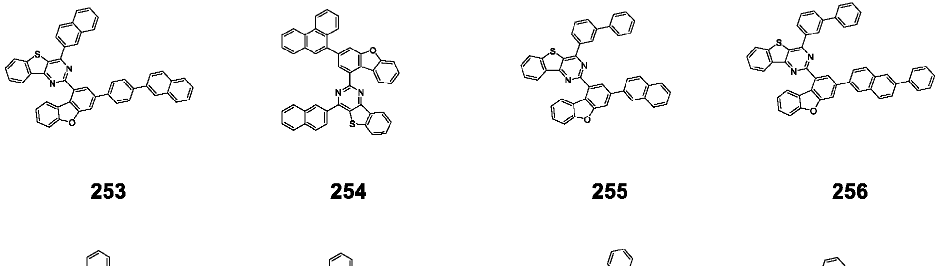

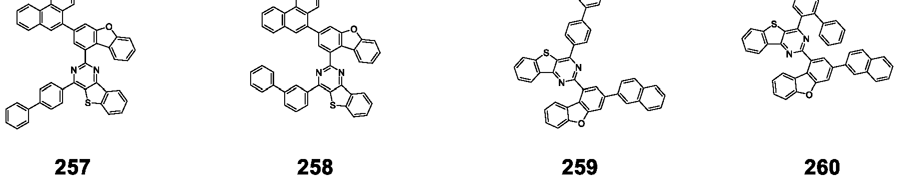

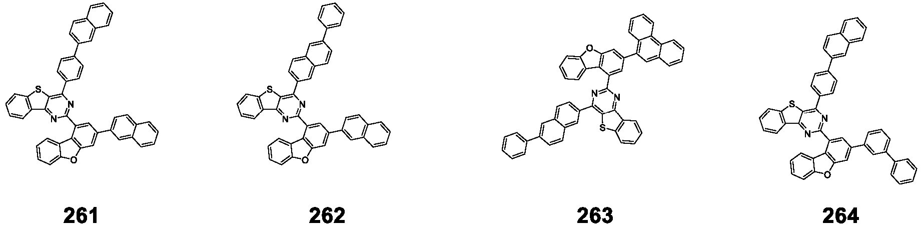

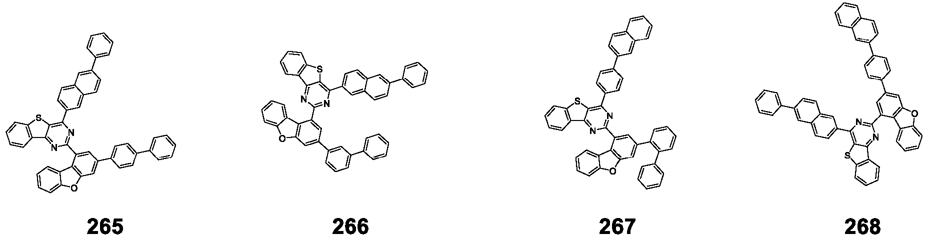

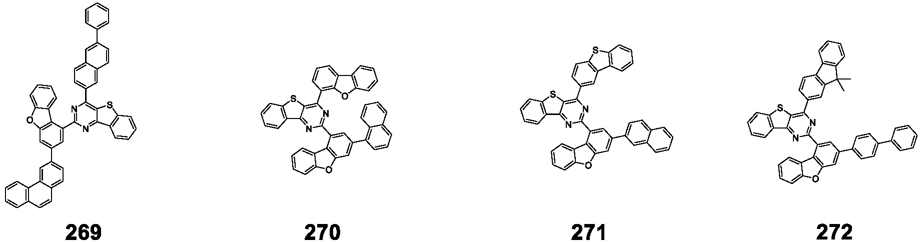

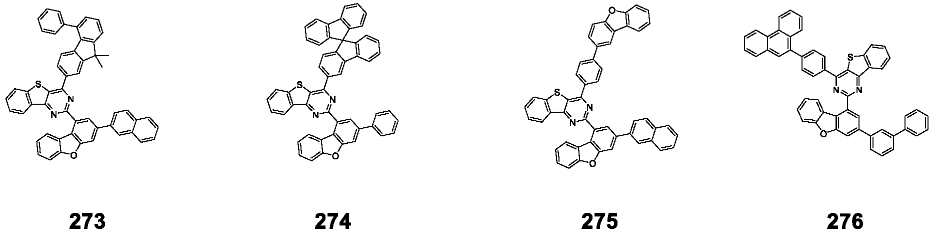

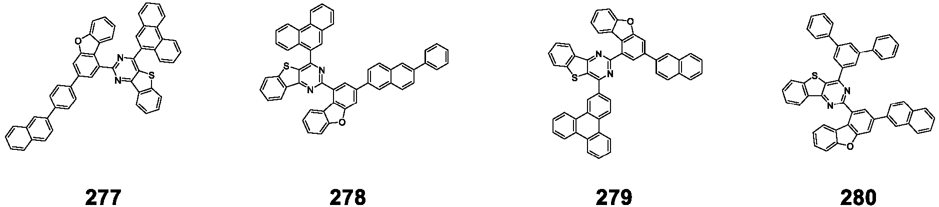

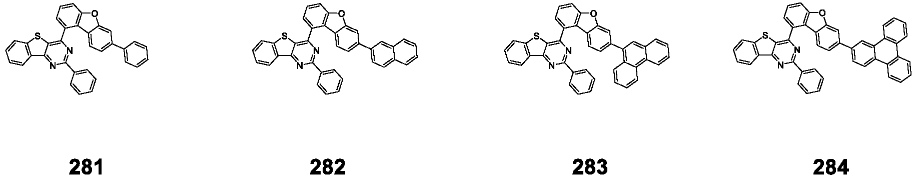

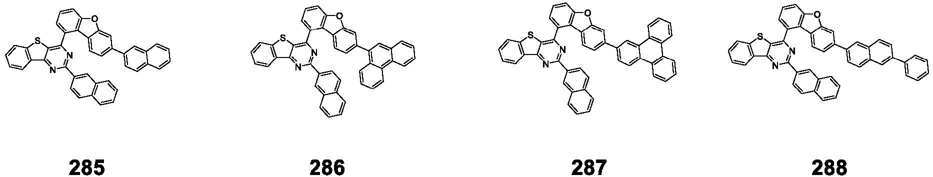

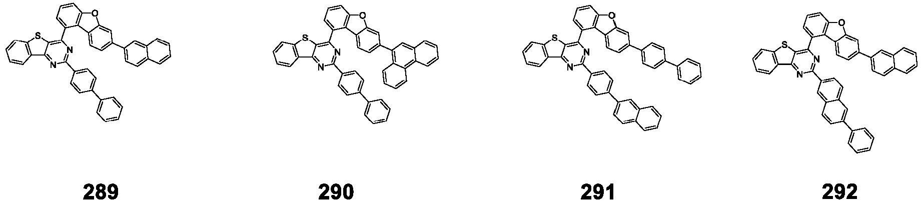

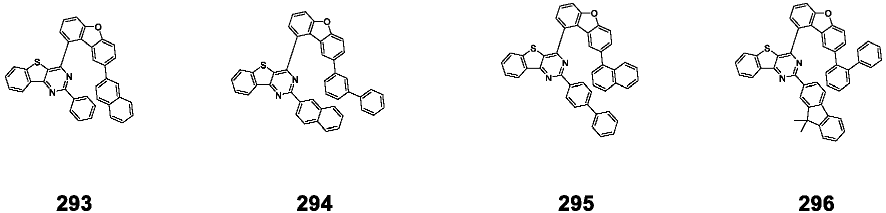

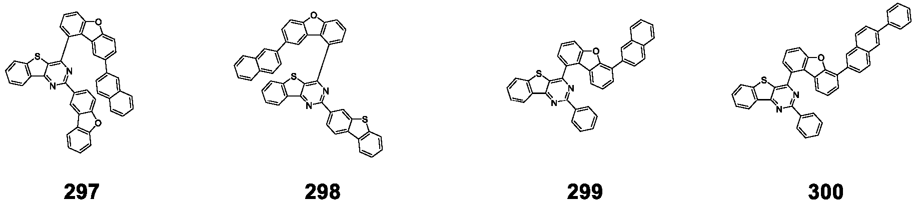

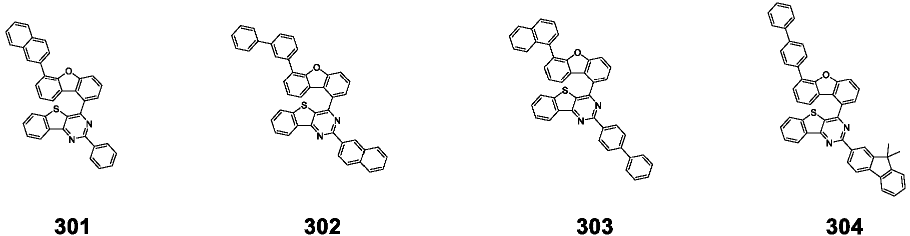

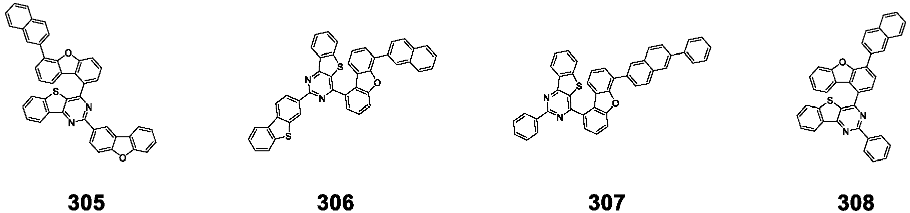

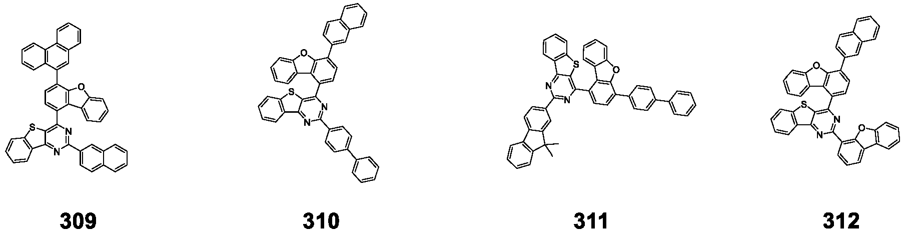

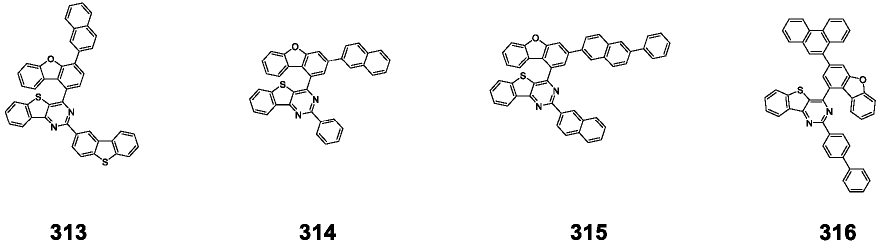

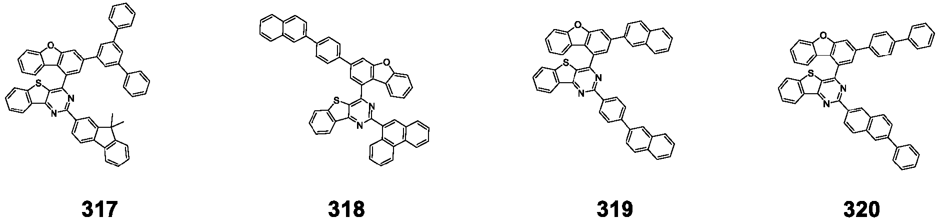

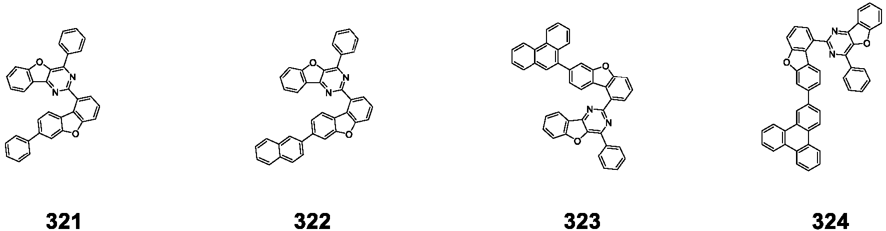

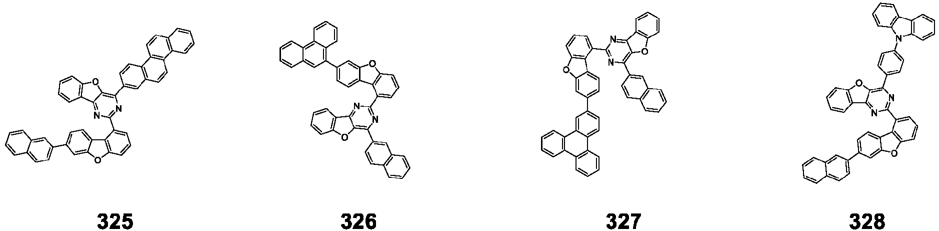

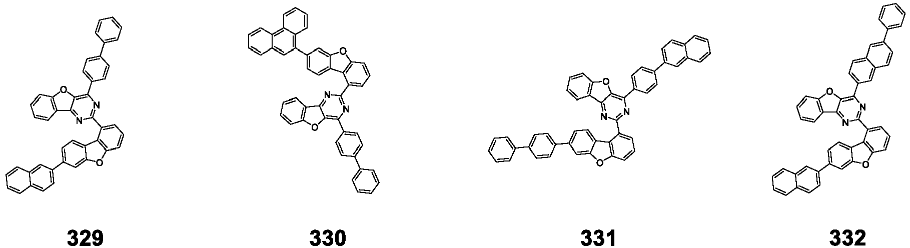

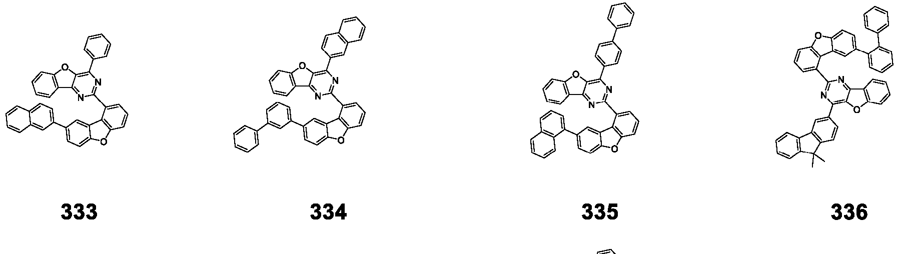

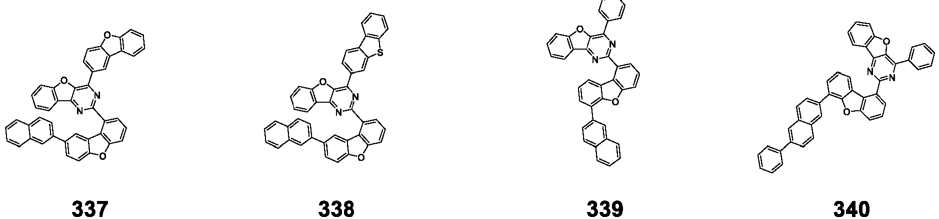

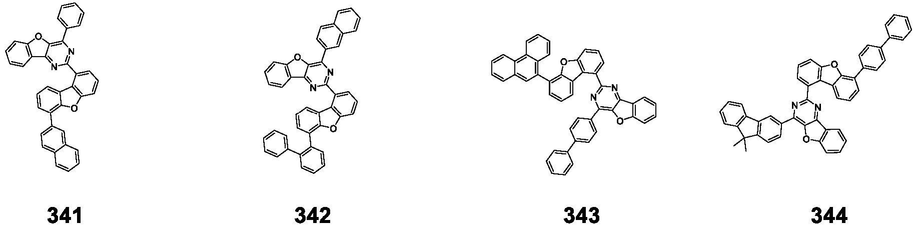

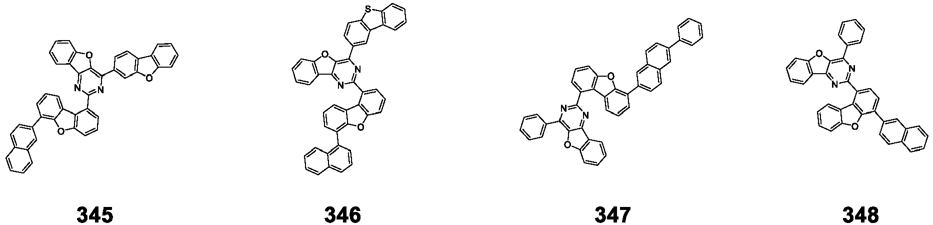

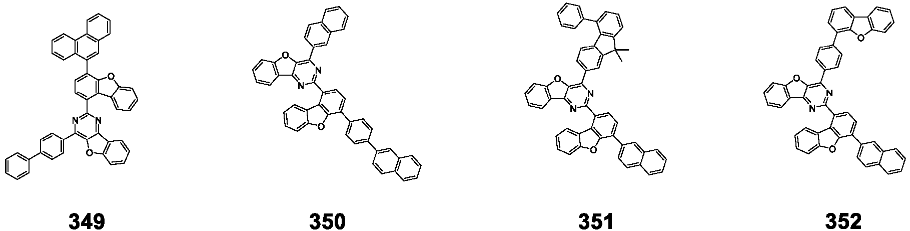

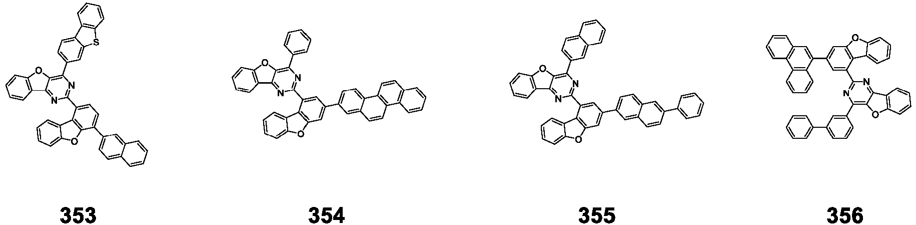

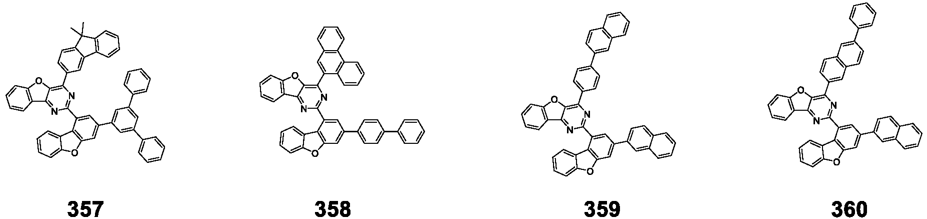

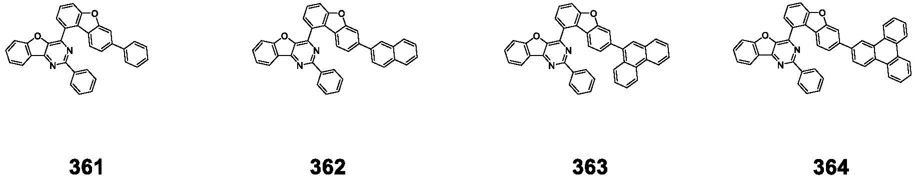

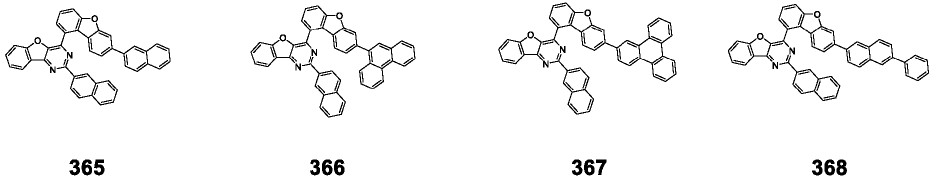

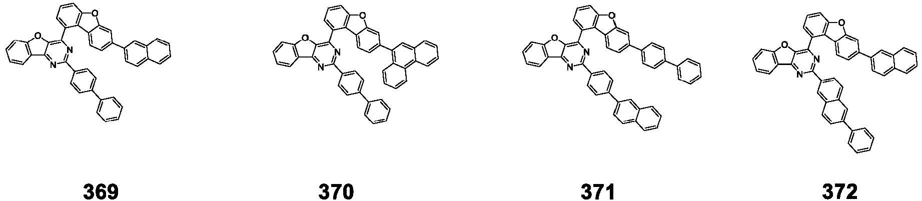

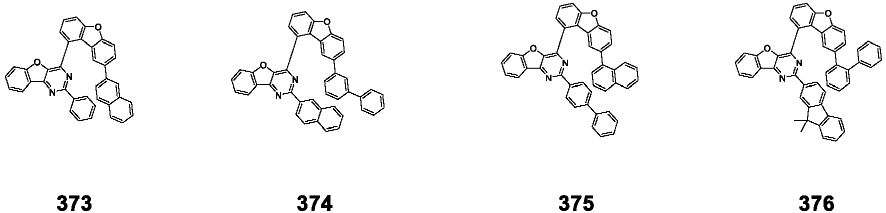

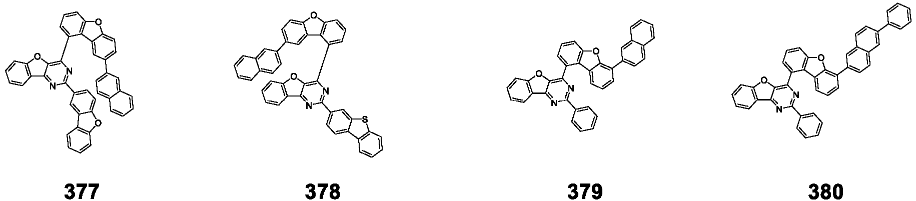

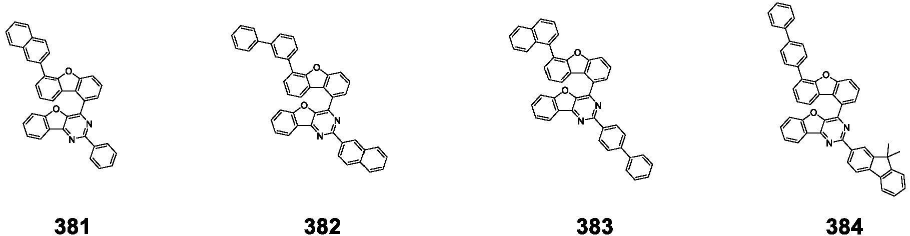

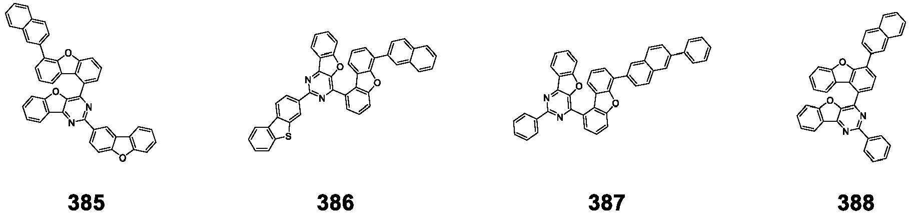

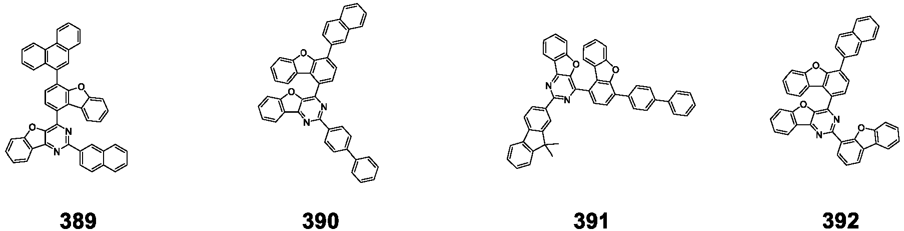

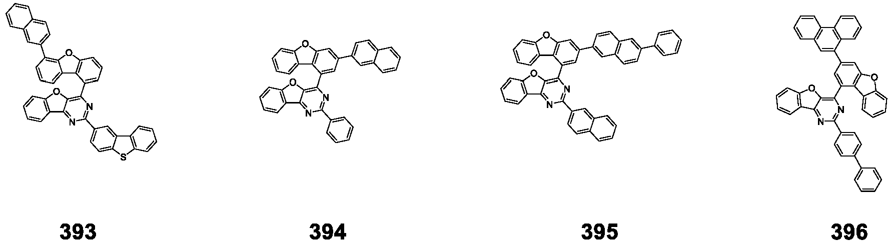

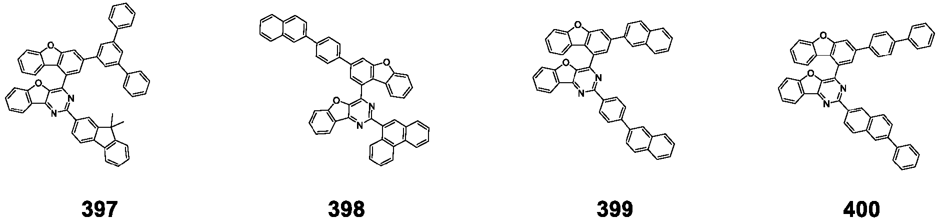

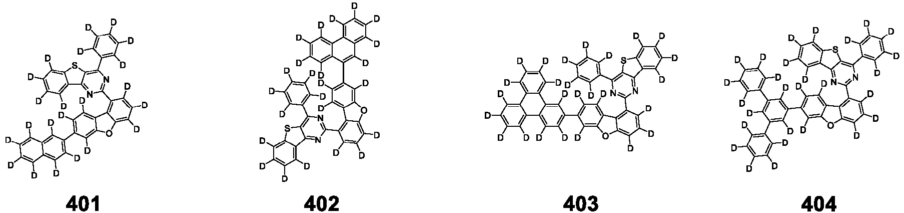

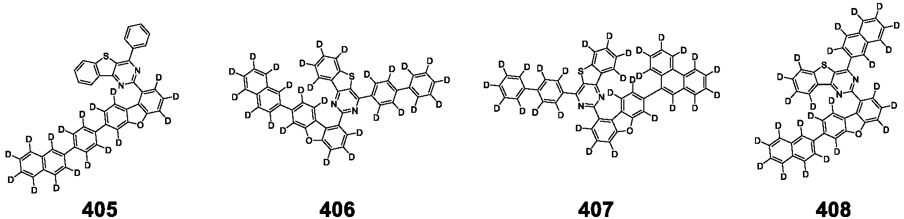

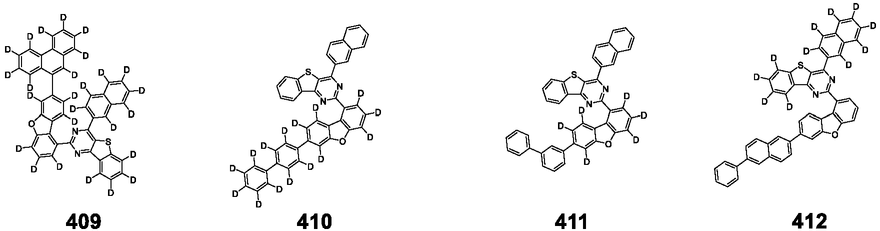

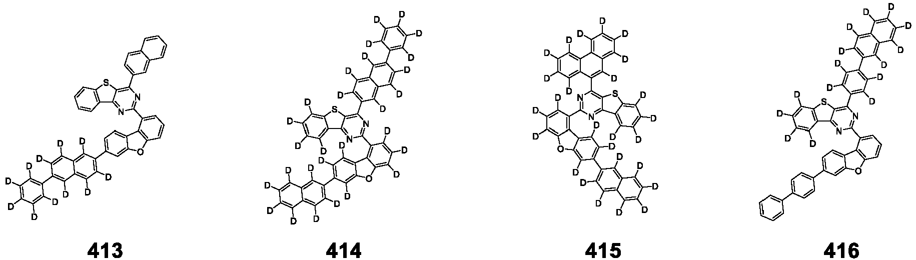

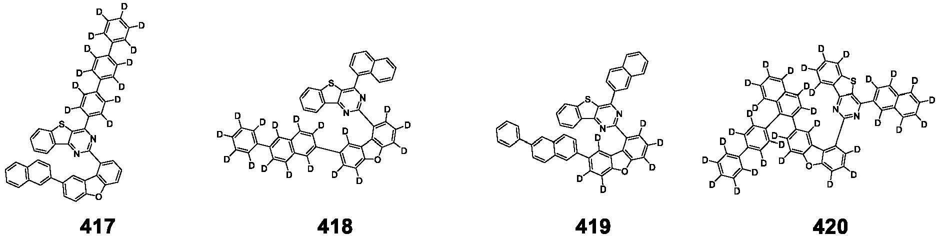

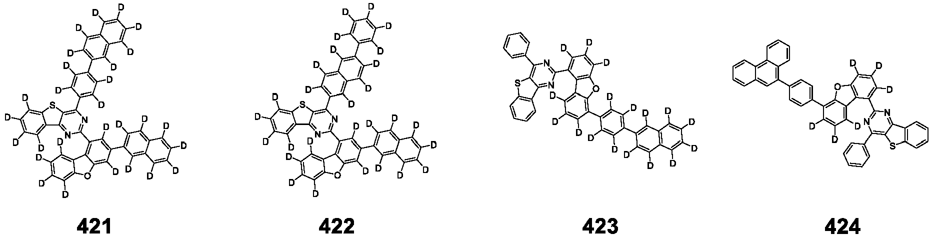

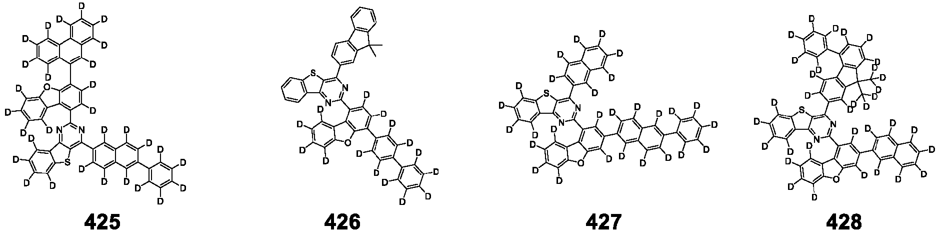

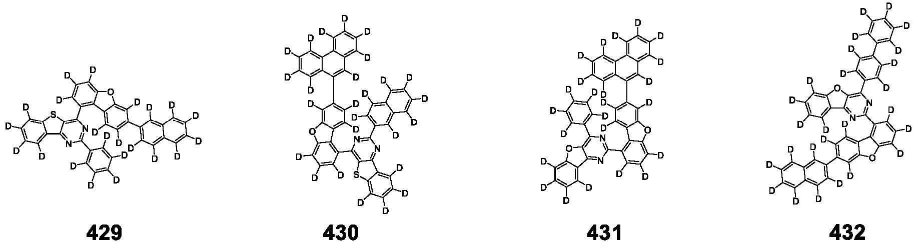

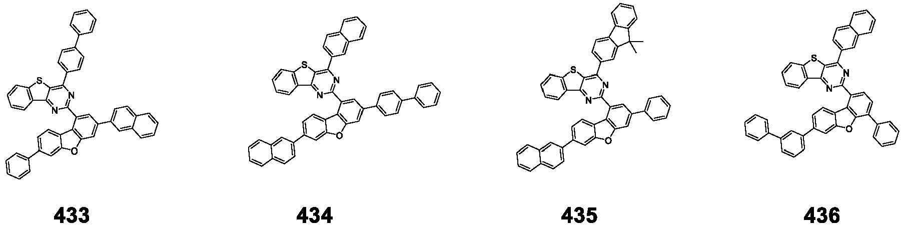

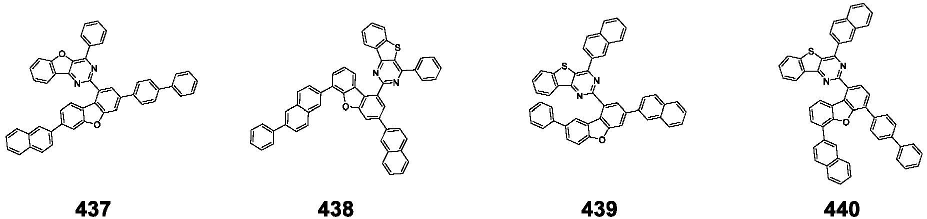

7. The organic light emitting device of claim 1, wherein Chemical Formula 2 is a heterocyclic compound represented by any one of the following compounds:

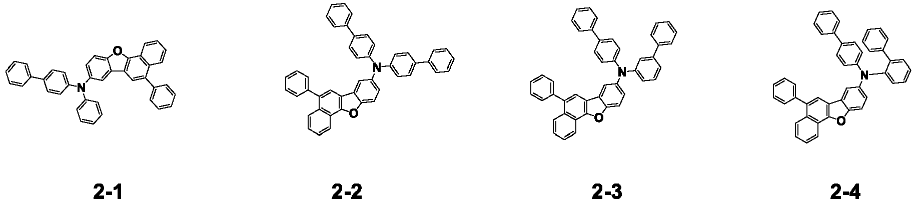

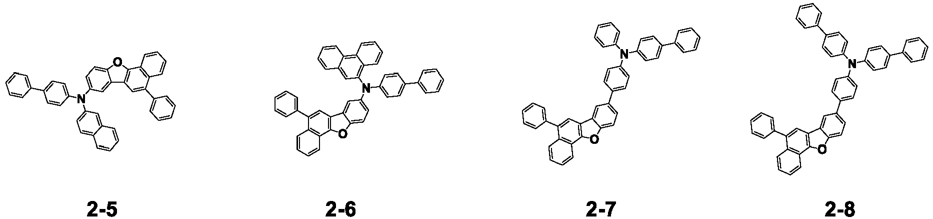

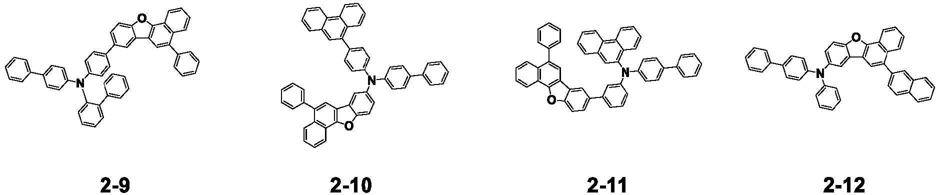

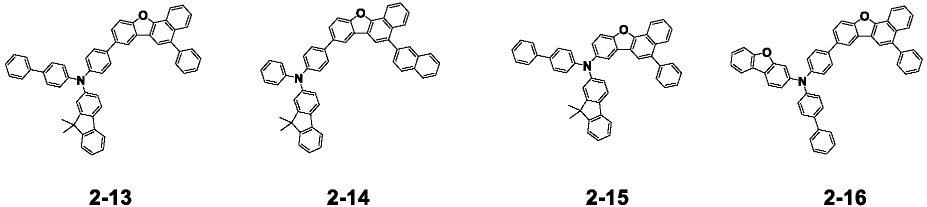

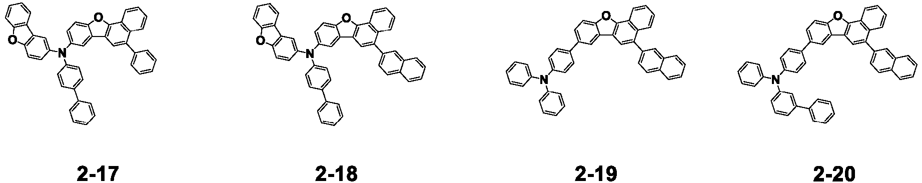

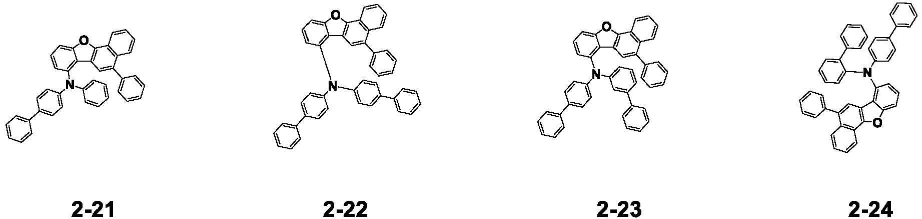

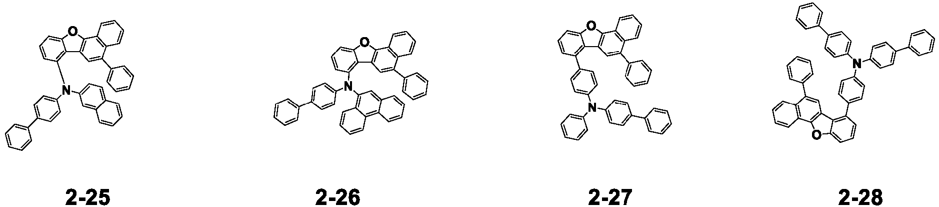

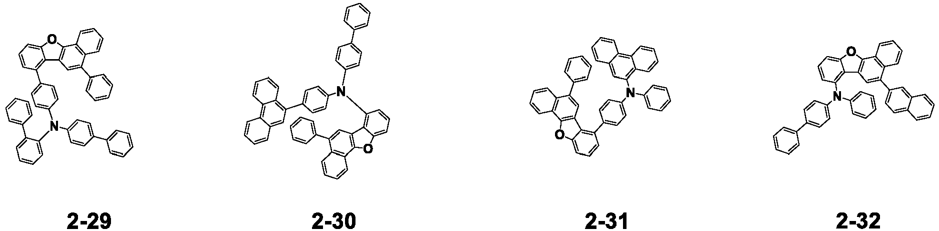

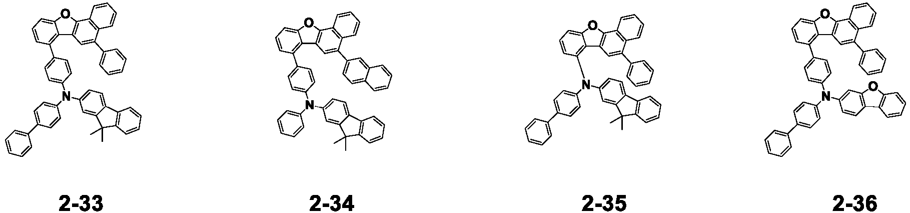

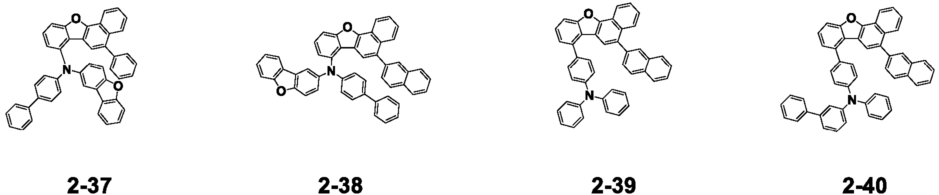

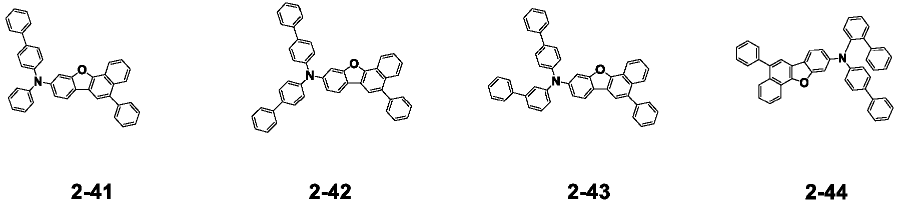

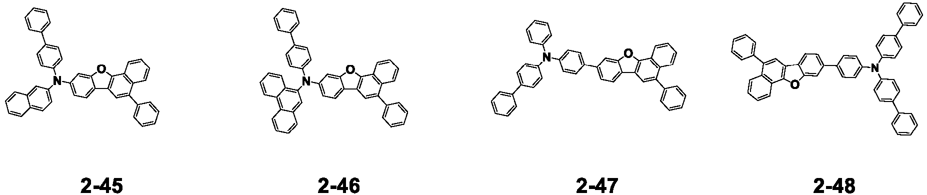

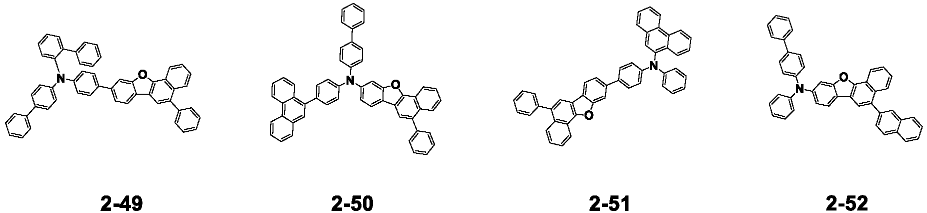

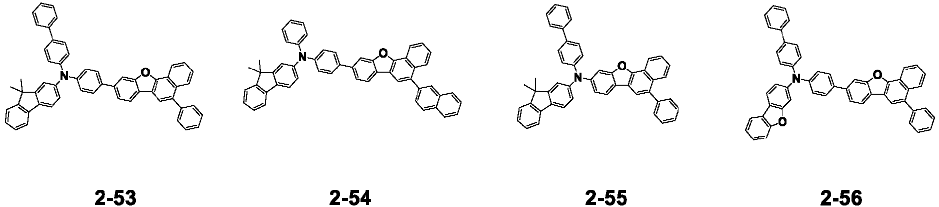

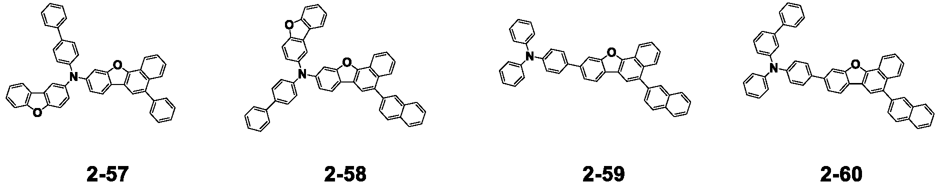

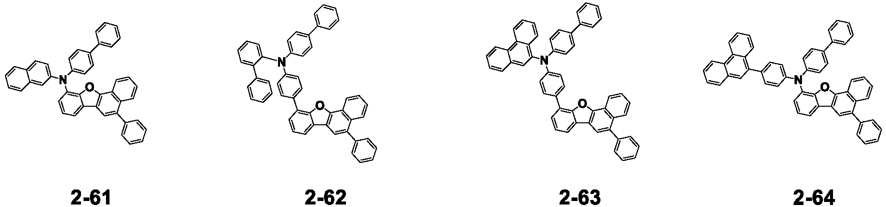

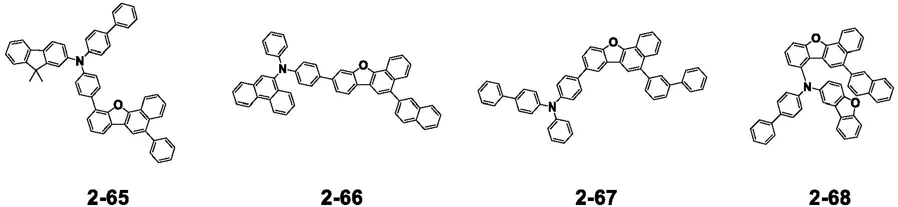

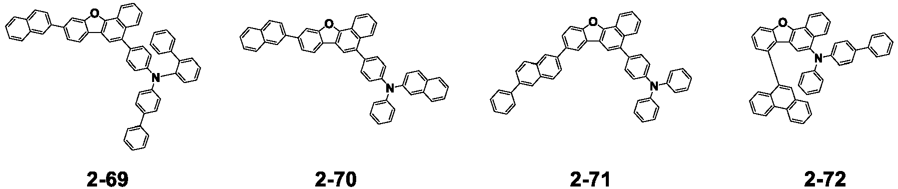

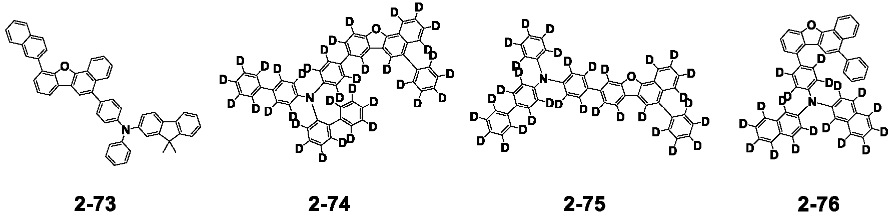

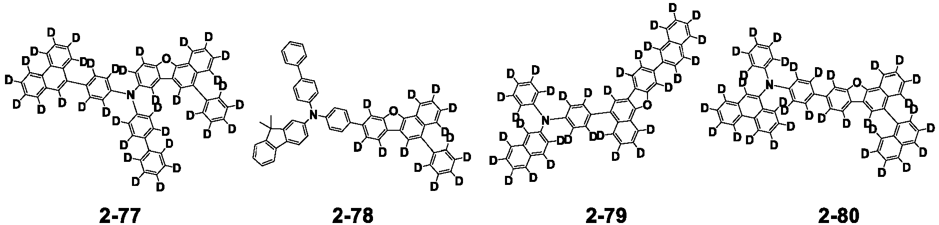

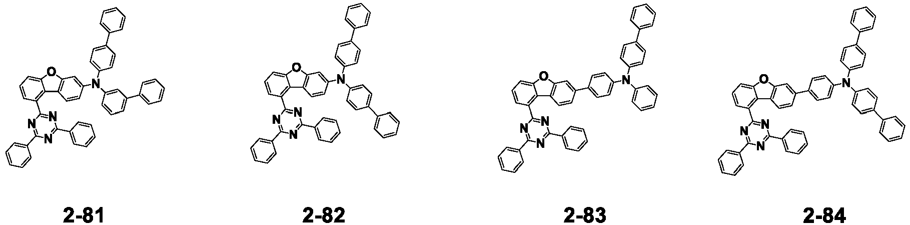

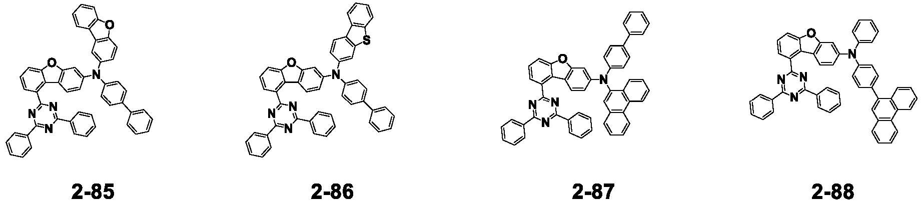

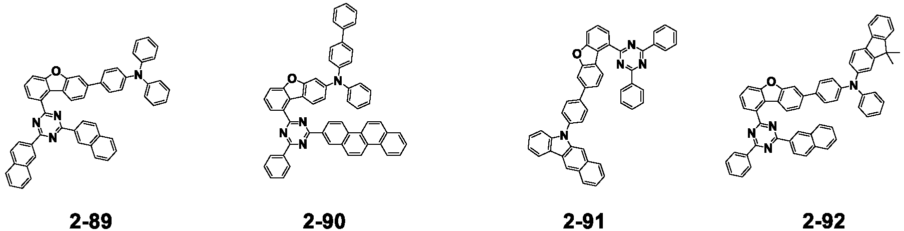

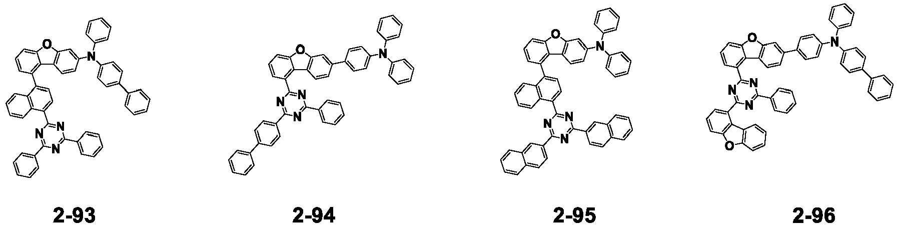

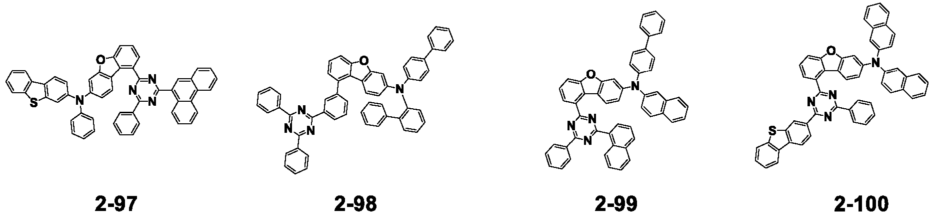

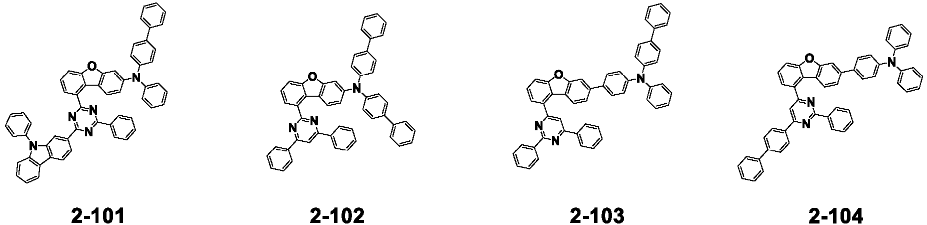

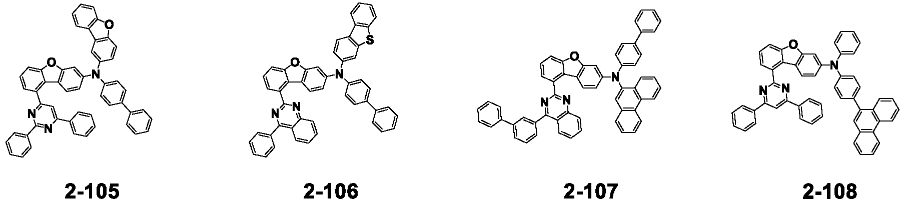

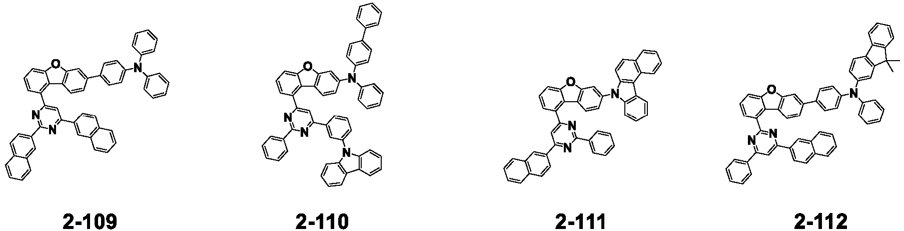

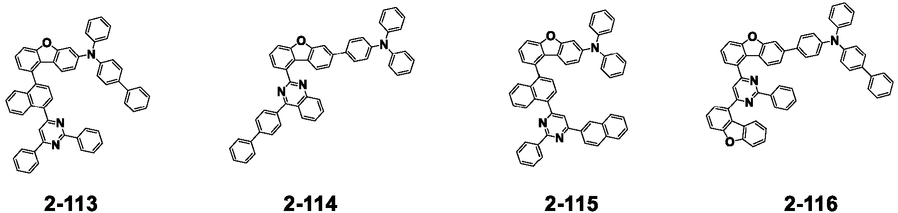

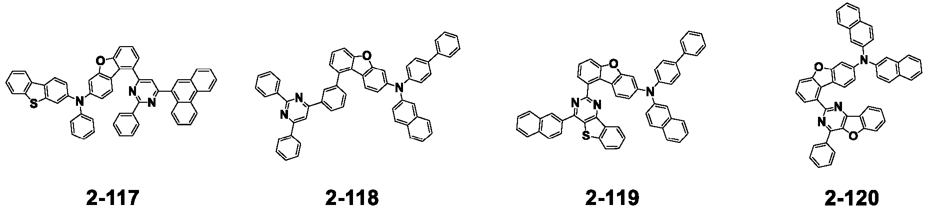

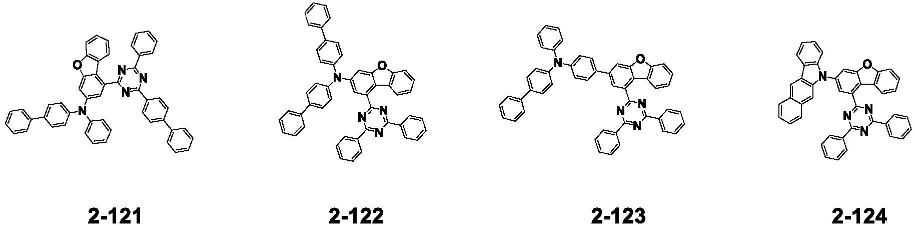

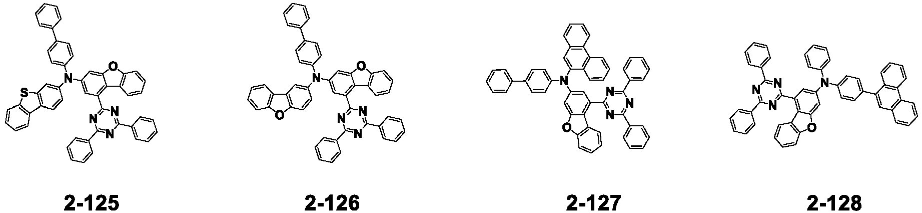

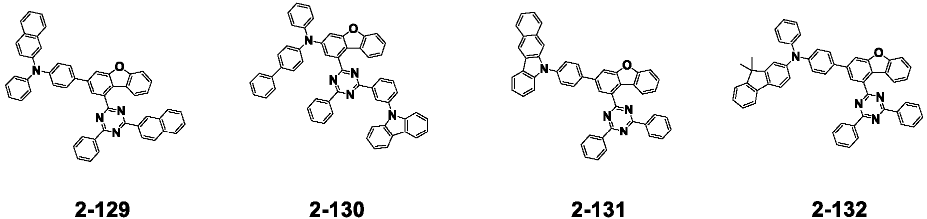

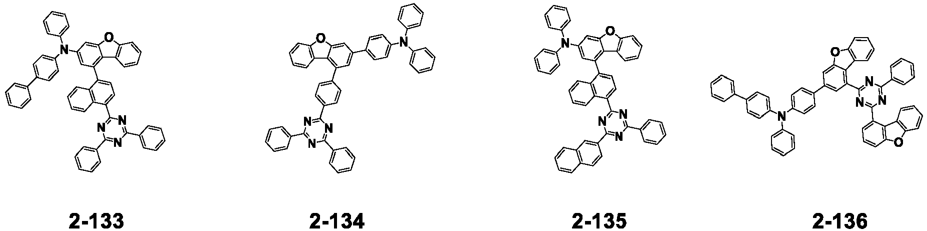

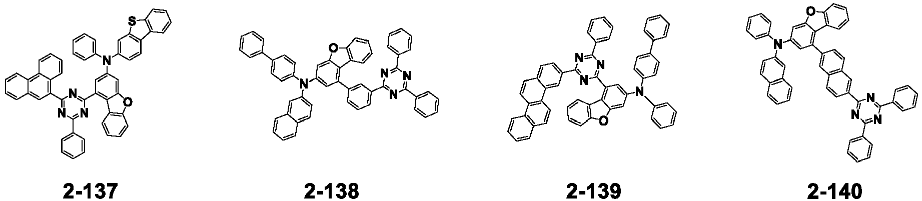

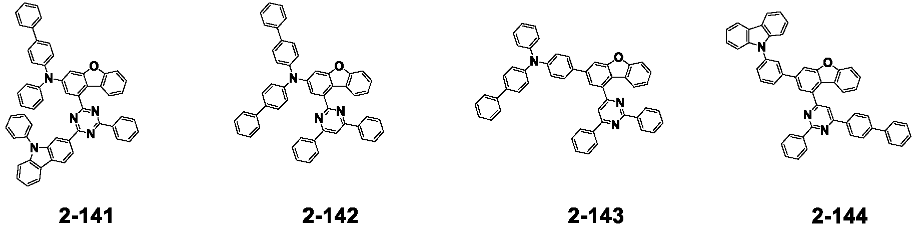

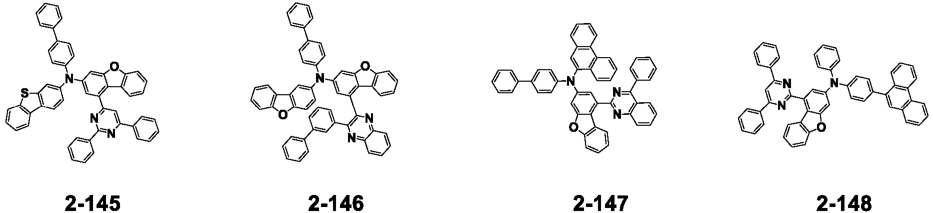

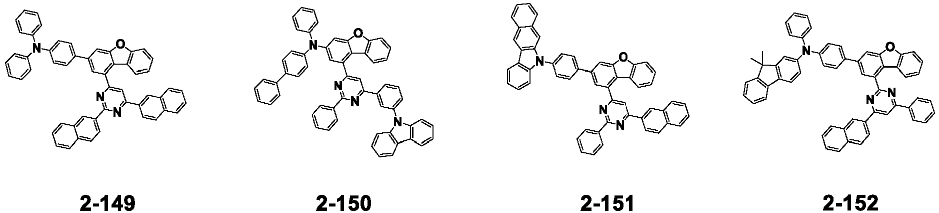

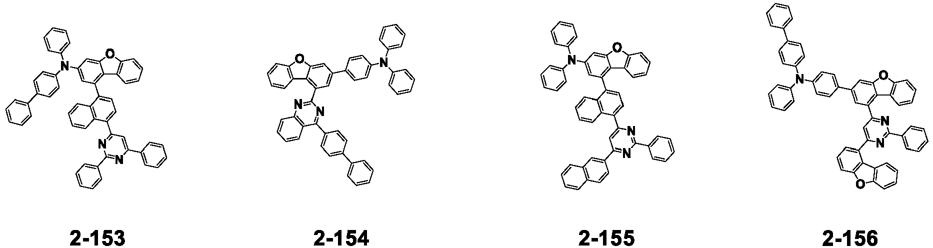

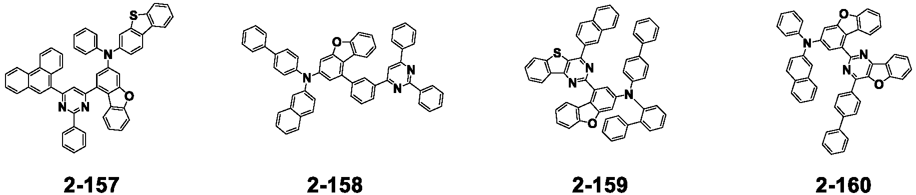

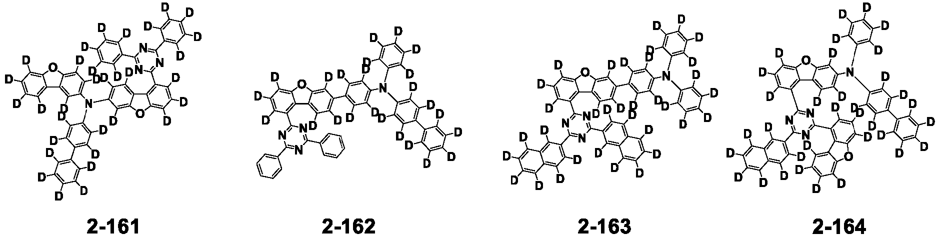

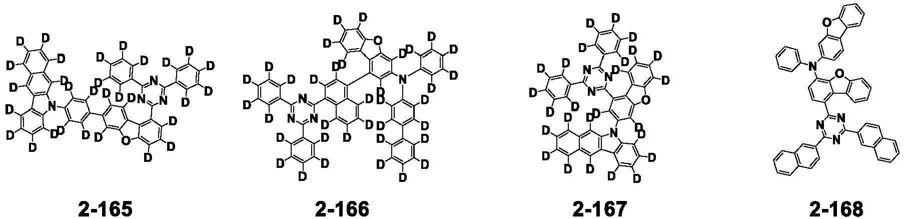

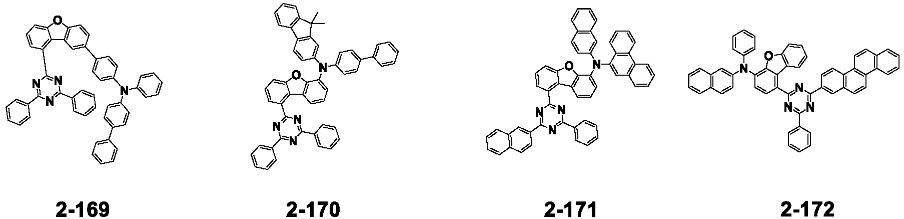

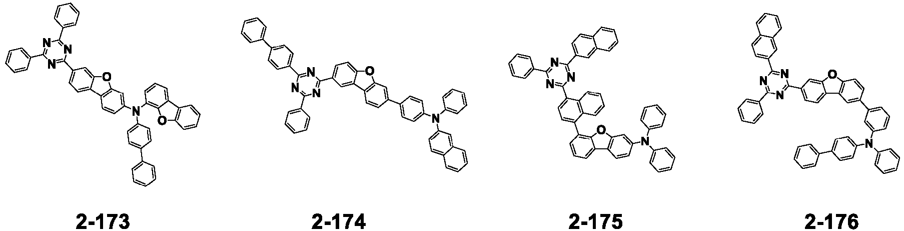

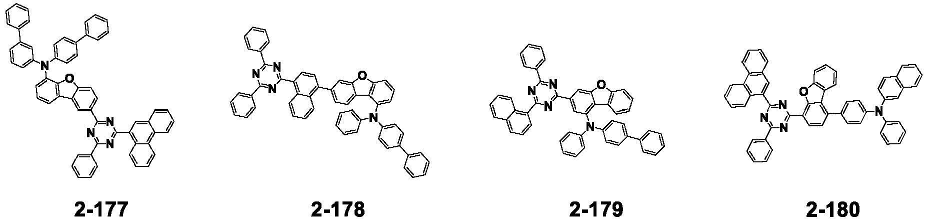

8. The organic light emitting device of claim 1, wherein the organic material layer comprises a light emitting layer, and the light emitting layer comprises the heterocyclic compound represented by Chemical Formula 1 and the heterocyclic compound represented by Chemical Formula 2.

9. The organic light emitting device of claim 8, wherein the light emitting layer optionally comprises a host material, and the host material comprises the heterocyclic compound represented by Chemical Formula 1 and the heterocyclic compound represented by Chemical Formula 2.

10. The organic light emitting device of claim 9, wherein the host material optionally comprises two or more host materials, and among the two or more host materials, the heterocyclic compound represented by Chemical Formula 1 is an N-type host material, and the heterocyclic compound represented by Chemical Formula 2 is a P-type host material.

11. The organic light emitting device of claim 9, wherein the host material optionally comprises two or more host materials, and the two or more host materials are pre-mixed and used.

12. The organic light emitting device of claim 1, comprising the first electrode, a first stack provided on the first electrode and comprising a first light emitting layer, a charge generation layer provided on the first stack, a second stack provided on the charge generation layer and comprising a second light emitting layer, and the second electrode provided on the second stack.

13. The organic light emitting device of claim 12,
wherein the first light emitting layer and the second light emitting layer comprise the heterocyclic compound represented by Chemical Formula 1 and the heterocyclic compound represented by Chemical Formula 2, respectively.

14. A composition for an organic material layer of the organic light emitting device comprising both the heterocyclic compound represented by Chemical Formula 1 and the compound represented by Chemical Formula 2 according to claim 1.

15. The composition of claim 14, wherein a weight ratio of the heterocyclic compound represented by Chemical Formula 1 : the compound represented by Chemical Formula 2 in the composition is 1 : 10 to 10 : 1.

16. A method of manufacturing an organic light emitting device, the method comprising:
preparing a substrate;
forming a first electrode on the substrate;
forming an organic material layer having one or more layers on the first electrode; and
forming a second electrode on the organic material layer,
wherein the forming of the organic material layer comprises forming an organic material layer having one or more layers by using the composition of claim 14.
